Europäisches Patentamt

European Patent Office

Office européen des brevets

(19)

(11) Veröffentlichungsnummer : **0 382 890 B1**

(12) # EUROPÄISCHE PATENTSCHRIFT

(45) Veröffentlichungstag der Patentschrift :
**10.03.93 Patentblatt 93/10**

(51) Int. Cl.$^5$ : **G01R 21/133**

(21) Anmeldenummer : **89116520.1**

(22) Anmeldetag : **07.09.89**

(54) **Anordnung zum Messen einer Scheinleistung.**

(30) Priorität : **15.02.89 CH 522/89**

(43) Veröffentlichungstag der Anmeldung :
**22.08.90 Patentblatt 90/34**

(45) Bekanntmachung des Hinweises auf die
Patenterteilung :
**10.03.93 Patentblatt 93/10**

(84) Benannte Vertragsstaaten :
**AT CH DE FR GB LI SE**

(56) Entgegenhaltungen :
**WO-A-82/02954**

(56) Entgegenhaltungen :
**FR-A- 2 269 083**
**FR-A- 2 616 227**
**LANDIS & GYR-MITTEILUNGEN, Band 32, Nr.
1, 1985, Seiten 4-8; P. WULLSCHLEGER:
"TARIFGERÄTE TARIGYR 400"**

(73) Patentinhaber : **Landis & Gyr Betriebs AG
CH-6301 Zug (CH)**

(72) Erfinder : **Joho, Benno
Aberenrain 40
CH-6340 Baar (CH)**
Erfinder : **Gyseler, Herbert
Eschenweg 14
CH-6340 Baar (CH)**

EP 0 382 890 B1

**Beschreibung**

Die Erfindung bezieht sich auf eine Anordnung zum Messen einer Scheinleistung gemäss dem Oberbegriff des Anspruchs 1.

Die Kosten der Elektrizitätserzeugung bestehen grundsätzlich aus zwei wesentlich unterschiedlichen Kostenelementen, nämlich aus Primärenergiekosten (Heizöl- oder Kohlenkosten) und aus Anlagenkosten. Letztere enthalten Kosten der Erzeugungsanlagen, der Transportanlagen und der Verteilanlagen. Elektrizitäts-Versorgungsunternehmen suchen nach Tarifformen, welche die Gesamtkosten inklusive einem angemessenen Gewinn möglichst gerecht auf die einzelnen Abnehmer verteilen. Um die Kosten der Primärenergie gerecht zu verteilen, ist offensichtlich ein Entgelt proportional der gelieferten Wirkleistung richtig. Um diese Kostenkomponente erfassen zu können, muss somit bei jedem Abnehmer ein Wirkenergie-Verbrauchszähler installiert werden. Grundsätzlich sind alle Kosten elektrischer Anlagen proportional zur maximalen Scheinleistung, was schon daran erkennbar ist, dass die Leistungsschilder aller Anlagekomponenten, wie z. B. Generatoren oder Transformatoren, den Wert der Scheinleistung als wesentlichste Angabe enthalten. Es wäre daher gerecht, wenn zur Deckung der Anlagekosten ein Entgelt proportional zum verbrauchten Scheinleistungsmaximum erhoben würde. Dies bedingt jedoch eine Messung der verbrauchten Scheinenergie beim Abnehmer.

Eine Anordnung der im Oberbegriff des Anspruchs 1 genannten Art ist aus der Druckschrift "Metering, Apparatus and Tariffs for electricity supply", November 1977, Seiten 247 bis 251, "An electronic kVA demand meter", B. Dearden, bekannt.

Der Erfindung liegt die Aufgabe zugrunde, die Messgenauigkeit der im Oberbegriff des Anspruchs 1 beschriebenen bekannten Anordnung zu verbessern und die Anordnung derart abzuändern, dass die Technik um weitere vorteilhafte Varianten der Anordnung bereichert wird.

Die genannte Aufgabe wird erfindungsgemäss durch die im Kennzeichen des Anspruchs 1 angegebenen Merkmale gelöst. Vorteilhafte Weiterbildungen der Erfindung sind in den Unteransprüchen gekennzeichnet.

Ausführungsbeispiele der Erfindung sind in der Zeichnung dargestellt und werden im folgenden näher beschrieben.

Es zeigen:
Fig. 1 ein Blockschaltbild eines Taktverteilers,
Fig. 2 ein Blockschaltbild einer ersten Variante der erfindungsgemässen Anordnung,
Fig. 3 ein Blockschaltbild einer zweiten Variante der erfindungsgemässen Anordnung,
Fig. 4 ein Blockschaltbild einer dritten Variante der erfindungsgemässen Anordnung,
Fig. 5 ein Blockschaltbild einer vierten Variante der erfindungsgemässen Anordnung,
Fig. 6 ein Blockschaltbild einer fünften Variante der erfindungsgemässen Anordnung,
Fig. 7 ein Blockschaltbild einer sechsten Variante der erfindungsgemässen Anordnung,
Fig. 8 ein Blockschaltbild einer siebten Variante der erfindungsgemässen Anordnung,
Fig. 9 ein Blockschaltbild einer achten Variante der erfindungsgemässen Anordnung,
Fig.10 ein Blockschaltbild einer Festwertspeichereinheit,
Fig.11 ein Schaltbild eines Mittels zur Freigabe der Auswertung,
Fig.12 ein Schaltbild einer Umschalteinrichtung,
Fig.13 ein Blockschaltbild eines zweiteiligen Festwertspeichers,
Fig.14 ein Blockschaltbild eines dreiteiligen Festwertspeichers,
Fig.15 ein Blockschaltbild einer Zähl- und Speichereinrichtung,
Fig.16 ein Schaltbild einer Ausgangsschaltung,
Fig.17 ein Schaltbild eines Synchronisierers und
Fig.18 ein Schaltbild einer weiteren Variante des Mittels zur Freigabe der Auswertung.
Gleiche Bezugszahlen bezeichnen in allen Figuren der Zeichnung gleiche Teile.

Als Bauelemente werden in allen Varianten vorzugsweise Bauelemente der Serie 74HC... verwendet. Diese Bauelemente sind in Datenbüchern der Lieferanten ausführlich beschrieben, z. B. im 74HC-Datenbuch der Firma Motorola, Semiconductor Products Inc. 5005E Mc Dowell Road M370, Phoenix AZ 85008, USA.

Wenn Spannung und Strom genau sinusförmig sind, lässt sich ein Wert S der Scheinleistung auch aus einem Wert P einer zugehörigen Wirkleistung und einem Wert Q einer zugehörigen Blindleistung ermitteln, da bekanntlich folgende Gleichungen gelten, wenn $\phi$ den Phasenwinkel zwischen Spannung und Strom bezeichnet:

$$S = \sqrt{[P^2 + Q^2]} \quad [\text{I}],$$

$$\text{tg}\phi = Q/P \quad [\text{II}],$$

$$\sin\phi = Q/S = [Q/P]/\sqrt{[1 + Q^2/P^2]} = \text{tg}\phi/\sqrt{[1 + \text{tg}^2\phi]} \quad [\text{III}]$$

und

$$\cos\phi \ = \ P/S \ = \ 1/\sqrt{[1 + Q^2/P^2]} \ = \ 1/\sqrt{[1 + tg^2\phi]} \quad [IV].$$

In allen Varianten wird die erfindungsgemässe Anordnung gespeist von einem aus Impulsen bestehenden ersten Eingangssignal 1 und von einem ebenfalls aus Impulsen bestehenden zweiten Eingangssignal 2. Die Impulsfrequenz f[P] des ersten Eingangssignals 1 ist proportional dem Wert P der zugehörigen Wirkleistung und die Impulsfrequenz f[Q] des zweiten Eingangsignals 2 ist proportional dem Wert Q der zugehörigen Blindleistung.

Die beiden Eingangssignale 1 und 2 werden in mindestens einem mit Impulsgebern versehenen elektromechanischen Elektrizitätszähler oder in mindestens einem elektronischen, statischen Elektrizitätszähler erzeugt. Dieser bzw. diese Elektrizitätszähler sind in der Zeichnung nicht dargestellt. Ihr Aufbau ist an sich bekannt und wird daher nicht näher beschrieben. Zwei ihrer Ausgänge sind mit je einem von zwei Signaleingängen der erfindungsgemässen Anordnung verbunden, an denen somit dann jeweils eines der beiden Eingangssignale 1 bzw. 2 ansteht.

Die beiden Impulsfrequenzen f[P] und f[Q] besitzen jeweils Werte, die vorzugsweise zwischen 0 Hz und 600 Hz bis 1100 Hz liegen. Da die beiden Eingangssignale 1 und 2 zeitlich quantisiert sind, können sie infolge ihres impulsweisen Auftretens einen Wert P oder Q der Wirkenergie bzw. der Blindenergie nicht kontinuierlich exakt darstellen. Die Werte sind nur im Zeitpunkt des Eintreffens des entsprechenden Impulses genau definiert, so dass in der Regel ein Zeitquantisierungsfehler vorhanden ist.

Die erfindungsgemässe Anordnung enthält in allen Varianten jeweils einen Taktverteiler 3, einen Impulszähler 4, einen Synchronisierer 5, eine Festwertspeichereinheit 6, die immer mindestens einen Festwertspeicher 6a beinhaltet, eine Einrichtung 7 zum Speichern von Zwischenresultaten, einen Addierer 8, eine Ausgangsschaltung 9, die in den drei ersten Varianten sowie in der fünften bis siebten Variante nur fakultativ vorhanden ist.

Nachfolgend gilt immer die Annahme, dass der Impulszähler 4 z. B. vier Bits und somit einen 4bit-Parallelausgang besitzt.

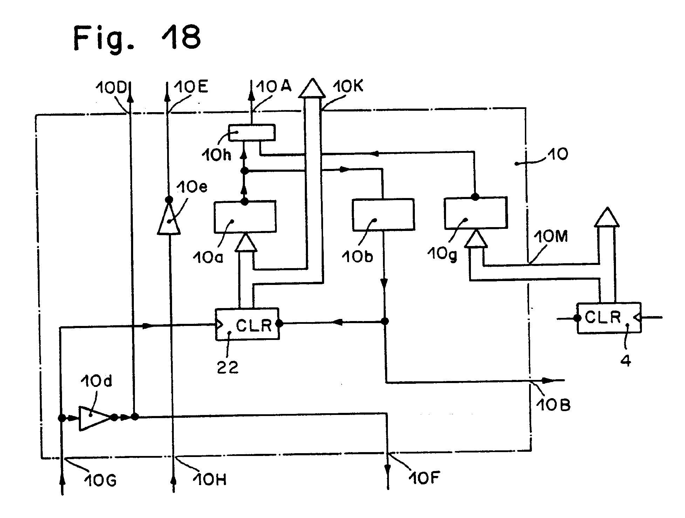

Der Synchronisierer 5 dient in allen Varianten dazu, zu verhindern, dass Impulse der Eingangssignale 1 und 2 innerhalb der Anordnung gleichzeitig auftreten, sich dort zeitlich überlappen oder dort zur Unzeit erscheinen, z. B. im Zeitpunkt des Zurückstellens des Impulszählers 4. Ein bevorzugter Aufbau des Synchronisierers 5 ist aus der Fig. 17 ersichtlich.

In allen Varianten sind die im Festwertspeicher 6a gespeicherten Zahlenwerte abhängig von den durch den ersten Impulszähler 4 gezählten Werten und besitzen jeweils K Bits, so dass die Anzahl Datenausgangsbits des Festwertspeichers 6a gleich K ist. In der vierten und achten Variante gilt z. B. K=8, so dass in diesen Varianten der Festwertspeicher 6a K=8 Datenausgänge D0 bis D7 besitzt, während in allen andern Varianten z. B. K=12 gilt, so dass der Festwertspeicher 6a in diesen Varianten jeweils K=12 Datenausgänge D0 bis D11 aufweist. Der Festwertspeicher 6a besitzt in den vier ersten Varianten jeweils z. B. vier Adresseneingänge A0 bis A3 und in den vier letzten Varianten z. B. jeweils mindestens acht Adresseneingänge A0 bis A7. Der Festwertspeicher 6a ist z. B. ein ROM ("read only memory"), ein EEPROM ("electrical erasable programmable read only memory") oder ein PROM ("programmable read only memory") und kann z. B. ein 27C64 sein.

Die Einrichtung 7 zum Speichern von Zwischenresultaten besteht aus einer Gruppe von D-Flipflop-Speichern, deren Takteingänge miteinander verbunden sind und einen Takteingang der Einrichtung 7 bilden. Diese Gruppe enthält jeweils so viele D-Flipflop-Speicher wie die im Festwertspeicher 6a gespeicherten Zahlenwerte Bits aufweisen, also K Stück.

Der Addierer 8 weist ebenfalls K Bits auf und besteht aus K Volladdierern ("full adder").

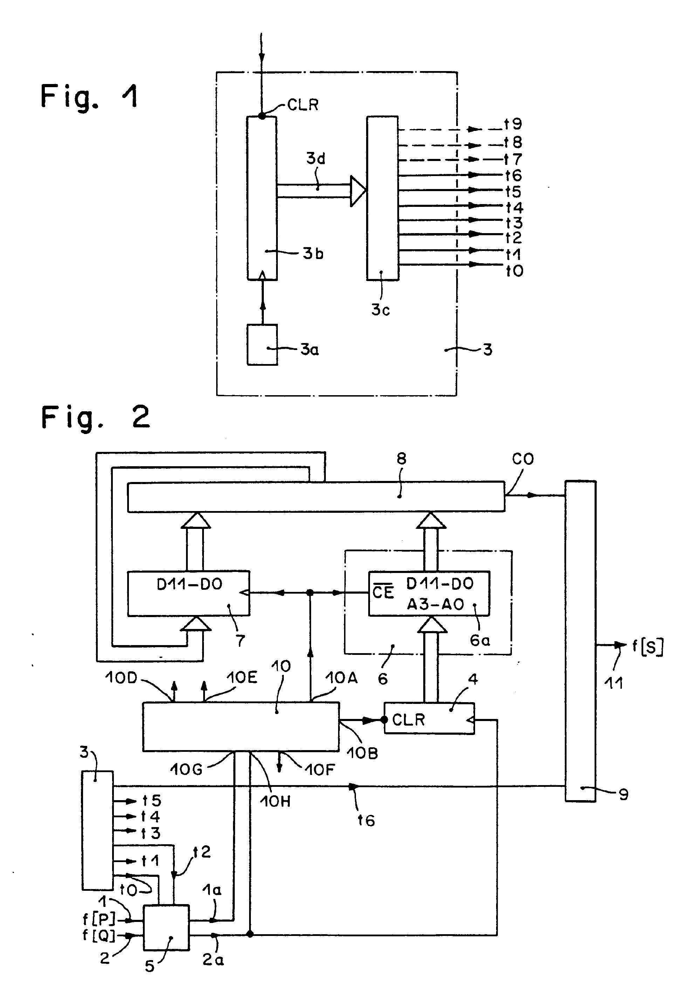

Der Aufbau des Taktverteilers 3 ist aus der Fig. 1 ersichtlich und besteht jeweils aus einem Taktgeber 3a, einem Taktzähler 3b und einem 1-aus-M-Decoder 3c. In den drei ersten Varianten besitzt M z. B. einen Wert sieben und an den dann sieben Ausgängen des 1-aus-M-Decoders 3c steht je eines von sieben Signalen t0 bis t6 an, während M in den fünf letzten Varianten z. B. einen Wert zehn aufweist, so dass an den dann zehn Ausgängen des 1-aus-M-Decoders 3c je eines von zehn Signalen t0 bis t9 ansteht. Im Taktverteiler 3 (siehe Fig. 1) ist der Ausgang des Taktgebers 3a auf einen Takteingang des Taktzählers 3b geführt, dessen Parallelausgang über eine Busverbindung 3d mit Paralleleingängen des 1-aus-M-Decoders 3c verbunden ist, wobei M Ausgänge des letzteren M Ausgänge des Taktverteilers 3 bilden, an denen die M Signale t0 bis t6 bzw. t0 bis t9 anstehen. Der Taktzähler 3b besitzt noch einen Rückstelleingang CLR, der gleichzeitig ein Rückstelleingang des Taktverteilers 3 ist.

In allen Varianten wird durch den Taktgeber 3a ein Taktsignal erzeugt, dessen rechteckförmige Impulse durch den Taktzähler 3b gezählt und somit mit durchgehend numerierten, laufenden Nummern versehen werden. Der 1-aus-M-Decoder 3c verteilt diese Impulse gemäss ihren laufenden Nummern zeitlich nacheinander auf seine M Ausgänge, so dass zuerst ein Impuls als Signal t0, dann ein Impuls als Signal t1, anschliessend ein Impuls als Signal t2, usw. und schliesslich ein Impuls als Signal t6 bzw. t9 erscheint. Anschliessend beginnt

EP 0 382 890 B1

dann wieder ein neuer Zyklus mit einem Impuls des Signals t0. Die Signale t0 bis t6 bzw. t0 bis t9 sind Zeitsignale und dienen als Zeitbasis.

In den vier ersten Varianten der erfindungsgemässen Anordnung ist ausserdem noch ein Mittel 10 zur Freigabe der Auswertung vorhanden, welches mindestens die Auswertung der im Festwertspeicher 6a gespeicherten Zahlenwerte freigibt.

Folgende Verbindungen existieren in der ersten Variante der erfindungsgemässen Anordnung (siehe Fig. 2):

- Die beiden Ausgänge des Taktverteilers 3, an denen die beiden Signale t0 und t2 anstehen, sind auf je einen von zwei Steuereingängen des Synchronisierers 5 geführt.

- Die beiden Eingangssignale 1 und 2 der erfindungsgemässen Anordnung speisen jeweils einen von zwei Signaleingängen des Synchronisierers 5, an dessen beiden Ausgängen, möglicherweise verzögert, je eines der beiden Eingangssignale als synchronisiertes Signal 1a bzw. 2a erscheint, wobei das synchronisierte Signal 1a dem ersten Eingangssignal 1 und das synchronisierte Signal 2a dem zweiten Eingangssignal 2 entspricht.

- Die Adresseneingänge A0 bis A3 des Festwertspeichers 6a sind über eine Busverbindung mit dem Parallelausgang des Impulszählers 4 verbunden.

- Ein Ausgang des Addierers 8 ist über eine Kbit-Busverbindung auf einen Dateneingang der Einrichtung 7 zum Speichern von Zwischenresultaten geführt.

- Zwei Buseingänge des Addierers 8 sind jeweils über eine Kbit-Busverbindung mit einem Datenausgang D0 bis D11 des Festwertspeichers 6a bzw. der Einrichtung 7 zum Speichern von Zwischenresultaten verbunden.

- Ein Übertragsausgang CO ("carry out") des Addierers 8 ist auf einen Ausgang der erfindungsgemässen Anordnung geführt. Beim Vorhandensein der Ausgangsschaltung 9 (siehe Fig. 2) ist der Übertragsausgang CO des Addierers 8 jeweils mit einem ersten Eingang der Ausgangsschaltung 9 verbunden, deren Ausgang dann seinerseits den Ausgang der erfindungsgemässen Anordnung bildet. Der Übertragsausgang CO des Addierers 8 ist somit über die Ausgangsschaltung 9 auf den Ausgang der erfindungsgemässen Anordnung geführt. Der Addierer 8 bzw. die Kombination des Addierers 8 und der Ausgangsschaltung 9 stellt eine Einrichtung 8 bzw. 8; 9 zur Erzeugung von Ausgangsimpulsen dar, die in Abhängigkeit der im Festwertspeicher 6a gespeicherten Zahlenwerte und auch der in der Einrichtung 7 gespeicherten Zwischenresultate generiert werden. Ein Ausgangssignal 11 der erfindungsgemässen Anordnung besteht aus diesen Ausgangsimpulsen, die eine Impulsfrequenz f[S] besitzen, die proportional dem Wert S der Scheinleistung ist. Beim Vorhandensein der Ausgangsschaltung 9 ist z. B. ein weiterer Eingang derselben mit demjenigen Ausgang des Taktverteilers 3 verbunden, an dem das Signal t6 ansteht.

- Der Takteingang des Impulszählers 4 ist mit einem der beiden Eingangssignale 1 bzw. 2 verbunden und zwar derart, dass er unmittelbar mit einem der beiden Ausgänge des Synchronisierers 5 verbunden ist, zwecks Zählung der gegebenenfalls verzögerten Impulse des betreffenden Eingangssignals 1 bzw. 2. Nachfolgend gilt die Annahme, dass er die Impulse des zweiten Eingangssignals 2 zählt. Zu diesem Zweck ist der Takteingang des Impulszählers 4 unmittelbar mit demjenigen Ausgang des Synchronisierers 5 verbunden, an dem das synchronisierte Eingangssignal 2a ansteht.

- Ein Freigabeausgang 10A des Mittels 10 zur Freigabe der Auswertung ist auf einen Freigabeeingang "$\overline{CE}$" des Festwertspeichers 6a sowie auf den Takteingang der Einrichtung 7 zum Speichern von Zwischenresultaten geführt.

- Ein Rückstellausgang 10B des Mittels 10 ist mit einem Rückstelleingang CLR des Impulszählers 4 verbunden.

- Die beiden Ausgänge des Synchronisierers 5 sind ausserdem auf je einen ersten Eingang 10G bzw. zweiten Eingang 10H des Mittels 10 geführt.

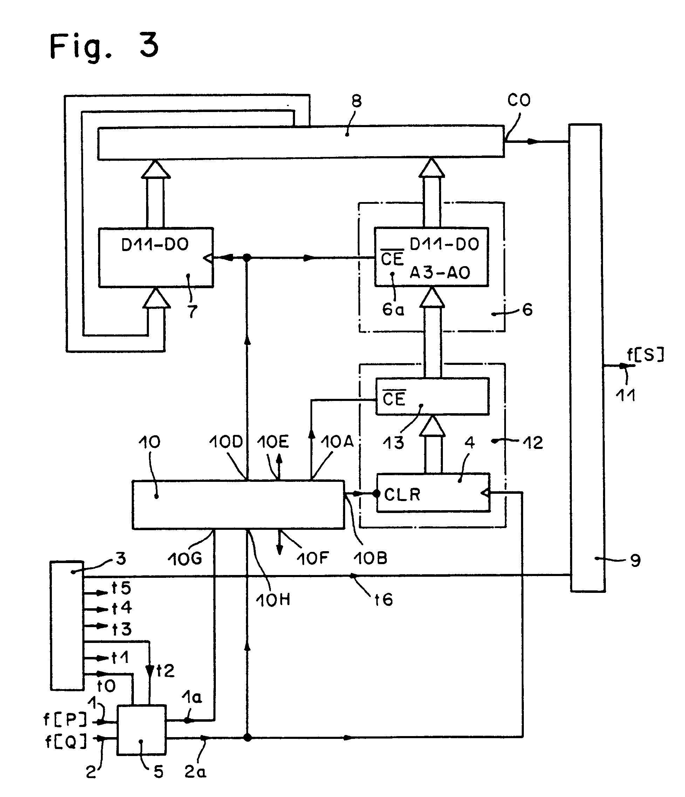

Die in der Fig. 3 dargestellte zweite Variante der erfindungsgemässen Anordnung ist ähnlich aufgebaut wie die in der Fig. 2 dargestellte erste Variante mit den Unterschieden, dass

- der Impulszähler 4 ersetzt ist durch eine Zähl- und Speichereinrichtung 12, die ihrerseits aus dem Impulszähler 4 und einem Zwischenregister 13 besteht, wobei der Parallelausgang des Impulszählers 4 über eine Busverbindung mit einem Dateneingang des Zwischenregisters 13 verbunden ist, dessen Datenausgang seinerseits über eine weitere Busverbindung auf die Adresseneingänge A0 bis A3 der Festwertspeichereinheit 6 und des Festwertspeichers 6a geführt ist, und

- der Freigabeausgang 10A des Mittels 10 mit einem Freigabeeingang "$\overline{CE}$" des Zwischenregisters 13 verbunden ist, während ein weiterer Freigabeausgang 10D des Mittels 10 auf den Freigabeeingang "$\overline{CE}$" des Festwertspeichers 6a sowie auf den Takteingang der Einrichtung 7 zum Speichern von Zwischenresultaten geführt ist.

Das Zwischenregister 13 weist dabei genau soviele Bits auf wie der Impulszähler 4, also vier Stück.

4

EP 0 382 890 B1

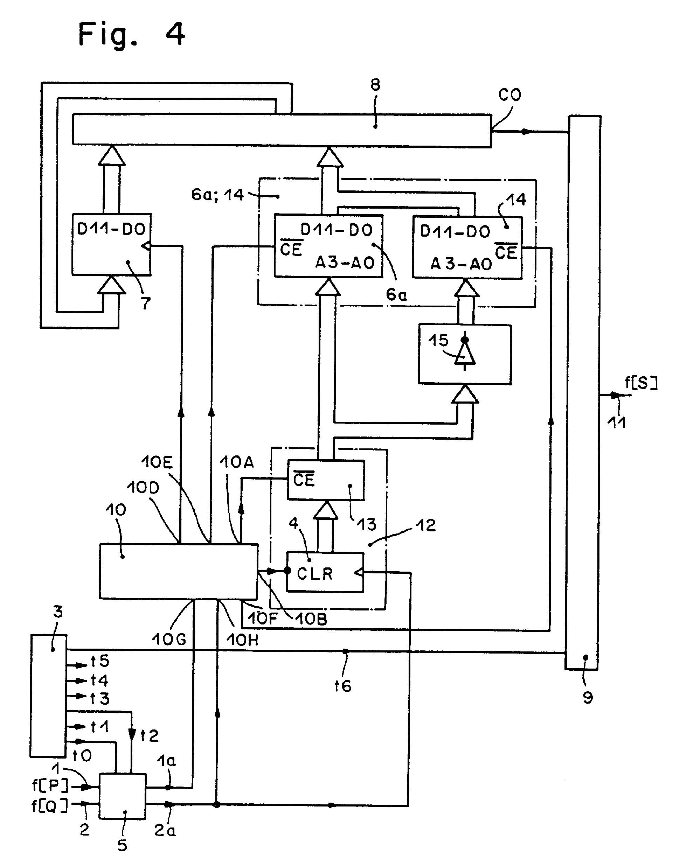

Die in der Fig. 4 dargestellte dritte Variante der erfindungsgemässen Anordnung ist ähnlich aufgebaut wie die in der Fig. 3 dargestellte zweite Variante mit den Unterschieden, dass

- zusätzlich zum Festwertspeicher 6a noch ein vorzugsweise gleich aufgebauter weiterer Festwertspeicher 14 vorhanden ist, dessen Anzahl Datenausgangsbits somit ebenfalls K Bits beträgt, wobei die K Datenausgänge D0 bis D11 der beiden Festwertspeicher 6a und 14 parallelgeschaltet sind, unter der Annahme, dass diese Datenausgänge D0 bis D11 "Tri state"-Datenausgänge sind,
- der Datenausgang des Zwischenregisters 13 dann auch, und zwar vorzugsweise über je einen Inverter 15 pro Bit, mittels Busverbindungen auf die Adresseneingänge A0 bis A3 des weiteren Festwertspeichers 14 geführt ist, so dass die Adresseneingänge A0 bis A3 des Festwertspeichers 6a über je einen Inverter 15 pro Bit mit den Adresseneingängen A0 bis A3 des Festwertspeichers 14 verbunden sind, und
- der weitere Freigabeausgang 10D des Mittels 10 nur mit dem Takteingang der Einrichtung 7 zum Speichern von Zwischenresultaten verbunden ist, während ein zweiter weiterer Freigabeausgang 10E des Mittels 10 auf den Freigabeeingang "$\overline{CE}$" des Festwertspeichers 6a und ein dritter weiterer Freigabeausgang 10F des Mittels 10 auf einen Freigabeeingang "$\overline{CE}$" des Festwertspeichers 14 geführt ist.

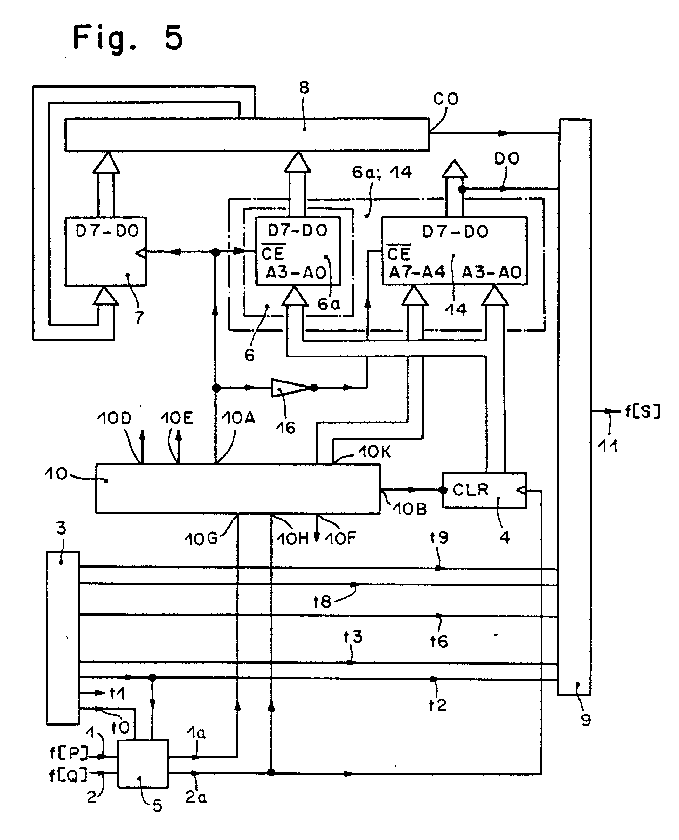

Die in der Fig. 5 dargestellte vierte Variante der erfindungsgemässen Anordnung ist ähnlich aufgebaut wie die in der Fig. 2 dargestellte erste Variante mit den Unterschieden, dass

- K=8,
- zusätzlich zum Festwertspeicher 6a noch der vorzugsweise gleich aufgebaute Festwertspeicher 14 vorhanden ist, dessen Anzahl Datenausgangsbits somit ebenfalls K Bits beträgt, wobei der Parallelausgang des Impulszählers 4 dann auch über eine Busverbindung auf die Adresseneingänge A0 bis A3 des Festwertspeichers 14 geführt ist,
- der das niederwertigste Bit aufweisende Datenausgang D0 des Festwertspeichers 14 mit einem dritten Eingang der in der vierten Variante immer vorhandenen Ausgangsschaltung 9, und damit über letztere mit dem Ausgang der Anordnung verbunden ist,
- der Taktverteiler 3 zehn Ausgangssignale t0 bis t9 statt sieben Ausgangssignale t0 bis t6 besitzt, wovon zusätzlich zum Ausgangssignal t6 noch die Ausgangssignale t2, t3, t8 und t9 auf je einen weiteren Eingang der Ausgangsschaltung 9 geführt sind,
- der Freigabeausgang 10A des Mittels 10 zusätzlich über einen Inverter 16 invertiert mit dem Freigabeeingang "$\overline{CE}$" des Festwertspeichers 14 verbunden ist und
- ein Parallelausgang 10K des Mittels 10 auf die höherwertigen Adresseneingänge A7 bis A4 der Adresseneingänge A7 bis A0 des Festwertspeichers 14 geführt ist.

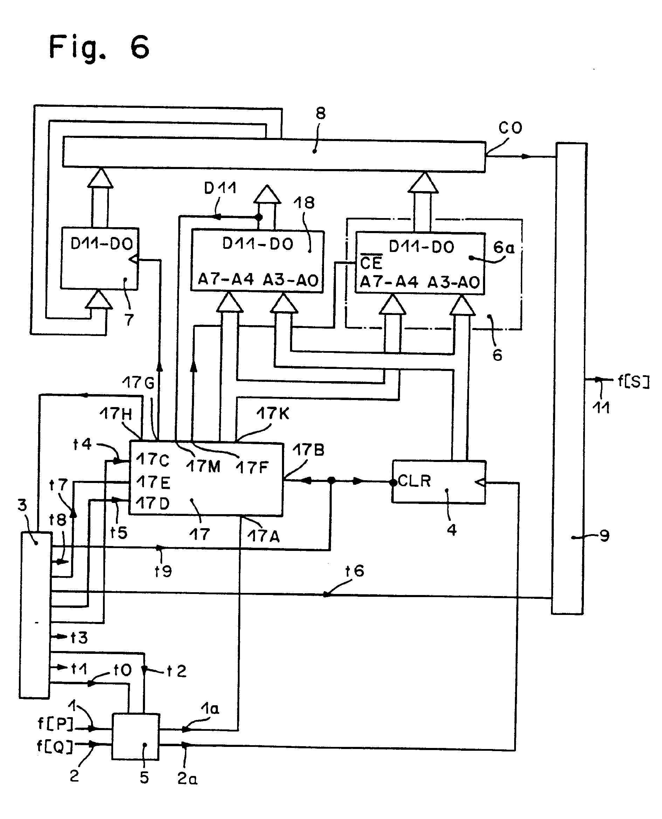

Die in der Fig. 6 bis Fig. 9 dargestellten fünften bis achten Varianten der erfindungsgemässen Anordnung sind jeweils ähnlich aufgebaut wie die in der Fig. 2 bis Fig. 5 dargestellten ersten bis vierten Varianten mit den Unterschieden, dass jeweils

- der Taktverteiler 3 immer zehn Ausgangssignale t0 bis t9 statt sieben Ausgangssignale t0 bis t6 aufweist,
- das Mittel 10 zur Freigabe der Auswertung durch ein Mittel 17; 18 zur Freigabe der Auswertung ersetzt ist, welches aus einer Umschalteinrichtung 17 und einem zusätzlichen als Decoder arbeitenden Festwertspeicher 18 besteht, wobei der letztere vorzugsweise gleich aufgebaut ist wie der Festwertspeicher 6a und somit ebenfalls K Datenausgänge aufweist,
- der Ausgang des Synchronisierers 5, an dem das synchronisierte Eingangssignal 1a ansteht, mit einem Signaleingang 17A der Umschalteinrichtung 17 und damit des Mittels 17; 18 verbunden ist,
- der Ausgang des Taktverteilers 3, an dem das Signal t9 ansteht, auf einen Rückstelleingang 17B der Umschalteinrichtung 17 und auf den Rückstelleingang CLR des Impulszählers 4 geführt ist,
- die Ausgänge des Taktverteilers 3, an denen die Signale t4, t5 und t7 anstehen, auf je einen Takteingang 17C, 17D und 17E der Umschalteinrichtung 17 geführt sind,
- ein Rückstellausgang 17H der Umschalteinrichtung 17 mit dem Rückstelleingang des Taktverteilers 3 verbunden ist und
- mindestens einer der Datenausgänge D11 bis D0 bzw. D7 bis D0 des zusätzlichen Festwertspeichers 18, vorzugsweise der höchstwertige Datenausgang D11 bzw. D7, auf einen Umschalteingang 17M der Umschalteinrichtung 17 und damit des Mittels 17; 18 geführt ist.

Der zusätzliche Festwertspeicher 18 besitzt in den vier letzten Varianten der erfindungsgemässen Anordnung jeweils gleiche Adressen wie der Festwertspeicher 6a.

Zusätzlich sind noch folgende Verbindungen vorhanden:

- In der fünften Variante (siehe Fig. 6):
  - Ein erster Freigabeausgang 17F der Umschalteinrichtung 17 und damit des Mittels 17; 18 ist mit dem Freigabeeingang "$\overline{CE}$" des Festwertspeichers 6a und ein zweiter Freigabeausgang 17G der Umschalteinrichtung 17 und damit des Mittels 17; 18 mit dem Takteingang der Einrichtung 7 verbunden und
  - der Parallelausgang des Impulszählers 4 ist über eine Busverbindung nur auf einen Teil, nämlich auf

5

die vier aufeinanderfolgenden niederwertigsten der Adresseneingänge A0 bis A3 und ein Parallelausgang 17K der Umschalteinrichtung 17 und damit des Mittels 17; 18 über eine Busverbindung auf die vier aufeinanderfolgenden höherwertigen Adresseneingänge A4 bis A7 jeweils der beiden Festwertspeicher 6a und 18 geführt.

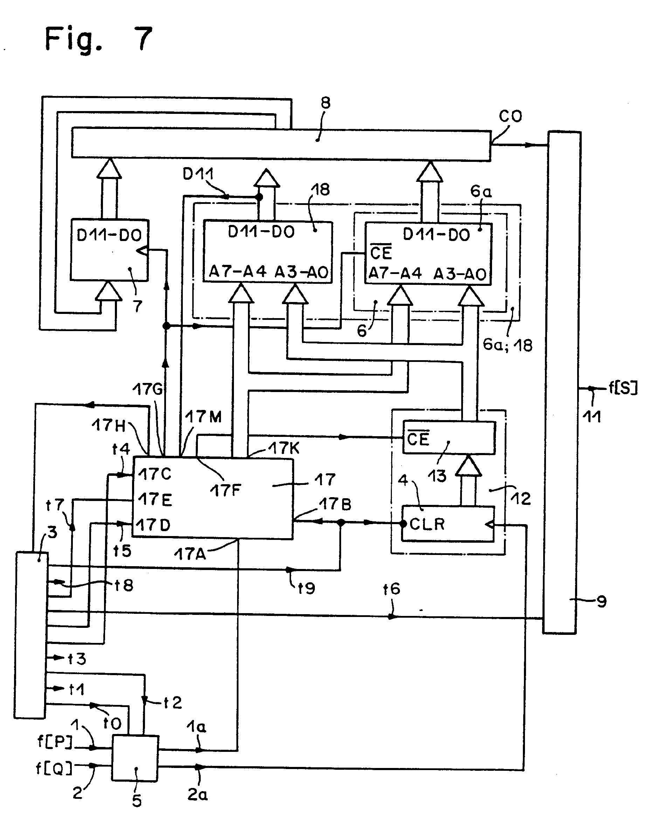

- In der sechsten Variante (siehe Fig. 7):
  - Der erste Freigabeausgang 17F der Umschalteinrichtung 17 und damit des Mittels 17; 18 ist mit dem Freigabeeingang "$\overline{CE}$" des Zwischenregisters 13 und der zweite Freigabeausgang 17G der Umschalteinrichtung 17 mit dem Takteingang der Einrichtung 7 sowie mit dem Freigabeeingang "$\overline{CE}$" des Festwertspeichers 6a verbunden und
  - der Parallelausgang des Zwischenregisters 13 ist über eine Busverbindung nur auf einen Teil, nämlich auf die vier niederwertigsten der Adresseneingänge A0 bis A3 und der Parallelausgang 17K der Umschalteinrichtung 17 und damit des Mittels 17; 18 über eine Busverbindung auf die vier höherwertigen Adresseneingänge A4 bis A7 jeweils der beiden Festwertspeicher 6a und 18 geführt.

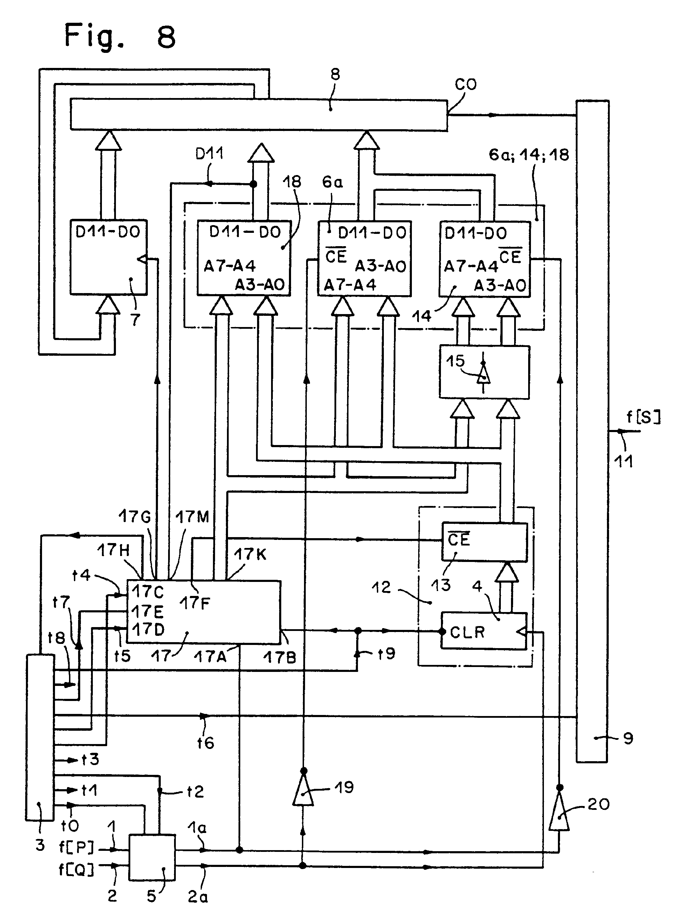

- In der siebten Variante (siehe Fig. 8):
  - Der erste Freigabeausgang 17F der Umschalteinrichtung 17 und damit des Mittels 17; 18 ist mit dem Freigabeeingang "$\overline{CE}$" des Zwischenregisters 13 und der zweite Freigabeausgang 17G der Umschalteinrichtung 17 mit dem Takteingang der Einrichtung 7 verbunden,
  - der Datenausgang des Zwischenregisters 13 ist über eine Busverbindung nur auf einen Teil, nämlich auf die vier niederwertigsten der Adresseneingänge A0 bis A3 und der Parallelausgang 17K der Umschalteinrichtung 17 und damit des Mittels 17; 18 über eine Busverbindung auf die vier höherwertigen Adresseneingänge A4 bis A7 jeweils der drei Festwertspeicher 6a, 14 und 18 geführt, wobei beim Festwertspeicher 14 diese Verbindungen vorzugsweise jeweils über einen Inverter 15 pro Bit geführt sind, und
  - der Ausgang des Synchronisierers 5, an dem das synchronisierte Eingangssignal 2a ansteht, ist über einen Inverter 19 mit dem Freigabeeingang "$\overline{CE}$" des Festwertspeichers 6a und der Ausgang des Synchronisierers 5, an dem das synchronisierte Eingangssignal 1a ansteht, über einen Inverter 20 mit dem Freigabeeingang "$\overline{CE}$" des Festwertspeichers 14 verbunden.

  Ähnlich wie in der dritten Variante sind in der siebten Variante die Adresseneingänge A0 bis A7 des Festwertspeichers 6a vorzugsweise über je einen Inverter 15 pro Bit auf die Adresseneingänge A0 bis A7 des Festwertspeichers 14 geführt.

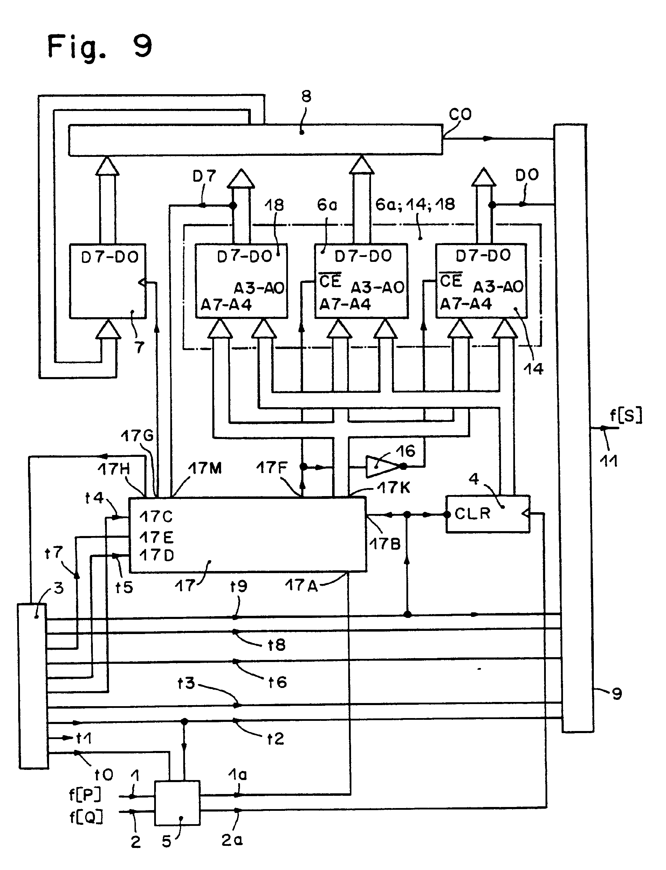

- In der achten Variante (siehe Fig. 9):
  - Der erste Freigabeausgang 17F der Umschalteinrichtung 17 und damit des Mittels 17; 18 ist mit dem Freigabeeingang "$\overline{CE}$" des Festwertspeichers 6a und über den Inverter 16 invertiert mit dem Freigabeeingang "$\overline{CE}$" des Festwertspeichers 14 verbunden, während der zweite Freigabeausgang 17G der Umschalteinrichtung 17 und damit des Mittels 17; 18 auf den Takteingang der Einrichtung 7 geführt ist, und
  - der Parallelausgang des Impulszählers 4 ist über eine Busverbindung nur auf einen Teil, nämlich auf die vier niederwertigsten der Adresseneingänge A0 bis A3 und der Parallelausgang 17K der Umschalteinrichtung 17 und damit des Mittels 17; 18 über eine Busverbindung auf die vier höherwertigen Adresseneingänge A4 bis A7 jeweils der drei Festwertspeicher 6a, 14 und 18 geführt.

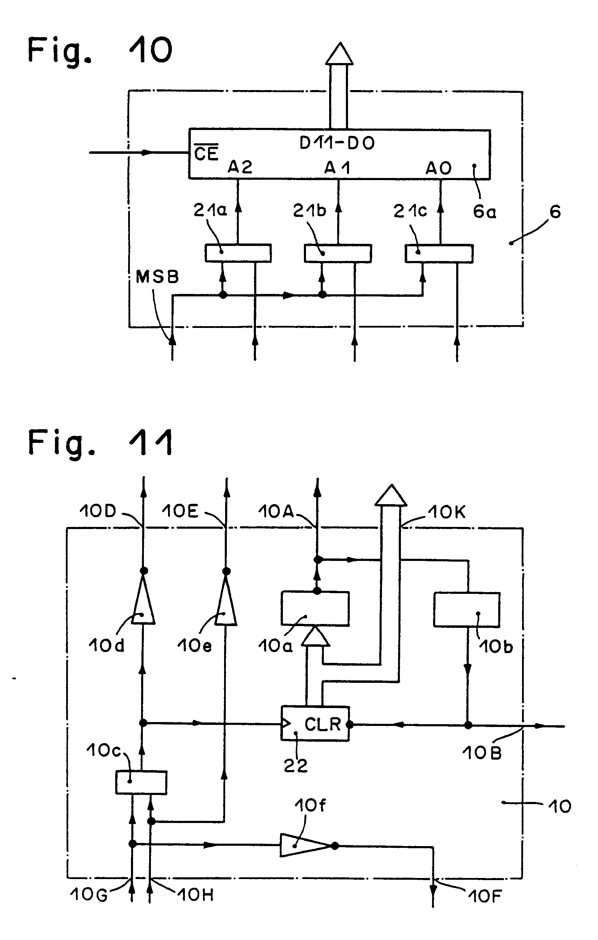

In der ersten, zweiten, vierten, fünften und sechsten Variante (siehe Fig. 2, Fig. 3, Fig. 6 und Fig. 7) wurde bisher angenommen, dass die Festwertspeichereinheit 6 nur aus dem Festwertspeicher 6a besteht. Die Festwertspeichereinheit 6 kann in diesen Varianten jedoch auch den in der Fig. 10 dargestellten Aufbau besitzen. Sie besteht dann aus dem Festwertspeicher 6a und einer Gruppe von drei Exklusiv-Oder-Gattern 21a, 21b und 21c, nämlich einem Exklusiv-Oder-Gatter weniger, als der Parallelausgang des Impulszählers 4 und - falls vorhanden - des Zwischenregisters 13 Anzahl Bits aufweist, während der Festwertspeicher 6a anstelle von vier nur mehr drei Adressenbits A0 bis A2 besitzt. Die ersten Eingänge aller Exklusiv-Oder-Gatter 21a, 21b und 21c sind in der Festwertspeichereinheit 6 miteinander verbunden und bilden den höchstwertigen Biteingang MSB ("most significant bit") eines 4bit-Adresseneingangs A0 bis A3 der Festwertspeichereinheit 6, während ein zweiter Eingang eines jeden Exklusiv-Oder-Gatters 21a bzw. 21b bzw. 21c die drei andern niederwertigen Biteingänge dieses 4bit-Adresseneingangs bildet. Die drei Exklusiv-Oder-Gatter 21a, 21b und 21c sind ihrerseits den drei Adresseneingängen A0 bis A2 des Festwertspeichers 6a vorgeschaltet, d. h. ihre Ausgänge sind mit diesen Adresseneingängen A0 bis A2 verbunden. Der 4bit-Adresseneingang der Festwertspeichereinheit 6 ist in der ersten und fünften Variante mit dem Parallelausgang des Impulszählers 4 und in der zweiten und sechsten Variante mit dem Datenausgang des Zwischenregisters 13 zu verbinden.

Das Mittel 10 zur Freigabe der Auswertung, dessen Aufbau in der Fig. 11 dargestellt ist, enthält mindestens einen weiteren Impulszähler 22, ein Mittel 10a zur Auslösung eines Freigabesignals, ein Impulsverzögerungsglied 10b und ein Oder-Gatter 10c. In der zweiten und dritten Variante sind ausserdem noch ein Inverter 10d sowie in der dritten Variante noch ein Inverter 10e und ein Inverter 10f vorhanden. Das Mittel 10a zur Auslösung eines Freigabesignals ist ein Decoder, vorzugsweise ein viereingängiges Nand-Gatter. Der Parallelausgang des Impulszählers 22 ist über eine Busverbindung mit einem Eingang des Mittels 10a verbunden, dessen invertierender Ausgang den Freigabeausgang 10A des Mittels 10 bildet und auf einen Eingang des Impulsverzögerungsgliedes 10b geführt ist, dessen Ausgang seinerseits mit einem Rückstelleingang CLR des Impulszählers 22 und mit dem Rückstellausgang 10B des Mittels 10 verbunden ist. Die beiden Eingänge 10G und 10H des Mittels 10, an denen über den Synchronisierer 5 die Eingangssignale 1 und 2 anstehen (siehe die Figuren 2 bis 9), sind je auf einen Eingang des Oder-Gatters 10c geführt, dessen Ausgang seinerseits mit dem Takteingang des Impulszählers 22 und - falls vorhanden - über den Inverter 10d mit dem weiteren Freigabeausgang 10D des Mittels 10 verbunden ist. Falls die Inverter 10e und 10f vorhanden sind, ist der Eingang 10H des Mittels 10 über den Inverter 10e auf den zweiten weiteren Freigabeausgang 10E und der Eingang 10G über den Inverter 10f auf den dritten weiteren Freigabeausgang 10F jeweils des Mittels 10 geführt. Der Parallelausgang des Impulszählers 22 ist ausserdem auf einen Parallelausgang 10K des Mittels 10 geführt.

Der Aufbau der Umschalteinrichtung 17 ist aus der Fig. 12 ersichtlich und besteht aus dem weiteren Impulszähler 22, einem Nand-Gatter 23, einem Inverter 24, einem D-Flipflop 25, einem Inverter 26 und einem Inverter 27. Das Signal t4 des Taktverteilers 3 speist über den Takteingang 17C der Umschalteinrichtung 17 einen ersten Eingang des Nand-Gatters 23, dessen Ausgang seinerseits den Rückstellausgang 17H der Umschalteinrichtung 17 bildet. Das Signal t7 des Taktverteilers 3 ist seinerseits über den Takteingang 17E der Umschalteinrichtung 17 unmittelbar auf den Freigabeausgang 17G der Umschalteinrichtung 17 und über den Inverter 24 auf einen Takteingang des D-Flipflops 25 geführt, dessen D-Eingang an Masse liegt, dessen "$\overline{Q}$"-Ausgang den Freigabeausgang 17F der Umschalteinrichtung 17 bildet und dessen Setzeingang vom Signal t5 des Taktverteilers 3 über den Takteingang 17D der Umschalteinrichtung 17 und den Inverter 27 gespeist ist. Der Umschalteingang 17M der Umschalteinrichtung 17 und damit der höchstwertige Datenausgang D11 bzw. D7 des Festwertspeichers 18 (siehe Fig. 6 bis Fig. 9) ist über den Inverter 26 mit einem zweiten Eingang des Nand-Gatters 23 verbunden. Der Rückstelleingang CLR des Impulszählers 22 bildet seinerseits den Rückstelleingang 17B der Umschalteinrichtung 17, während deren Signaleingang 17A, an dem in den letzten vier Varianten der erfindungsgemässen Anordnung synchronisiert das erste Eingangssignal 1 ansteht, mit dem Takteingang des Impulszählers 22 verbunden ist, dessen Parallelausgang den Parallelausgang 17K der Umschalteinrichtung 17 und damit des Mittels 17; 18 bildet.

Der Impulszähler 22 besitzt in allen Varianten vorzugsweise ebensoviele Bits wie der Impulszähler 4, also z. B. 4 Stück.

Nachfolgend wird zuerst die Arbeitsweise der drei ersten Varianten beschrieben (siehe Fig. 2 bis Fig. 4):

Der Takteingang des Impulszählers 22 ist über das Oder-Gatter 10c (siehe Fig. 11) derart mit den beiden Eingangssignalen 1 und 2 verbunden, die synchronisiert an den Eingängen 10G und 10H des Mittels 10 anstehen, dass der Impulszähler 22 jeweils die Summe der Anzahl der durch den Synchronisierer 5 ggfs. leicht verzögerten Impulse der beiden Eingangssignale 1 und 2 zählt und zwar von 0 bis R. Das dabei am invertierenden Ausgang des Mittels 10a und somit am Freigabeausgang 10A des Mittels 10 erscheinende Freigabesignal dient der Auswertungsfreigabe des Inhaltes des Impulszählers 4 zu einem Zeitpunkt, an dem der Inhalt des Impulszählers 22 und damit die Summe der Anzahl Impulse der beiden Eingangssignale 1 und 2 einen bestimmten vorgegebenen Wert R erreicht. Nach dem R-ten, z. B. dem 15-ten Impuls dieser Summe ist der Inhalt des Impulszählers 22 gleich R=15 und es erscheint ein negativgehender Impuls am invertierenden Ausgang des Mittels 10a, welches die Zahl 15=1111 decodiert. In diesem Augenblick ist der Inhalt des Impulzählers 4 gleich q, wenn q die Anzahl Blindleistungs-Impulse, d. h. die Anzahl Impulse des Eingangssignals 2 bezeichnet, die bis zu diesem Augenblick die Takteingänge der beiden Impulszähler 4 und 22 erreicht hat. Der Ausgangsimpuls des Mittels 10a gibt in diesem Augenblick über den Freigabeausgang 10A des Mittels 10 die Auswertung des Inhaltes des Impulszählers 4 frei und stellt nach dieser Auswertung verzögert mit Hilfe des Impulsverzögerungsgliedes 10b den Inhalt des Impulszählers 22 und über den Rückstellausgang 10B den Inhalt des Impulszählers 4 auf Null zurück, und zwar bevor ein weiterer Impuls der Eingangssignale 1 und 2 einen Takteingang der beiden Impulszähler 4 und 22 erreichen kann. Wenn die Anzahl Wirkleistungs-Impulse, d. h. die Anzahl Impulse des Eingangssignals 1, die bis zu diesem Augenblick den Takteingang des Impulszählers 22 erreicht hat, mit p bezeichnet wird, dann gelten im Freigabeaugenblick die Gleichungen:

$$p + q = R = 15 \text{ oder } p = R - q = 15 - q \quad [V].$$

Da die Werte p und q proportional den zugehörigen Wirkleistungs-bzw. Blindleistungs-Werten P und Q sind, ergeben die Formeln [I] bis [V] folgende Gleichungen:

$$g_s = \{\sqrt{[q^2 + p^2]}\}/R = [1/R].\sqrt{\{q^2 + [R - q]^2\}} = s/R \quad [VI],$$
$$tg\phi = q/p = q/[R - q] \quad [VII],$$

7

$$\sin\phi = q/[g_s R] = [q/p]/\sqrt{[1+q^2/p^2]} = tg\phi/\sqrt{[1+tg^2\phi]}$$
$$= q/\sqrt{\{q^2+[R-q]^2\}} \qquad\qquad [VIII]$$

und

$$\cos\phi = p/[g_s R] = 1/\sqrt{[1+q^2/p^2]} = 1/\sqrt{[1+tg^2\phi]}$$
$$= [R-q]/\sqrt{\{q^2+[R-q]^2\}} \qquad\qquad [IX],$$

wobei $g_s$ die durch den vorgegebenen Wert R geteilte Anzahl s $= \sqrt{[p^2 + q^2]}$ Impulse derjenigen Werte S der Scheinleistung bezeichnet, die den Werten P und Q der Wirkleistung und der Blindleistung entsprechen.

Zu jedem Wert von q gehört somit gemäss den Gleichungen [V] bis [IX] je ein einziger Wert von p=R-q, von $g_s = [1/R].\sqrt{\{q^2 + [R - q]^2\}}$, von tg$\phi$=q/p, von $\sin\phi = q/\sqrt{\{q^2 + [R - q]^2\}}$ und von $\cos\phi = [R - q]/\sqrt{\{q^2 + [R - q]^2\}}$, wobei q alle ganzzahligen Werte von 0 bis R annehmen kann.

Für den Fall R=15 sind in der nachfolgenden Tabelle I die zugehörigen Werte von p, tg$\phi$, cos$\phi$, sin$\phi$ und $g_s$ für alle zugelassenen Werte von q dargestellt, wobei q selber sowohl dezimal als auch dual dargestellt ist.

Tabelle I:

| q dez | q dual | p= R-q | tgø= q/[R-q] | cosø= [R-q]/√{q²+[R-q]²} | sinø= q/√{q²+[R-q]²} | $g_s$=[1/R]. √{q²+[R-q]²} |
|---|---|---|---|---|---|---|
| 0 | 0000 | 15 | 0 | 1.000 | 0.000 | 1.000 |
| 1 | 0001 | 14 | 1/14 | 0.997 | 0.071 | 0.936 |
| 2 | 0010 | 13 | 2/13 | 0.988 | 0.152 | 0.877 |
| 3 | 0011 | 12 | 3/12 | 0.970 | 0.243 | 0.825 |
| 4 | 0100 | 11 | 4/11 | 0.940 | 0.342 | 0.780 |
| 5 | 0101 | 10 | 5/10 | 0.894 | 0.447 | 0.745 |
| 6 | 0110 | 9 | 6/9 | 0.832 | 0.555 | 0.721 |
| 7 | 0111 | 8 | 7/8 | 0.753 | 0.659 | 0.709 |
| 8 | 1000 | 7 | 8/7 | 0.659 | 0.753 | 0.709 |
| 9 | 1001 | 6 | 9/6 | 0.555 | 0.832 | 0.721 |
| 10 | 1010 | 5 | 10/5 | 0.447 | 0.894 | 0.745 |
| 11 | 1011 | 4 | 11/4 | 0.342 | 0.940 | 0.780 |
| 12 | 1100 | 3 | 12/3 | 0.243 | 0.970 | 0.825 |
| 13 | 1101 | 2 | 13/2 | 0.152 | 0.988 | 0.877 |
| 14 | 1110 | 1 | 14 | 0.071 | 0.997 | 0.936 |
| 15 | 1111 | 0 | 15/0 | 0.000 | 1.000 | 1.000 |

Die in der Tabelle I dargestellten Zahlenwerte $g_s$, sin$\phi$ und cos$\phi$ sind im allgemeinen irrationale Zahlen. Sie lassen sich also mit einer endlichen Anzahl Stellen des dezimalen oder eines anderen Zahlensystems nicht genau, sondern nur mit einer gewissen Annäherung darstellen, was einen Rundungsfehler ergibt. Dies bedeutet, dass diese Zahlenwerte mindestens auf das nächste ganzahlige Multipel von $1/2^K$ abgerundet werden müssen, und zwar vorzugsweise nach unten hin, um mit K Bits z. B. im Festwertspeicher 6a dargestellt werden zu können. In den drei ersten Varianten gelten K=12 Bits und $1/2^K$=1/4096, da $2^{12}$=4096. Durch dieses Abrunden muss dann ein maximaler Fehler von ca +/- (1/8) Promille in Kauf genommen werden.

Nachfolgend bezeichnet A in den drei ersten Varianten und in der fünften bis siebten Variante jeweils eine beliebige Zahl, die auch irrational sein kann und die grösser oder gleich einem Zehntel ist. In der vierten und achten Variante ist A dagegen immer gleich 1.

- In den beiden ersten Varianten werden die mit Hilfe der Gleichung VI berechneten Werte von $A.g_s$ auf Multiple von $1/2^K$ abgerundet und diese abgerundeten Zahlenwerte im Festwertspeicher 6a unter Adressen gespeichert, die jeweils vom zugehörigen durch den Impulszähler 4 gezählten Wert q abgeleitet sind.

- In der dritten Variante werden die mit Hilfe der Gleichung VIII berechneten Werte von $A.\sin\phi$ auf Multiple von $1/2^K$ abgerundet und diese abgerundeten Werte im Festwertspeicher 6a unter Adressen gespeichert, die jeweils vom zugehörigen durch den Impulszähler 4 gezählten Wert q abgeleitet sind. In der dritten Variante werden ausserdem die mit Hilfe der Gleichung IX berechneten Werte von $A.\cos\phi$ auf Multiple von $1/2^K$ abgerundet und diese abgerundeten Werte im Festwertspeicher 14 unter Adressen gespeichert, die ebenfalls jeweils vom zugehörigen Wert q abgeleitet sind.

Somit sind alle im Festwertspeicher 6a gespeicherten Zahlenwerte abhängig von den Werten von q und, da diese proportional den Werten Q sind, abhängig von den Werten Q der Blindleistung. In allen drei ersten Varianten besitzt dabei q, wie bereits erwähnt, alle ganzzahligen Werte von 0 bis R, d. h. von 0 bis 15.

Im Auswertungszeitpunkt ist der Dualwert von q (siehe die zweite Kolonne der Tabelle I) im Impulszähler 4 gespeichert. Dieser Dualwert von q wird ausserdem in der zweiten und dritten Variante (siehe Fig. 3 und Fig. 4) im Auswertungszeitpunkt durch den Ausgangsimpuls des Mittels 10a in das Zwischenregister 13 übernommen. Dies bedeutet, dass in den drei ersten Varianten der Dualwert von q, sei es vom Parallelausgang des Impulszählers 4 in der ersten Variante, sei es vom Datenausgang des Zwischenregisters 13 in der zweiten und dritten Variante, entweder unmittelbar (siehe Fig. 2 bis Fig. 4) oder - falls die in der Fig. 10 dargestellte Festwertspeichereinheit 6 verwendet wird - über die Gruppe der Exklusiv-Oder-Gatter 21a, 21b und 21c alle Adresseneingänge A0 bis A3 bzw. A0 bis A2 des Festwertspeichers 6a erreicht, wobei die Gruppe der Exklusiv-Oder-Gatter 21a bis 21c allerdings nur in den beiden ersten Varianten vorhanden sein kann.

Wenn die Gruppe der Exklusiv-Oder-Gatter 21a bis 21c nicht vorhanden ist, dann bildet der Dualwert von q in den drei ersten Varianten unmittelbar eine 4bit-Adresse des Festwertspeichers 6a.

Wenn die Gruppe der Exklusiv-Oder-Gatter 21a bis 21c dagegen in den beiden ersten Varianten vorhanden ist, dann bildet der Ausgangswert dieser Gruppe jeweils eine 3bit-Adresse des Festwertspeichers 6a, die von den 4Bit des Dualwertes von q abgeleitet ist. Wie aus der letzten Kolonne der Tabelle I ersichtlich ist, sind gleiche Werte von $g_s$ spiegelbildlich zu einer Mittellinie angeordnet, die zwischen den Werten 7 und 8 von q verläuft. Es sind somit nicht sechzehn, sondern nur halbsoviele, nämlich acht unterschiedliche Werte von $g_s$ vorhanden, was in den beiden ersten Varianten mit Hilfe der Gruppe der Exklusiv-Oder-Gatter 21a bis 21c dazu ausgenutzt werden kann, Speicherplätze im Festwertspeicher 6a zu sparen. Der Festwertspeicher 6a braucht dann nur mehr halbsoviele Speicherplätze und nur mehr eine 3bit-Adresse statt einer 4bit-Adresse. Jedem unterschiedlichen Wert von $g_s$ sind in diesem Fall jeweils zwei zusammengehörige Werte von q zugeordnet, nämlich:

## Tabelle II:

```
q=0=0000 und q=15=1111 zu gs=1.000 bzw.

q=1=0001 und q=14=1110 zu gs=0.936 bzw.

q=2=0010 und q=13=1101 zu gs=0.877 bzw.

q=3=0011 und q=12=1100 zu gs=0.825 bzw.

q=4=0100 und q=11=1011 zu gs=0.780 bzw.

q=5=0101 und q=10=1010 zu gs=0.745 bzw.

q=6=0110 und q=09=1001 zu gs=0.721 bzw.

q=7=0111 und q=08=1000 zu gs=0.709.
```

Wie aus der Tabelle II ersichtlich ist, sind die Dualwerte zweier zusammengehöriger Werte von q, denen ein gleicher $g_s$-Wert zugeordnet ist, invertierte 4bit-Dualwerte, d. h. jedes Bit des einen ist das invertierte Bit des andern. Oder anders ausgedrückt:

- Beim ersten 4bit-Dualwert zweier zusammengehöriger Dualwerte von q besitzt das höchstwertige Bit (MSB) des 4bit-Dualwertes einen Wert Null, und die 3bit-Adresse des Festwertspeichers 6a muss gleich den drei niederwertigsten Bits der ersten 4bit-Dualwerte von q sein.

- Beim zweiten 4bit-Dualwert zweier zusammengehöriger 4bit-Dualwerte von q besitzt das höchstwertige Bit (MSB) dagegen einen Wert Eins, und die 3bit-Adresse des Festwertspeichers 6a muss dann gleich den invertierten drei niederwertigsten Bits des ersten 4bit-Dualwertes von q sein, damit ein gleicher Wert von $g_s$ aus dem Festwertspeicher 6a gelesen wird.

Dies wird mit Hilfe der drei Exklusiv-Oder-Gatter 21a bis 21c erreicht, da bekanntlich ein Exklusiv-Oder-Gatter bei unterschiedlichen Eingangswerten einen Logikwert Eins und bei gleichen Eingangswerten ein Logikwert Null an seinem Ausgang erzeugt. Bei einem Logikwert Null an einem der beiden Eingänge eines Exklusiv-Oder-Gatters werden somit Logikwerte Null oder Eins am andern Eingang des Exklusiv-Oder-Gatters durch das Exklusiv-Oder-Gatter bestätigt, während bei einem Logikwert Eins an einem der beiden Eingänge die Logikwerte Null oder Eins des andern Eingangs durch das Exklusiv-Oder-Gatter invertiert werden.

In einer besonders vorteilhaften Gruppe von optimierten Untervarianten der beiden ersten Varianten sind im Festwertspeicher 6a Zahlenwerte gespeichert, die um $Y/2^K$ niedriger sind als die auf das nächstliegende Multiple von $1/2^K$ abgerundeten Zahlenwerte der berechneten Werte von $A.g_s$. Dabei ist Y jeweils eine ganzzahlige Zahl, die von den Werten der Parameter K, R und A abhängig ist und in der Regel Werte von 0 bis 4 besitzt. Diese Werte von Y können dabei für die einzelnen berechneten Werte von $A.g_s$ unterschiedlich sein.

Eine in Funktion der Phase $\phi$ aufgetragene Fehlerkennlinie der Scheinleistung besitzt im Falle von Y=0 nur positive Werte, so dass es vorteilhaft ist, einen ganzzahligen Wert von 1 bis 4 für Y zu wählen. In diesem Fall weist die erwähnte Fehlerkennlinie der Scheinleistung sowohl positive als auch negative Werte auf, wobei die Werte von Y dann vorzugsweise so zu wählen sind, dass die Null-Linie annähernd die Mittellinie dieser Fehlerkennlinie bildet. Die Verwendung eines von Eins unterschiedlichen Wertes von A hat in den drei ersten Varianten jeweils den Vorteil, dass die Ausgangsimpulse der erfindungsgemässen Anordnung bereits in sogenannten "engineering units" ausgedrückt werden können, d. h., dass diese Impulse bereits mit einer Proportionalitätskonstante gewichtet sind, so dass jeder Impuls einer bestimmten technischen Energieeinheit entspricht.

In der in der Fig. 2 dargestellten ersten Variante steht im Auswerteaugenblick an den Adresseneingängen A0 bis A3 bzw. A0 bis A2 des Festwertspeichers 6a eine Adresse an, die von dem im Auswerteaugenblick geltenden Wert von q abgeleitet ist. Der am Freigabeausgang 10A des Mittels 10 erscheinende Ausgangsimpuls des Mittels 10a gibt den Festwertspeicher 6a im Auswerteaugenblick frei, so dass der in ihm unter der anstehenden Adresse gespeicherte Zahlenwert am Datenausgang D0 bis D11 des Festwertspeichers 6a erscheint und mit Hilfe des Addierers 8 zum bereits vorhandenen, in der Einrichtung 7 gespeicherten Zwischenresultat addiert wird. Das Resultat der Addition wird am Ende des Ausgangsimpulses des Mittels 10a, der wegen des invertierten Ausganges ein negativgehender Impuls ist, durch die ansteigende Flanke dieses Ausgangsimpulses in der Einrichtung 7 gespeichert und zwar mit Hilfe von deren Takteingang. Also jedesmal, wenn der Impulszähler 22 den Wert R=15 erreicht, wird der im Festwertspeicher 6a gespeicherte Zahlenwert, der dem im Impulszähler 4 gespeicherten Wert von q entspricht, in den Addierer 8 gegeben und zum alten Zwischenresultat addiert, d. h. diese Zahlenwerte werden akkumuliert, wobei das Resultat der Kumulation als neues Zwischenresultat in der Einrichtung 7 abgespeichert wird. Dadurch, dass in der ersten Variante der Impulszähler 22 die Addition nur bei jedem 15. Impuls freigibt, wird die Eingangsfrequenz des Impulszählers 22 durch 15 geteilt, d. h. die Ausgangsfrequenz f[S] der erfindungsgemässen Anordnung ist 15mal niedriger als diese Eingangsfrequenz, oder anders ausgedrückt, die Wertigkeit der Ausgangsimpulse der erfindungsgemässen Anordnung ist 15mal höher als diejenige der Impulse der beiden Eingangssignale 1 und 2.

In den in der Fig. 3 und der Fig. 4 dargestellten zweiten und dritten Varianten lädt dagegen der Ausgangsimpuls des Mittels 10a den gerade im Impulszähler 4 anstehenden Wert von q in das Zwischenregister 13, so dass eine von diesem Wert von q abgeleitete Adresse ab diesem Auswerteaugenblick als Adresse an den Adresseneingängen A0 bis A3 bzw. A0 bis A2 des Festwertspeichers 6a ansteht und zwar mindestens solange, bis ein neuer Ausgangsimpuls des Mittels 10a erscheint, um eine neue Auswertung des Impulszählers 4 einzuleiten.

In der in der Fig. 3 dargestellten zweiten Variante gibt jeder mit Hilfe des Inverters 10d (siehe Fig. 11) invertierte Impuls des Eingangssignals 1 oder 2, der am Takteingang des Impulszählers 22 erscheint, den Festwertspeicher 6a frei, so dass der in ihm unter der vom Zwischenregister 13 gelieferten anstehenden Adresse gespeicherte Zahlenwert am Datenausgang D0 bis D11 des Festwertspeichers 6a erscheint und mit Hilfe des Addierers 8 zum bereits vorhandenen, in der Einrichtung 7 gespeicherten Zwischenresultat addiert wird. Das Resultat der Addition wird dann am Ende des negativgehenden Ausgangsimpulses des Inverters 10d durch dessen steigende Flanke in der Einrichtung 7 gespeichert mit Hilfe von deren Takteingang. Der im Festwertspeicher 6a gespeicherte Zahlenwert wird somit jedesmal, wenn ein Impuls des ersten oder des zweiten Eingangssignals 1 oder 2 am Takteingang des Impulszählers 22 eintrifft, also R=15mal zwischen zwei aufeinanderfolgenden Auswerteaugenblicken, in den Addierer 8 gegeben. Ansonsten funktioniert die in der Fig. 3 dargestellte Variante genauso wie die in der Fig. 2 dargestellte Variante. Bedingung für das korrekte Funktionieren der zweiten und auch der dritten Variante ist die Voraussetzung, dass der Wert S der Scheinleistung sich nur langsam ändert und zwischen zwei aufeinanderfolgenden Auswerteaugenblicken als annähernd konstant angenommen werden kann. Durch die zweite Variante wird eine 15fache Erhöhung der Ausgangsfrequenz f[S] der erfindungsgemässen Anordnung erreicht. Ein Nachteil der zweiten Variante liegt darin, dass die Impulse der beiden Eingangsssignale 1 und 2 gleich stark gewichtet werden. Diesen Nachteil vermeidet die dritte Variante.

Aus den Gleichungen [III] und [IV] ist ersichtlich, dass in Wirklichkeit die Impulse des ersten Eingangssignals 1 mit den Werten von $\cos\phi$ und die Impulse des zweiten Eingangssignals 2 mit den Werten von $\sin\phi$ zu gewichten sind. Deshalb sind in der dritten Variante Zahlenwerte, die abhängig sind von $A.\sin\phi$ und $A.\cos\phi$, im Festwertspeicher 6a bzw. im Festwertspeicher 14 gespeichert. In der dritten Variante (siehe Fig. 4) gibt jeder mit Hilfe des Inverters 10e bzw. 10f (siehe Fig. 11) invertierte Impuls des Eingangssignals 1 oder 2 entweder den Festwertspeicher 6a frei, wenn er ein Impuls des zweiten Eingangssignals 2 ist, oder den Festwertspeicher 14 frei, wenn er ein Impuls des ersten Eingangssignals 1 ist. Dabei steht an den Adresseneingängen A0 bis A3 des Festwertspeichers 14 wegen den Inverter 15 die invertierte Adresse des Festwertspeichers 6a an. Die Anwesenheit der Inverter 15 hat den Vorteil, dass in den beiden Festwertspeichern 6a und 14 sechzehn unterschiedliche Zahlenwerte in der gleichen Reihenfolge abgespeichert werden können. Wie aus der Tabelle I ersichtlich, ist nämlich der zu einem bestimmten Dualwert von q gehörende Wert von $\cos\phi$ gleich dem zum invertierten Dualwert vom gleichen q gehörenden Wert von $\sin\phi$. Bei Benutzung der Inverter 15 sind somit gleichwertige abgerundete Werte von A.$\cos\phi$ und A.$\sin\phi$ in den beiden Festwertspeichern 6a und 14 unter gleichen Adressen gespeichert. Sobald einer der beiden Festwertspeicher 6a oder 14 freigegeben ist, erscheint der in ihm unter der anstehenden Adresse gespeicherte angenäherte Wert von A.$\sin\phi$ oder A.$\cos\phi$ an seinem Datenausgang D0 bis D11 und damit an einem der beiden Eingänge des Addierers 8, der diesen Zahlenwert zum bereits vorhandenen, in der Einrichtung 7 gespeicherten Zwischenresultat addiert. Das Resultat der Addition wird dann am Ende des durch den Inverter 10d (siehe Fig. 11) invertierten Impulses der Eingangssignale 1 und 2, die am Takteingang des Impulszählers 22 anstehen, durch die steigende Flanke dieses invertierten Impulses in die Einrichtung 7 gespeichert mit Hilfe von deren Takteingang. Einmal von der unterschiedlichen Gewichtung der Impulse der beiden Eingangssignale 1 und 2 abgesehen, funktioniert die dritte Variante genau so wie die zweite Variante. Auch in ihr wird somit eine 15fache Erhöhung der Ausgangsfrequenz f[S] erreicht.

Sobald der Ausgangswert des Addierers 8 einen Wert $2^K=4096$ erreicht hat, d. h. nachdem dieser Addierer einen Wert 4096 mal 1/4096 errechnet hat, läuft der Inhalt des Addierers 8 über und es erscheint in allen Varianten ein Impuls am Übertragsausgang CO ("carry out") des Addierers 8. Ist die Dauer dieses Impulses ungenügend, so wird diese Impulsdauer in der dann notwendigerweise vorhandenen Ausgangsschaltung 9, die hier in den drei ersten Varianten vorzugsweise aus einem Impulsformer besteht, aufbereitet und neu generiert, so dass die Impulse des Ausgangssignals 11 der erfindungsgemässen Anordnung eine definierte Dauer erhalten, wobei ihre Startflanken immer mit denjenigen der Ausgangsimpulse des Übertragsausganges CO des Addierers 8 übereinstimmen. Im einfachsten Fall ist der Impulsformer z. B. ein monostabiler Multivibrator oder ein Und-Gatter. Im letzten Fall, der in den Figuren 2 bis 4 sowie 6 bis 8 angenommen wurde, reduziert sich die in der Fig. 16 dargestellte Ausgangsschaltung 9 auf das Und-Gatter 31 und besitzt nur mehr zwei Eingänge, wovon einer mit dem Übertragsausgang CO des Addierers 8 verbunden ist und der andere vom Signal t6 des Taktverteilers 3 angesteuert ist.

Nachfolgend wird die Arbeitsweise der vierten Variante beschrieben (siehe Fig. 5):

Bei der Berechnung der Werte von $s = \sqrt{(q^2 + p^2)} = \sqrt{\{q^2 + [R - q]^2\}}$ kann q in der vierten Variante wieder alle ganzzahligen Werte von 0 bis R annehmen, wobei R diesmal z. B. gleich 10 ist. In der vierten Variante ist, wie bereits erwähnt, A immer gleich 1.

Die berechneten Werte von s bestehen in der Regel jeweils aus einem ganzen Wert und einem gegebenenfalls abgerundeten Dualbruch ("binary fraction"). Letzterer wird jeweils mit einem Faktor dermassen multipliziert, dass ein ganzzahlwertiges Multiple von $1/2^K$ entsteht, welches dann selber keinen Dualbruch mehr enthält. In einer besonders vorteilhaften optimierten Untervariante der vierten Variante werden die berechneten Werte von s um einen Wert $Y/2^K$ verkleinert, wobei Y wieder eine ganzzahlige Zahl ist, die von den Werten der Parameter K, R und A abhängig ist und in der Regel wieder Werte von 0 bis 4 besitzt. Diese Werte von Y können dabei für die einzelnen berechneten Werte von s unterschiedlich sein und sind wieder vorzugsweise so zu wählen, dass die Null-Linie annähernd die Mittellinie der Fehlerkennlinie bildet. Die so berechneten ganzzahligen Werte und ganzzahlwertigen Multiplen der Dualbrüche der gegebenenfalls um $Y/2^K$ verkleinerten berechneten Werte von s sind immer Multiple von $1/2^K$ und können somit je in einem Kbit-Festwertspeicher abgespeichert werden. In der in der Fig. 5 dargestellten Anordnung gelten K=8 und $2^K=2^8=256$.

Im Festwertspeicher 14 sind die berechneten, den ganzzahligen Werten von s entsprechenden Zahlenwerte gespeichert, nämlich diese ganzzahligen Werte selber oder die ganzzahligen Werte der um $Y/2^K$ verkleinerten berechneten Werte von s. Im Festwertspeicher 6a sind dagegen die berechneten, den ganzzahlwertigen Multiplen von $1/2^K$ entsprechenden Zahlenwerte gespeichert, nämlich die ganzzahlwertigen Multiplen von $1/2^K$ der gegebenenfalls abgerundeten Dualbrüche von s oder die ganzzahlwertigen Multiplen von $1/2^K$ der Dualbrüche der um $Y/2^K$ verkleinerten berechneten Werte von s, und zwar unter Adressen, die von den zugehörigen im Impulszähler 4 gespeicherten Werten von q abgeleitet sind.

Die Adresse des Festwertspeichers 6a besteht aus den 4bit-Binärwerten von q, die im Impulszähler 4 gespeichert sind, während die 4bit-Binärwerten von p+q im Impulszähler 22 des Mittels 10 gespeichert sind. Die Werte von (p+q) sind dabei immer grösser oder gleich denjenigen von q, da p immer grösser oder gleich Null ist. In der dritten Kolonne der nachfolgenden Tabelle III sind alle vorkommenden Werte der Adressen des Festwertspeichers 6a in Binär-Darstellung wiedergegeben. Die acht niederwertigsten Bits der Adressen des weiteren Festwertspeichers 14 bestehen dagegen in der angegebenen Reihenfolge aus den aneinandergereihten Werten von p+q und q.

In der vierten und fünften Kolonne der Tabelle III sind die zugehörigen Werte von p und von $s = \sqrt{(q^2 + p^2)}$ jeweils in dezimaler Darstellung wiedergegeben, während in der sechsten und achten Kolonne, ebenfalls dezimal, zugehörige ganzzahlige Werte $s_a$ der um $Y/2^K$ verkleinerten berechneten Werte von s bzw. die mit $10^4$ multiplizierten zugehörigen Dezimalbrüche von s dargestellt sind, wobei das Vorhandensein von abgerundeten vierstelligen Dezimalbrüchen angenommen wurde. Die mit $10^4$ multiplizierten abgerundeten Dezimalbrüche von s stellen dabei in Dezimaldarstellung die obenerwähnten ganzzahlwertigen Multiplen der gegebenenfalls abgerundeten Dualbrüche von s dar. Die Werte von $s_a$ sind ihrerseits grösstenteils gleich den ganzzahligen Werten von s mit Ausnahme der bereits ganzzahlwertigen Werte von s, bei denen die ganzzahligen Werte von s um einen Wert Eins verringert sind.

In der siebten Kolonne der Tabelle III ist angegeben, ob der Wert von $s_a$ geradzahlig oder ungeradzahlig ist, wobei O einen geradzahligen und 1 einen ungeradzahligen Wert darstellt.

Tabelle III:

| HEX | BINAER p+q  q | Wirk-energie p (dezimal) | $s=\sqrt{(q^2+p^2)}$ | Scheinenergie (dezimal) $s_a$ | $s_a$ gerade=0/ ungerade=1 | Dezimal-brüche $.10^4$ |
|-----|---------------|--------------------------|----------------------|-------------------------------|-----------------------------|------------------------|
| 00 | 0000 0000 | 0 | 0 | 0 | 0 | 0000 |
| 10 | 0001 0000 | 1 | $\sqrt{1}=1$ | 0 | 0 | 10000 |
| 11 | 0001 0001 | 0 | $\sqrt{1}=1$ | 0 | 0 | 10000 |
| 20 | 0010 0000 | 2 | $\sqrt{4}=2$ | 1 | 1 | 10000 |
| 21 | 0010 0001 | 1 | $\sqrt{2}=1.4142$ | 1 | 1 | 4142 |
| 22 | 0010 0010 | 0 | $\sqrt{4}=2$ | 1 | 1 | 10000 |
| 30 | 0011 0000 | 3 | $\sqrt{9}=3$ | 2 | 0 | 10000 |
| 31 | 0011 0001 | 2 | $\sqrt{5}=2.2361$ | 2 | 0 | 2361 |
| 32 | 0011 0010 | 1 | $\sqrt{5}=2.2361$ | 2 | 0 | 2361 |
| 33 | 0011 0011 | 0 | $\sqrt{9}=3$ | 2 | 0 | 10000 |
| 40 | 0100 0000 | 4 | $\sqrt{16}=4$ | 3 | 1 | 10000 |
| 41 | 0100 0001 | 3 | $\sqrt{10}=3.1623$ | 3 | 1 | 1623 |
| 42 | 0100 0010 | 2 | $\sqrt{8}=2.8284$ | 2 | 0 | 8284 |
| 43 | 0100 0011 | 1 | $\sqrt{10}=3.1623$ | 3 | 1 | 1623 |
| 44 | 0100 0100 | 0 | $\sqrt{16}=4$ | 3 | 1 | 10000 |
| 50 | 0101 0000 | 5 | $\sqrt{25}=5$ | 4 | 0 | 10000 |
| 51 | 0101 0001 | 4 | $\sqrt{17}=4.1231$ | 4 | 0 | 1231 |
| 52 | 0101 0010 | 3 | $\sqrt{13}=3.6056$ | 3 | 1 | 6056 |
| 53 | 0101 0011 | 2 | $\sqrt{13}=3.6056$ | 3 | 1 | 6056 |
| 54 | 0101 0100 | 1 | $\sqrt{17}=4.1231$ | 4 | 0 | 1231 |
| 55 | 0101 0101 | 0 | $\sqrt{25}=5$ | 4 | 0 | 10000 |

Tabelle III (Fortsetzung 1):

| HEX | BINAER p+q  q | Wirk- energie p (dezimal) | $s=\sqrt{(q^2+p^2)}$ | Scheinenergie (dezimal) $s_a$ | $s_a$ gerade=0/ ungerade=1 | Dezimal- brüche $.10^4$ |
|---|---|---|---|---|---|---|
| 60 | 0110 0000 | 6 | $\sqrt{36}=6$ | 5 | 1 | 10000 |
| 61 | 0110 0001 | 5 | $\sqrt{26}=5.0990$ | 5 | 1 | 0990 |
| 62 | 0110 0010 | 4 | $\sqrt{20}=4.4721$ | 4 | 0 | 4721 |
| 63 | 0110 0011 | 3 | $\sqrt{18}=4.2426$ | 4 | 0 | 2426 |
| 64 | 0110 0100 | 2 | $\sqrt{20}=4.4721$ | 4 | 0 | 4721 |
| 65 | 0110 0101 | 1 | $\sqrt{26}=5.0990$ | 5 | 1 | 0990 |
| 66 | 0110 0110 | 0 | $\sqrt{36}=6$ | 5 | 1 | 10000 |
| 70 | 0111 0000 | 7 | $\sqrt{49}=7$ | 6 | 0 | 10000 |
| 71 | 0111 0001 | 6 | $\sqrt{37}=6.0828$ | 6 | 0 | 0828 |
| 72 | 0111 0010 | 5 | $\sqrt{29}=5.3852$ | 5 | 1 | 3852 |
| 73 | 0111 0011 | 4 | $\sqrt{25}=5$ | 4 | 0 | 10000 |
| 74 | 0111 0100 | 3 | $\sqrt{25}=5$ | 4 | 0 | 10000 |
| 75 | 0111 0101 | 2 | $\sqrt{29}=5.3852$ | 5 | 1 | 3852 |
| 76 | 0111 0110 | 1 | $\sqrt{37}=6.0828$ | 6 | 0 | 0828 |
| 77 | 0111 0111 | 0 | $\sqrt{49}=7$ | 6 | 0 | 10000 |
| 80 | 1000 0000 | 8 | $\sqrt{64}=8$ | 7 | 1 | 10000 |
| 81 | 1000 0001 | 7 | $\sqrt{50}=7.0711$ | 7 | 1 | 0711 |
| 82 | 1000 0010 | 6 | $\sqrt{40}=6.3246$ | 6 | 0 | 3246 |
| 83 | 1000 0011 | 5 | $\sqrt{34}=5.8310$ | 5 | 1 | 8310 |
| 84 | 1000 0100 | 4 | $\sqrt{32}=5.6569$ | 5 | 1 | 6569 |
| 85 | 1000 0101 | 3 | $\sqrt{34}=5.8310$ | 5 | 1 | 8310 |
| 86 | 1000 0110 | 2 | $\sqrt{40}=6.3246$ | 6 | 0 | 3246 |
| 87 | 1000 0111 | 1 | $\sqrt{50}=7.0711$ | 7 | 1 | 0711 |
| 88 | 1000 1000 | 0 | $\sqrt{64}=8$ | 7 | 1 | 10000 |

EP 0 382 890 B1

Tabelle III (Fortsetzung 2):

| HEX | BINAER p+q  q | Wirk-energie p (dezimal) | Scheinenergie (dezimal) $s=\sqrt{(q^2+p^2)}$ | $s_a$ | $s_a$ gerade=0/ ungerade=1 | Dezimal-brüche .$10^4$ |
|---|---|---|---|---|---|---|
| 90 | 1001 0000 | 9 | $\sqrt{81}=9$ | 8 | 0 | 10000 |
| 91 | 1001 0001 | 8 | $\sqrt{65}=8.0623$ | 8 | 0 | 0623 |
| 92 | 1001 0010 | 7 | $\sqrt{53}=7.2801$ | 7 | 1 | 2801 |
| 93 | 1001 0011 | 6 | $\sqrt{45}=6.7082$ | 6 | 0 | 7082 |
| 94 | 1001 0100 | 5 | $\sqrt{41}=6.4031$ | 6 | 0 | 4031 |
| 95 | 1001 0101 | 4 | $\sqrt{41}=6.4031$ | 6 | 0 | 4031 |
| 96 | 1001 0110 | 3 | $\sqrt{45}=6.7082$ | 6 | 0 | 7082 |
| 97 | 1001 0111 | 2 | $\sqrt{53}=7.2801$ | 7 | 1 | 2801 |
| 98 | 1001 1000 | 1 | $\sqrt{65}=8.0623$ | 8 | 0 | 0623 |
| 99 | 1001 1001 | 0 | $\sqrt{81}=9$ | 8 | 0 | 10000 |
| A0 | 1010 0000 | A | $\sqrt{A^2}=A=10$ | 9 | 1 | 10000 |
| A1 | 1010 0001 | 9 | $\sqrt{82}=9.0554$ | 9 | 1 | 0554 |
| A2 | 1010 0010 | 8 | $\sqrt{68}=8.2462$ | 8 | 0 | 2462 |
| A3 | 1010 0011 | 7 | $\sqrt{58}=7.6158$ | 7 | 1 | 6158 |
| A4 | 1010 0100 | 6 | $\sqrt{52}=7.2111$ | 7 | 1 | 2111 |
| A5 | 1010 0101 | 5 | $\sqrt{50}=7.0711$ | 7 | 1 | 0711 |
| A6 | 1010 0110 | 4 | $\sqrt{52}=7.2111$ | 7 | 1 | 2111 |
| A7 | 1010 0111 | 3 | $\sqrt{58}=7.6158$ | 7 | 1 | 6158 |
| A8 | 1010 1000 | 2 | $\sqrt{68}=8.2462$ | 8 | 0 | 2462 |
| A9 | 1010 1001 | 1 | $\sqrt{82}=9.0554$ | 9 | 1 | 0554 |
| AA | 1010 1010 | 0 | $\sqrt{A^2}=A=10$ | 9 | 1 | 10000 |

Tabelle III (Fortsetzung 3):

| HEX | BINAER p+q q | Wirk-energie p (dezimal) | $s=\sqrt{(q^2+p^2)}$ | $s_a$ | $s_a$ gerade=0/ ungerade=1 | Dezimal-brüche .10⁴ |
|---|---|---|---|---|---|---|
| B0 | 1011 0000 | B | $\sqrt{B^2}=B=11$ | 10 | 0 | 10000 |
| B1 | 1011 0001 | A | $\sqrt{101}=10.0499$ | 10 | 0 | 0499 |
| B2 | 1011 0010 | 9 | $\sqrt{85}=9.2195$ | 9 | 1 | 2195 |
| B3 | 1011 0011 | 8 | $\sqrt{73}=8.5440$ | 8 | 0 | 5440 |
| B4 | 1011 0100 | 7 | $\sqrt{65}=8.0623$ | 8 | 0 | 0623 |
| B5 | 1011 0101 | 6 | $\sqrt{61}=7.8102$ | 7 | 1 | 8102 |
| B6 | 1011 0110 | 5 | $\sqrt{61}=7.8102$ | 7 | 1 | 8102 |
| B7 | 1011 0111 | 4 | $\sqrt{65}=8.0623$ | 8 | 0 | 0623 |
| B8 | 1011 1000 | 3 | $\sqrt{73}=8.5440$ | 8 | 0 | 5440 |
| B9 | 1011 1001 | 2 | $\sqrt{85}=9.2195$ | 9 | 1 | 2195 |
| BA | 1011 1010 | 1 | $\sqrt{101}=10.0499$ | 10 | 0 | 0499 |
| BB | 1011 1011 | 0 | $\sqrt{B^2}=B=11$ | 10 | 0 | 10000 |
| C0 | 1100 0000 | C | $\sqrt{C^2}=C=12$ | 11 | 1 | 10000 |
| C1 | 1100 0001 | B | $\sqrt{122}=11.0454$ | 11 | 1 | 0454 |
| C2 | 1100 0010 | A | $\sqrt{104}=10.1980$ | 10 | 0 | 1980 |
| C3 | 1100 0011 | 9 | $\sqrt{90}=9.4868$ | 9 | 1 | 4868 |
| C4 | 1100 0100 | 8 | $\sqrt{80}=8.9443$ | 8 | 0 | 9443 |
| C5 | 1100 0101 | 7 | $\sqrt{74}=8.6023$ | 8 | 0 | 6023 |
| C6 | 1100 0110 | 6 | $\sqrt{72}=8.4853$ | 8 | 0 | 4853 |
| C7 | 1100 0111 | 5 | $\sqrt{74}=8.6023$ | 8 | 0 | 6023 |
| C8 | 1100 1000 | 4 | $\sqrt{80}=8.9443$ | 8 | 0 | 9443 |
| C9 | 1100 1001 | 3 | $\sqrt{90}=9.4868$ | 9 | 1 | 4868 |
| CA | 1100 1010 | 2 | $\sqrt{104}=10.1980$ | 10 | 0 | 1980 |
| CB | 1100 1011 | 1 | $\sqrt{122}=11.0454$ | 11 | 1 | 0454 |
| CC | 1100 1100 | 0 | $\sqrt{C^2}=C=12$ | 11 | 1 | 10000 |

Tabelle III (Fortsetzung 4):

-------------------------------------------------------------------

| HEX | BINAER p+q q | Wirk-energie p (dezimal) | Scheinenergie (dezimal) $s=\sqrt{(q^2+p^2)}$ | $s_a$ | $s_a$ gerade=0/ ungerade=1 | Dezimal-brüche $.10^4$ |
|-----|-----|-----|-----|-----|-----|-----|
| D0 | 1101 0000 | D | $\sqrt{D^2}=D=13$ | 12 | 0 | 10000 |
| D1 | 1101 0001 | C | $\sqrt{145}=12.0416$ | 12 | 0 | 0416 |
| D2 | 1101 0010 | B | $\sqrt{125}=11.1803$ | 11 | 1 | 1803 |
| D3 | 1101 0011 | A | $\sqrt{109}=10.4403$ | 10 | 0 | 4403 |
| D4 | 1101 0100 | 9 | $\sqrt{97}=9.8486$ | 9 | 1 | 8486 |
| D5 | 1101 0101 | 8 | $\sqrt{89}=9.4340$ | 9 | 1 | 4340 |
| D6 | 1101 0110 | 7 | $\sqrt{85}=9.2195$ | 9 | 1 | 2195 |
| D7 | 1101 0111 | 6 | $\sqrt{85}=9.2195$ | 9 | 1 | 2195 |
| D8 | 1101 1000 | 5 | $\sqrt{89}=9.4340$ | 9 | 1 | 4340 |
| D9 | 1101 1001 | 4 | $\sqrt{97}=9.8486$ | 9 | 1 | 8486 |
| DA | 1101 1010 | 3 | $\sqrt{109}=10.4403$ | 10 | 0 | 4403 |
| DB | 1101 1011 | 2 | $\sqrt{125}=11.1803$ | 11 | 1 | 1803 |
| DC | 1101 1100 | 1 | $\sqrt{145}=12.0416$ | 12 | 0 | 0416 |
| DD | 1101 1101 | 0 | $\sqrt{D^2}=D=13$ | 12 | 0 | 10000 |
| E0 | 1110 0000 | E | $\sqrt{E^2}=E=14$ | 13 | 1 | 10000 |
| E1 | 1110 0001 | D | $\sqrt{170}=13.0384$ | 13 | 1 | 0384 |
| E2 | 1110 0010 | C | $\sqrt{148}=12.1655$ | 12 | 0 | 1655 |
| E3 | 1110 0011 | B | $\sqrt{130}=11.4018$ | 11 | 1 | 4018 |
| E4 | 1110 0100 | A | $\sqrt{116}=10.7703$ | 10 | 0 | 7703 |
| E5 | 1110 0101 | 9 | $\sqrt{106}=10.2956$ | 10 | 0 | 2956 |
| E6 | 1110 0110 | 8 | $\sqrt{100}=10$ | 9 | 1 | 10000 |
| E7 | 1110 0111 | 7 | $\sqrt{98}=9.8995$ | 9 | 1 | 8995 |
| E8 | 1110 1000 | 6 | $\sqrt{100}=10$ | 9 | 1 | 10000 |
| E9 | 1110 1001 | 5 | $\sqrt{106}=10.2956$ | 10 | 0 | 2956 |
| EA | 1110 1010 | 4 | $\sqrt{116}=10.7703$ | 10 | 0 | 7703 |
| EB | 1110 1011 | 3 | $\sqrt{130}=11.4018$ | 11 | 1 | 4018 |
| EC | 1110 1100 | 2 | $\sqrt{148}=12.1655$ | 12 | 0 | 1655 |
| ED | 1110 1101 | 1 | $\sqrt{170}=13.0384$ | 13 | 1 | 0384 |
| EE | 1110 1110 | 0 | $\sqrt{E^2}=E=14$ | 13 | 1 | 10000 |

18

Tabelle III (Fortsetzung 5):

| HEX | BINAER p+q q | Wirk- energie p (dezimal) | Scheinenergie (dezimal) | | | |
|---|---|---|---|---|---|---|
| | | | $s=\sqrt{(q^2+p^2)}$ | $s_a$ | $s_a$ gerade=0/ ungerade=1 | Dezimal- brüche $.10^4$ |
| F0 | 1111 0000 F | F | $\sqrt{F^2}=F=15$ | 14 | 0 | 10000 |
| F1 | 1111 0001 E | E | $\sqrt{197}=14.0357$ | 14 | 0 | 0357 |
| F2 | 1111 0010 D | D | $\sqrt{173}=13.1529$ | 13 | 1 | 1529 |
| F3 | 1111 0011 C | C | $\sqrt{153}=12.3693$ | 12 | 0 | 3693 |
| F4 | 1111 0100 B | B | $\sqrt{137}=11.7047$ | 11 | 1 | 7047 |
| F5 | 1111 0101 A | A | $\sqrt{125}=11.1803$ | 11 | 1 | 1803 |
| F6 | 1111 0110 9 | 9 | $\sqrt{117}=10.8167$ | 10 | 0 | 8167 |
| F7 | 1111 0111 8 | 8 | $\sqrt{113}=10.6301$ | 10 | 0 | 6301 |
| F8 | 1111 1000 7 | 7 | $\sqrt{113}=10.6301$ | 10 | 0 | 6301 |
| F9 | 1111 1001 6 | 6 | $\sqrt{117}=10.8167$ | 10 | 0 | 8167 |
| FA | 1111 1010 5 | 5 | $\sqrt{125}=11.1803$ | 11 | 1 | 1803 |
| FB | 1111 1011 4 | 4 | $\sqrt{137}=11.7047$ | 11 | 1 | 7047 |
| FC | 1111 1100 3 | 3 | $\sqrt{153}=12.3693$ | 12 | 0 | 3693 |
| FD | 1111 1101 2 | 2 | $\sqrt{173}=13.1529$ | 13 | 1 | 1529 |
| FE | 1111 1110 1 | 1 | $\sqrt{197}=14.0357$ | 14 | 0 | 0357 |
| FF | 1111 1111 0 | 0 | $\sqrt{F^2}=F=15$ | 14 | 0 | 10000 |

Die ganzzahligen Werte der Kolonne $s = \sqrt{(q^2 + p^2)}$ der Tabelle III sind in der nachfolgenden Tabelle IV noch etwas übersichtlicher dargestellt:

Tabelle IV:

```
--------------------------------------------------------------------
                                    q=
              0  1  2  3  4  5  6  7  8  9  10 11 12 13 14 15
--------------------------------------------------------------------
        0     0
        1     1  1
        2     2  1  2
        3     3  2  2  3
        4     4  3  2  3  4
        5     5  4  3  3  4  5
        6     6  5  4  4  4  5  6
        7     7  6  5  5  5  5  6  7
p+q=    8     8  7  6  5  5  5  6  7  8
        9     9  8  7  6  6  6  6  7  8  9
       10    10  9  8  7  7  7  7  7  8  9  10
       11    11 10  9  8  8  7  7  8  8  9  10 11
       12    12 11 10  9  8  8  8  8  8  9  10 11 12
       13    13 12 11 10  9  9  9  9  9  9  10 11 12 13
       14    14 13 12 11 10 10 10  9 10 10  10 11 12 13 14
       15    15 14 13 12 11 11 10 10 10 10  11 11 12 13 14 15
--------------------------------------------------------------------
```

Die Tabelle IV stellt die nicht optimierte Untervariante der vierten Variante dar, in der für alle Werte Y=0 gilt.

Die Kolonne $s_a$ der Tabelle III, die eine optimierte Untervariante der vierten Variante darstellt, ist in der nachfolgenden Tabelle V noch etwas übersichtlicher dargestellt:

Tabelle V:

|  | q=0 | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|---|
| 0 | 0 | | | | | | | | | | | | | | | |
| 1 | 0 | 0 | | | | | | | | | | | | | | |
| 2 | 1 | 1 | 1 | | | | | | | | | | | | | |
| 3 | 2 | 2 | 2 | 2 | | | | | | | | | | | | |
| 4 | 3 | 3 | 2 | 3 | 3 | | | | | | | | | | | |
| 5 | 4 | 4 | 3 | 3 | 4 | 4 | | | | | | | | | | |
| 6 | 5 | 5 | 4 | 4 | 4 | 5 | 5 | | | | | | | | | |
| 7 | 6 | 6 | 5 | 4 | 4 | 5 | 6 | 6 | | | | | | | | |
| p+q= 8 | 7 | 7 | 6 | 5 | 5 | 5 | 6 | 7 | 7 | | | | | | | |
| 9 | 8 | 8 | 7 | 6 | 6 | 6 | 6 | 7 | 8 | 8 | | | | | | |
| 10 | 9 | 9 | 8 | 7 | 7 | 7 | 7 | 7 | 8 | 9 | 9 | | | | | |
| 11 | 10 | 10 | 9 | 8 | 8 | 7 | 7 | 8 | 8 | 9 | 10 | 10 | | | | |
| 12 | 11 | 11 | 10 | 9 | 8 | 8 | 8 | 8 | 8 | 9 | 10 | 11 | 11 | | | |
| 13 | 12 | 12 | 11 | 10 | 9 | 9 | 9 | 9 | 9 | 9 | 10 | 11 | 12 | 12 | | |
| 14 | 13 | 13 | 12 | 11 | 10 | 10 | 9 | 9 | 9 | 10 | 10 | 11 | 12 | 13 | 13 | |
| 15 | 14 | 14 | 13 | 12 | 11 | 11 | 10 | 10 | 10 | 10 | 11 | 11 | 12 | 13 | 14 | 14 |

Wie aus der Tabelle V ersichtlich ist, sind zwei auf der Vertikalen angeordnete benachbarte Werte von $s_a$ entweder gleich oder sie unterscheiden sich nur durch einen Wert Eins voneinander. Dies bedeutet, dass jeder empfangene Impuls des Eingangssignals 1 entweder einen gleichen oder einen um einen Wert Eins inkrementierten Wert von $s_a$ erzeugen muss.

Desgleichen ist aus der Tabelle V ersichtlich, dass zwei auf einer schräg von oben rechts nach unten links verlaufenden Diagonale angeordnete benachbarte Werte von $s_a$ auch entweder gleich sind oder sich nur durch einen Wert Eins voneinander unterscheiden. Dies bedeutet, dass auch jeder empfangene Impuls des Eingangssignals 2 entweder einen gleichen oder einen um einen Wert Eins inkrementierten Wert von $s_a$ erzeugen muss.

Es ist somit ersichtlich, dass jedesmal, wenn ein Impuls des Eingangssignals 1 oder des Eingangssignals 2 die erfindungsgemässe Anordnung erreicht, der Wert von $s_a$ entweder unverändert bleibt oder um einen Wert Eins erhöht werden muss. Anders ausgedrückt: Jeder Eingangsimpuls der erfindungsgemässen Anordnung, gleichgültig, ob es sich um einen Impuls des Eingangssignals 1 oder 2 handelt, muss entweder keinen oder einen einzigen Impuls am Ausgang der erfindungsgemässen Anordnung erzeugen.

Es ist daher nicht nötig, in der Anordnung die Anzahl der bereits abgegebenen Impulse zu speichern, sondern es genügt, in der Anordnung die Tatsache zu speichern, dass die Anzahl der abgegebenen Impulse geradzahlig oder ungeradzahlig war. Es ist daher auch nicht erforderlich, den vollständigen Wert von $s_a$, wie er in den Tabellen III und V aufgelistet ist, mit 4 Bits im Festwertspeicher 14 zu speichern. Es genügt vielmehr, ein einziges Bit von $s_a$ zu speichern, nämlich dass am Ausgang des Festwertspeichers 14 anstehende niederwertigste Bit. Die Werte dieses einzigen Bits entsprechen den in der siebten Kolonne der Tabelle III dargestellten Werten. Im Festwertspeicher 14, in dem die den ganzzahligen Werten von A.s entsprechenden Zahlenwerte gespeichert sind, ist somit in einer weiteren vorteilhaften Untervariante der vierten Variante von die-

21

sen Zahlenwerten jeweils nur mindestens das niederwertigste Bit gespeichert. In der in der Fig. 5 dargestellten Anordnung der vierten Variante gilt nachfolgend die Annahme, dass nur jeweils dieses niederwertigste Bit ausgewertet wird.

Jedesmal, wenn die Summe der Anzahl Impulse der beiden Eingangssignale 1 und 2 den Wert R=10 erreicht und nur dann, erscheint ein negativgehender Impuls am Freigabeausgang 10A des Mittels 10. Die Zeitpunkte, an denen jeweils der Wert R=10 erreicht wird, entsprechen den Auswerteaugenblicken, in denen jeweils die den ganzzahlwertigen Multiplen der Dualbrüche von A.s entsprechenden Zahlenwerte ausgewertet werden. In diesen Auswerteaugenblicken sperrt der negativgehende Impuls am Freigabeausgang 10A des Mittels 10 (siehe Fig. 5) über den Inverter 16 den Festwertspeicher 14, der bis jetzt in Betrieb war, und gibt den bis jetzt gesperrten Festwertspeicher 6a frei. Der Wert des zum gerade im Impulszähler 4 anstehenden Wert von q gehörenden Dualbruchs des gegebenenfalls um $Y/2^K$ verkleinerten Wertes von A.s erscheint am Datenausgang D7 bis D0 des Festwertspeichers 6a und wird zur weiteren Auswertung auf den Addierer 8 gegeben. Es wird somit nur in dem Augenblick, an dem ein Wert R=10 erreicht wird, ein dem Dualbruch von A.s entsprechender Zahlenwert ausgewertet und mit Hilfe des Addierers 8 zum alten Summenwert addiert, der in der Einrichtung 7 zum Speichern von Zwischenresultaten gespeichert ist. Alle die andern, den Dualbrüchen von A.s entsprechenden Zahlenwerte werden dagegen bei der Auswertung nicht berücksichtigt. Der negative Impuls am Freigabeausgang 10A des Mittels 10 lädt mit seiner steigenden Flanke das neue Resultat der durch den Addierer 8 verwirklichten Addition in die Einrichtung 7 zum Speichern von Zwischenresultaten. Nach Beendigung dieses Impulses sperrt das Signal am Freigabeausgang 10A des Mittels 10 wieder den Festwertspeicher 6a und gibt über den Inverter 16 wieder den Festwertspeicher 14 frei, wodurch die den ganzzahligen Werten von A.s entsprechenden Zahlenwerte bzw. deren niederwertigstes Bit am Datenausgang D7 bis D0 bzw. D0 des Festwertspeichers 14 erscheinen. Erst in dem Augenblick, an dem wieder ein Wert R=10 erreicht wird, beginnt im Festwertspeicher 6a eine neue Auswertung der den Dualbrüchen von A.s entsprechenden Zahlenwerte. Die am Datenausgang D7 bis D0 bzw. D0 des Festwertspeichers 14 erscheinenden, den ganzzahligen Werten von A.s entsprechenden Werte werden direkt der Ausgangsschaltung 9 zugeführt und dort ausgewertet. Die den in den Augenblicken, an denen der Wert R=10 erreicht wird, geltenden Dualbrüche von A.s entsprechenden Zahlenwerte werden dagegen mit Hilfe des Addierers 8 kumuliert. Wenn das Resultat dieser Kumulation den Addierer 8 zum Überlaufen bringt, erscheint ein Logikwert Eins an dessen Übertragsausgang CO. Das an diesem Übertragausgang CO anstehende Übertragsignal wird anschliessend in der nachgeschalteten Ausgangsschaltung 9 ausgewertet, die in der vierten Variante immer vorhanden ist und dann immer den in der Fig. 16 dargestellten Aufbau besitzt.

Die fünfte bis achte Variante der erfindungsgemässen Anordnung (siehe Fig. 6 bis Fig. 9) unterscheiden sich hauptsächlich von den vier ersten Varianten dadurch, dass jeweils das Mittel 10 zur Freigabe der Auswertung ersetzt ist durch die Kombination 17;18 der Umschalteinrichtung 17 und des Festwertspeichers 18, wobei der Festwertspeicher 18 die Funktion des Mittels 10a zur Auslösung des Freigabesignals übernimmt. Ausserdem besitzen die Adressen aller Festwertspeicher 6a, 14 und 18 - falls vorhanden - mindestens genausoviele Bits, wie die beiden Impulszähler 4 und 22 zusammen Bits aufweisen. Wenn die beiden Impulszähler 4 und 22 je 4 Bits besitzen, so weisen die Adressen aller vorhandenen Festwertspeicher somit mindestens 8 Bits auf. Der Parallelausgang des Impulszählers 4 ist dabei jeweils auf die vier aufeinanderfolgenden niederwertigsten Adresseneingänge A0 bis A3 aller vorhandenen Festwertspeicher geführt, während der Parallelausgang des Impulszählers 22, der gleichzeitig der Parallelausgang 17K der Umschalteinrichtung 17 ist (siehe Fig. 12), mit den vier aufeinanderfolgenden höherwertigen Adresseneingängen A4 bis A7 der acht Adresseneingänge A0 bis A7 dieser Festwertspeicher derart verbunden ist, dass die N=8 niederwertigsten Bits der Adressen der Festwertspeicher gleich den in der angegebenen Reihenfolge aneinandergereihten Werten von p und q, die je in einem der beiden Impulszähler 4 und 22 gespeichert sind. In der fünften bis achten Variante gehört somit zu jedem Ausgangswert der beiden Impulszähler 4 und 22 je ein Teil der Adresse aller vorhandenen Festwertspeicher. Ansonsten entspricht die fünfte Variante der ersten Variante, die sechste Variante der zweiten Variante, die siebte Variante der dritten Variante und die achte Variante der vierten Variante, wobei zwei entsprechende Varianten ähnlich funktionieren und wobei in den Festwertspeichern 6a und 14 zweier zusammengehöriger Varianten, sofern vorhanden, jeweils gleiche Zahlenwerte abgespeichert sind.

Wenn die Summe der Anzahl Impulse der beiden Eingangssignale 1 und 2 gleich dem bestimmten vorgegebenen Wert R=10 ist, entspricht dies in der fünften bis achten Variante jeweils ganz bestimmten Adressen der Festwertspeicher 6a, 14 und 18, sofern diese vorhanden sind. Die N=8 niederwertigsten Bits, der an diesen Festwertspeichern anstehenden Adressen, werden in den genannten Varianten im Festwertspeicher 18 decodiert. Beim Vorhandensein des Wertes R=10 erscheint z. B. am höchstwertigen Datenausgang D11 (in der fünften bis siebten Variante) bzw. D7 (in der achten Variante) ein Logikwert Eins. An diesem höchstwertigen Datenausgang D11 bzw. D7 des Festwertspeichers 18 ist somit jeweils ein Logikwert Eins vorhanden bei jeder Adresse des Festwertspeichers 6a (in der fünften und sechsten Variante) bzw. der Festwertspeicher 6a und 14 (in der siebten und achten Variante), die solchen Werten der Anzahl Impulse der beiden Eingangssignale 1 und 2 entspricht, deren Summe gleich dem bestimmten vorgegebenen Wert R ist. Dieser Logikwert Eins dient dann dazu in jeder der genannten Variante, in der Umschalteinrichtung 17 (siehe Fig. 12) mit Hilfe des D-Flipflops 25 den am Freigabeausgang 17F normalerweise anstehenden Logikwert von einem Logikwert Eins auf einen Logikwert Null umzuschalten. Für alle andern Adressen dieser Festwertspeicher weist dagegen dieser Freigabeausgang 17F unveränderlich einen Logikwert Eins auf.

In der fünften und achten Variante (siehe Fig. 6 und Fig. 9) gibt das Ausgangssignal des Freigabeausgangs 17F der Umschalteinrichtung 17 über den Freigabeeingang "$\overline{CE}$" den Festwertspeicher 6a und in der sechsten und siebten Variante (siehe Fig. 7 und Fig. 8) das Zwischenregister 13 frei.

Der aus den acht niederwertigsten Bits aufgebaute Teil der Adresse des Festwertspeichers 6a besteht in der angegebenen Reihenfolge aus den aneinandergereihten 4bit-Binärwerten von p, die im Impulszähler 22 gespeichert sind, und von q, die ihrerseits im Impulszähler 4 gespeichert sind.

Normalerweise besitzt das am Ausgang des Festwertspeichers 18 anstehende höchstwertige Bit D11 bzw. D7 einen Logikwert Null und damit der Ausgang des Inverters 26 (siehe Fig. 12) einen Logikwert Eins, der das Nand-Gatter 23 für die Impulse des Signals t4 freigibt. Jeder Impuls des Signals t4 stellt dann über das Nand-Gatter 23 und den Rückstellausgang 17H der Umschalteinrichtung 17 den Taktzähler 3b im Taktverteiler 3 (siehe Fig. 1) auf Null zurück, so dass der Taktzähler 3b nie höher als bis zur zum Signal t4 gehörenden laufenden Nummer zählen kann. Dies verhindert die Erzeugung der zu den Signalen t5 bis t9 gehörenden Impulse, die somit alle in der Regel unterdrückt sind. Es werden dann in der achten Variante die ganzzahligen Werte von A.s bzw. deren niederwertigste Bits am Datenausgang D7 bis D0 bzw. D0 des Festwertspeichers 14 erscheinen und in der nachgeschalteten Ausgangsschaltung 9 ausgewertet.

Jedesmal jedoch, wenn die Summe der Anzahl Impulse der beiden Eingangssignale 1 und 2 den Wert R=10 erreicht und nur dann, erscheint ein Logikwert Eins als höchstwertiges Bit am Datenausgang D11 bzw. D7 des Festwertspeichers 18 und somit ein Logikwert Null am Ausgang des Inverters 26 (siehe Fig. 12). Die Zeitpunkte, an denen jeweils der Wert R=10 erreicht wird, entsprechen den Auswerteaugenblicken, in denen jeweils in der fünften bis siebten Variante die im Festwertspeicher 6a (siehe Fig. 6 und Fig. 7) oder die in den Festwertspeichern 6a und 14 (siehe Fig. 8) abgespeicherten Werte von A.g$_s$ bzw. in der achten Variante die im Festwertspeicher 6a (siehe Fig. 9) abgespeicherten den ganzzahlwertigen Multiple der Dualbrüche von A.s entsprechenden Zahlenwerte ausgewertet werden. Der Logikwert Null am Ausgang des Inverters 26 sperrt daher zu diesem Zweck das Nand-Gatter 23, so dass die Impulse des Signals t4 den Taktzähler 3c nicht mehr über den Rückstellausgang 17H der Umschalteinrichtung 17 auf Null zurückstellen können und dieser somit diesmal alle laufenden Nummern zählen kann. Dadurch werden auch die Impulse der Signale t5 bis t9 erzeugt. Der erste dann erscheinende Impuls des Signals t5 setzt über den Inverter 27 das D-Flipflop 25, wodurch ein Logikwert Null am Freigabeausgang 17F der Umschalteinrichtung 17 erscheint. Dadurch wird der zu den gerade anstehenden niederwertigsten acht Bits der Adresse der Festwertspeicher gehörende Wert von A.g$_s$ (in der fünften bis siebten Variante) bzw. Wert des dem ganzzahlwertigen Multiple des Dualbruches von A.s entsprechenden Zahlenwertes am Datenausgang D11/D7 bis D0 des Festwertspeichers 6a erzeugt und zur weiteren Auswertung auf den Addierer 8 gegeben. Diese Werte werden somit nur in dem Augenblick, an dem ein Wert R=10 erreicht wird, ausgewertet und mit Hilfe des Addierers 8 zum alten Summenwert addiert, der in der Einrichtung 7 zum Speichern von Zwischenresultaten gespeichert ist. Alle die andern Zahlenwerte von A.g$_s$ in der fünften bis siebten Variante sowie alle die andern den Dualbrüchen von A.s in der achten Variante entsprechenden Zahlenwerte werden dagegen bei der Auswertung nicht berücksichtigt. Der dem ersten Impuls des Signals t5 nachfolgende erste Impuls des Signals t7 lädt in der fünften bis achten Variante über den Freigabeausgang 17G mit seiner steigenden Flanke das neue Resultat der durch den Addierer 8 verwirklichten Addition in die Einrichtung 7 zum Speichern von Zwischenresultaten und stellt anschliessend mit seiner fallenden Flanke über den Inverter 24 das D-Flipflop 25 auf Null zurück. Dadurch erscheint wieder ein Logikwert Eins am Freigabeausgang 17F der Umschalteinrichtung 17, wodurch in der achten Variante wieder nur die    den ganzzahligen Werten von A.s entsprechenden Zahlenwerte bzw. deren niederwertigste Bits am Datenausgang D11/D7 bis D0 bzw. D0 des Festwertspeichers 14 erzeugt werden. Erst in dem Augenblick, an dem wieder ein Wert R=10 erreicht wird, beginnt eine neue Auswertung und zwar in der fünften bis siebten Variante der Zah-lenwerte von A.g$_s$ und in der achten Variante der den Dualbrüchen von A.s entsprechenden Zahlenwerte. Die in der achten Variante am Datenausgang D11/D7 bis D0 bzw. D0 des Festwertspeichers 14 erscheinenden, den ganzzahligen Werten von A.s entsprechenden Werte werden zwar auch dem Addierer 8 zugeführt und zu den bisherigen Werten addiert. Das Resultat dieser Addition wird jedoch nie in der Einrichtung 7 zum Speichern von Zwischenresultaten abgelegt, da in diesen Fällen die Impulse des Signals t7 unterdrückt sind und nicht am Takteingang der Einrichtung 7 erscheinen können. Die den ganzzahligen Werten von A.s entsprechenden Zahlenwerte bzw. deren niederwertigstes Bit werden in der achten Variante direkt der Ausgangsschaltung 9 zugeführt, die dann immer vorhanden ist, und dort ausgewertet.

Die in der achten Variante den, in den Augenblicken, an denen der Wert R=10 erreicht wird, geltenden Dualbrüche von A.s entsprechenden Zahlenwerte werden dagegen immer mit Hilfe des Addierers 8 kumuliert. Wenn in der fünften bis achten Variante das Resultat der Kumulation den Addierer 8 zum Überlaufen bringt, erscheint ein Logikwert Eins an dessen Übertragausgang CO. Das an diesem Übertragausgang CO anstehende Übertragsignal wird in der fünften bis siebten Variante fakultativ über die dann der Aufbereitung dienende Ausgangsschaltung 9 und in der achten Variante immer über die dann der Auswertung dienende Ausgangsschaltung 9 dem Ausgang der erfindungsgemässen Anordnung zugeführt.

Die vorhandenen getrennten Festwertspeicher 6a und 14 bzw. 6a und 18 bzw. 6a, 14 und 18 können natürlich auch alle oder teilweise zusammen einen einzigen Festwertspeicher 6a;14 bzw. 6a;18 bzw. 6a;14;18 bilden, der dann zwei oder drei Speicherteile und mindestens ein Adressenbit mehr aufweist als die einzelnen Festwertspeicher 6a, 14 und 18, die ihn bilden.

Ein zweiteiliger Festwertspeicher 6a;14 bzw. 6a;18 kann die Festwertspeicher 6a und 14 der dritten und vierten Variante (siehe Fig. 4 und Fig. 5) oder 6a und 18 der fünften und sechsten Variante (siehe Fig. 6 und Fig. 7) ersetzen.

In der Fig. 13 ist ein zweiteiliger Festwertspeicher 6a;14 dargestellt, der z. B. in der vierten Variante (siehe Fig. 5) verwendet werden kann. Die Adresse dieses zweiteiligen Festwertspeichers 6a;14 besitzt ein Bit mehr als die Adresse der in der Fig. 5 dargestellten Festwertspeicher 6a und 14, nämlich total 5 Bits. Der Teil des zweiteiligen Festwertspeichers 6a;14, der dem Festwertspeicher 6a entspricht, besitzt z. B. eine Adresse, deren höchstwertiges Bit einen Logikwert "0" aufweist, während der Teil, der dem Festwertspeicher 14 entspricht, z. B. eine Adresse aufweist, deren höchstwertiges Bit einen Logikwert "1" besitzt. Der höchstwertige Biteingang A4 dieser Adresse übernimmt dann die Rolle des Freigabeeingangs "CE" der Festwertspeicher 6a und 14, so dass in der Fig. 5 der Freigabeausgang 10A des Mittels 10 mit dem höchstwertigen Biteingang A4 der Adresse des zweiteiligen Festwertspeichers 6a;14 zu verbinden ist und der Inverter 16 eingespart werden kann, während die vier niederwertigsten Biteingänge A0 bis A3 der Adresse des zweiteiligen Festwertspeichers 6a;14 mit dem Parallelausgang des Impulszählers 4 verbunden bleiben.

Ein dreiteiliger Festwertspeicher 6a;14;18 kann die Festwertspeicher 6a, 14 und 18 der siebten und achten Variante (siehe Fig. 8 und Fig. 9) ersetzen.

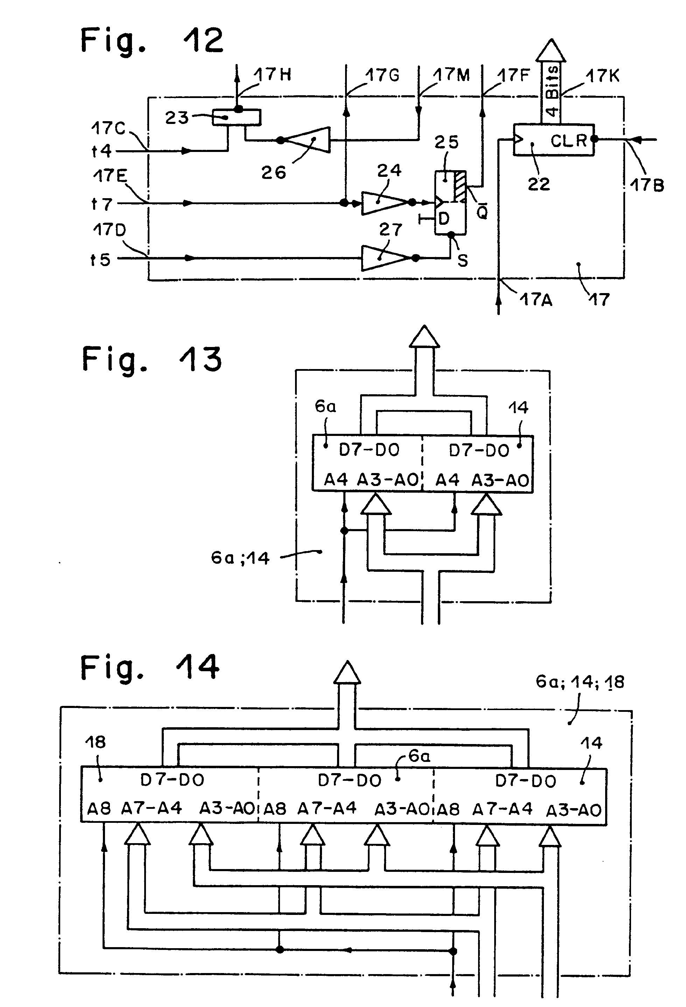

In der Fig. 14 ist ein dreiteiliger Festwertspeicher 6a;14;18 dargestellt, der z. B. in der achten Variante (siehe Fig. 9) verwendet werden kann. Die Adresse dieses dreiteiligen Festwertspeichers 6a;14;18 besitzt ein Bit mehr als die Adresse der in der Fig. 9 dargestellten Festwertspeicher 6a, 14 und 18, nämlich total 9 Bits. Der Teil des dreiteiligen Festwertspeichers 6a;14;18, der dem Festwertspeicher 6a entspricht, besitzt z. B. eine Adresse, deren höchstwertiges Bit einen Logikwert "0" aufweist, während der Teil, der dem Festwertspeicher 14 entspricht, z. B. eine Adresse aufweist, deren höchstwertiges Bit einen Logikwert "1" besitzt. Der höchstwertige Biteingang A8 dieser Adresse übernimmt dann die Rolle des Freigabeeingangs "CE" der Festwertspeicher 6a und 14, so dass in der Fig. 9 der Freigabeausgang 17F der Umschalteinrichtung 17 mit dem höchstwertigen Biteingang A8 der Adresse des dreiteiligen Festwertspeichers 6a;14;18 zu verbinden ist und der Inverter 16 eingespart werden kann, während die acht niederwertigsten Biteingänge A0 bis A7 der Adresse des dreiteiligen Festwertspeichers 6a;14;18 mit dem Parallelausgang des Impulszählers 4 und dem Parallelausgang 17K der Umschalteinrichtung 17 verbunden bleiben.

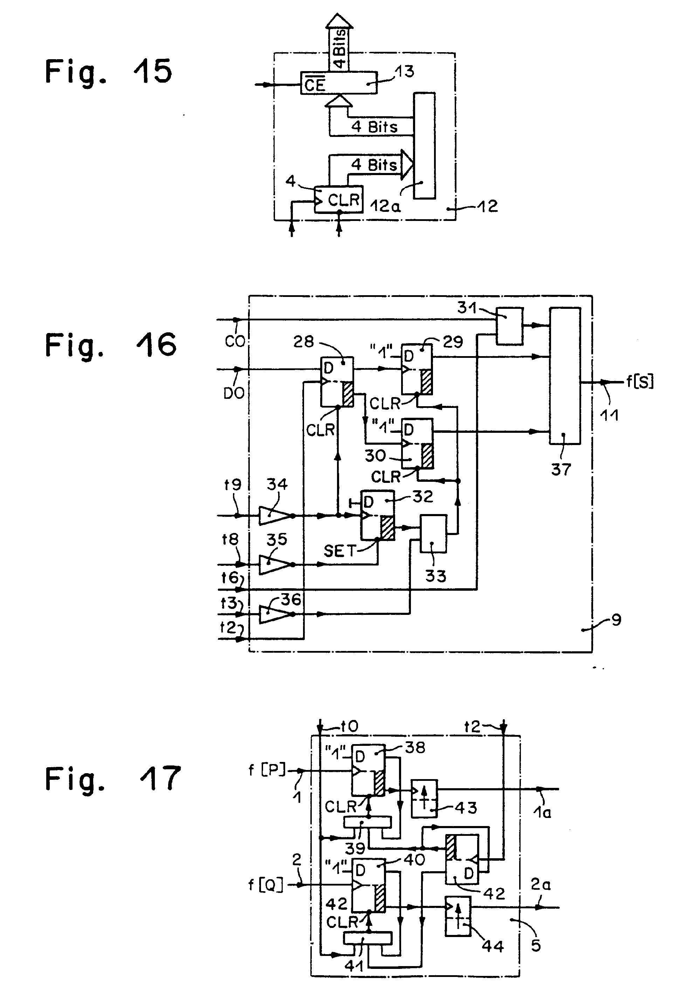

In der zweiten, dritten, sechsten und siebten Variante kann die in der Fig. 3, Fig.4, Fig. 7 und Fig. 8 dargestellte Zähl- und Speichereinrichtung 12 durch diejenige ersetzt werden, die in der Fig. 15 dargestellt ist, wodurch zusätzliche Untervarianten dieser Varianten entstehen.

Die in der Fig. 15 dargestellte Zähl- und Speichereinrichtung 12 besteht aus dem Impulszähler 4, dem Zwischenregister 13 und einem Mikrocomputer 12a. Dabei ist der Parallelausgang des Impulszählers 4 über den Mikrocomputer 12a mit dem Dateneingang des Zwischenregisters 13 verbunden, d. h. der Parallelausgang des Impulszählers 4 ist auf einen Dateneingang des Mikrocomputers 12a geführt und ein Datenausgang des letzteren ist mit dem Dateneingang des Zwischenregisters 13 verbunden. Der Mikrocomputer 12a dient dabei der Ermittlung über eine bestimmte vorgegebene Zeit eines Mittelwertes der am Parallelausgang des Impulszählers 4 anstehenden Werte, d. h. der Werte von q, und der anschliessenden Zuleitung dieses Mittelwertes zum Dateneingang des Zwischenregisters 13. Durch diese Mittelwertbildung wird ein Messfehler verringert, der dadurch entsteht, dass die Impulse der beiden Eingangssignale 1 und 2 unregelmässige zeitliche Abstände besitzen können, obwohl die Scheinleistung während dieser Zeitintervalle an sich konstant ist.

In der ersten bis dritten Variante sowie in der fünften bis siebten Variante bildet der Übertragsausgang CO des Addierers 8 entweder unmittelbar den Ausgang der erfindungsgemässen Anordnung oder er ist wie in den zugehörigen Figuren dargestellt über die Ausgangsschaltung 9 mit diesem Ausgang verbunden. In der vierten und achten Variante ist der Übertragsausgang CO des Addierers 8 immer über eine Ausgangsschaltungs 9 auf den Ausgang der erfindungsgemässen Anordnung geführt. Die Ausgangsschaltung 9 besitzt dann vorzugsweise den in der Fig. 16 dargestellten Aufbau.

Die in der Fig. 16 dargestellte Ausgangsschaltung 9 besteht aus einem D-Flipflop 28, einem D-Flipflop 29, einem D-Flipflop 30, einem Und-Gatter 31, einem D-Flipflop 32, einem Und-Gatter 33, einem Inverter 34, einem Inverter 35, einem Inverter 36 und einem Oder-Gatter 37.

Das vom Übertragsausgang CO des Addierers 8 kommende Übertragssignal wird einem ersten Eingang und das Signal t6 einem zweiten Eingang jeweils des Und-Gatters 31 zugeführt, dessen Ausgang mit einem ersten Eingang des Oder-Gatters 37 verbunden ist. Das Signal am Datenausgang D0 des Festwertspeichers 14 ist auf einen D-Eingang und das Signal t2 auf einen Takteingang jeweils des D-Flipflops 28 geführt, dessen beide Ausgänge jeweils mit einem Takteingang des D-Flipflops 29 bzw. 30 verbunden sind. Die D-Eingänge der beiden D-Flipflops 29 und 30 liegen jeweils an einem Logikwert "1", während ihre "Q"-Ausgänge jeweils mit einem zweiten bzw. dritten Eingang des Oder-Gatters 37 verbunden sind, dessen Ausgang seinerseits den Ausgang der Ausgangsschaltung 9 bildet. Das Signal t9 ist über den Inverter 34 auf einen Rückstelleingang CLR des D-Flipflops 28 und auf einen Takteingang des D-Flipflops 32 geführt, dessen D-Eingang an Masse liegt. Der invertierende Ausgang des D-Flipflops 32 ist auf einen ersten Eingang und das Signal t3 über den Inverter 36 auf einen zweiten Eingang jeweils des Und-Gatters 33 geführt, dessen Ausgang seinerseits mit den Rückstelleingängen CLR der beiden D-Flipflops 29 und 30 verbunden ist. Das Signal t8 ist über den Inverter 35 auf einen Setzeingang SET des D-Flipflops 32 geführt.

Im D-Flipflop 28 wird die Information gespeichert, ob in der laufenden Periode bisher eine geradzahlige oder eine ungeradzahlige Anzahl Impulse erzeugt wurde. Zu Beginn dieser Periode sind alle D-Flipflops 28, 29, 30 und 32 auf Null zurückgestellt. Da bisher noch kein Impuls, d. h. eine geradzahlige Anzahl Impulse, erzeugt wurde, ist im D-Flipflop 28 zu Beginn der laufenden Periode korrekterweise ein Logikwert Null gespeichert. Jeder Impuls des Signals t2 lädt nun mit seiner steigenden Flanke den Wert des niederwertigsten, am Datenausgang D0 des Festwertspeichers 14 anstehenden Bits in das D-Flipflop 28. Wird der Inhalt des D-Flipflops 28 dadurch nur bestätigt, dann entsteht keine Flanke an seinen Ausgängen und es wird kein Impuls am Ausgang der Ausgangsschaltung 9 erzeugt. Wird durch das Laden des niederwertigsten Bits dagegen der Inhalt des D-Flipflops 28 geändert, dann erscheint an einem seiner beiden Ausgänge eine steigende Flanke, die das nachgeschaltete D-Flipflop 29 oder 30 mit einem Logikwert Eins lädt, der über das Oder-Gatter 37 den Ausgang der Ausgangsschaltung 9 erreicht. Der zeitlich nachfolgende Impuls des Signals t3 stellt über das durch einen Ausgang des D-Flipflops 32 freigegebene Und-Gatter 33 das D-Flipflop 29 bzw. 30 anschliessend auf Null zurück, wodurch der Logikwert Eins am Ausgang der Ausgangsschaltung 9 beendet wird. Es ist somit an diesem Ausgang ein Impuls erzeugt worden. Die Impulse der Signale t6, t8 und t9 sind, wie bereits erwähnt, während dieser Betriebsphase unterdrückt. Wird jetzt am Ende der laufenden Periode im Auswerteaugenblick der Wert R=10 erreicht, dann wird, wie bereits anlässlich der Funktionsbeschreibung der Fig. 4 erläutert, die Erzeugung der Impulse der Signale t6, t8 und t9 freigegeben. Im Auswerteaugenblick wird nicht nur, wie bereits beschrieben, das niederwertigste Bit ausgewertet, sondern anschliessend auch noch der dem nichtganzzahligen Restwert des Produktes A.s entsprechende Zahlenwert ausgewertet mit Hilfe des Impulses des Signals t6, welcher das Und-Gatter 31 freigibt. Ist das Übertragsignal des Addierers 8 in diesem Augenblick gleich einem Logikwert Eins, dann erreicht dieser Logikwert Eins während der Impulszeit des Impulses des Signals t6 über das Und-Gatter 31 und das Oder-Gatter 37 den Ausgang der Ausgangsschaltung 9 und erzeugt somit dort einen Impuls. Der nachfolgende Impuls des Signals t8 setzt dann das D-Flipflop 32, wodurch das Und-Gatter 33 kurzzeitig gesperrt wird und dadurch die D-Flipflops 29 und 30 auf Null zurückgestellt werden. Der nachfolgende Impuls des Signals t9 stellt seinerseits das D-Flipflop 28 auf Null zurück und setzt mit seiner fallenden Flanke wieder das D-Flipflop 32 auf Null. Sämtliche D-Flipflops 28, 29, 30 und 32 befinden sich somit nun am Anfang der jetzt beginnenden neuen Periode wieder in der Ausgangslage, so dass der beschriebene Zyklus erneut beginnen kann.

Der in der Fig. 17 dargestellte Synchronisierer 5 besteht aus einem D-Flipflop 38, einem Nand-Gatter 39, einem D-Flipflop 40, einem Nand-Gatter 41, einem D-Flipflop 42, einem monostabilen Multivibrator 43 und einem monostabilen Multivibrator 44.

Die Eingangssignale 1 und 2 der erfindungsgemässen Anordnung sind jeweils auf einen Takteingang des D-Flipflops 38 bzw. 40 geführt, deren D-Eingänge jeweils an einem Logikwert "1" liegen. Das Signal t0 speist je einen ersten Eingang der beiden Nand-Gatter 39 und 41, während das Signal t2 auf einen Takteingang des D-Flipflops 42 geführt ist. Der "Q"-Ausgang des D-Flipflops 38 ist mit einem zweiten Eingang des Nand-Gatters 39 und derjenige des D-Flipflops 40 mit einem zweiten Eingang des Nand-Gatters 41 verbunden. Der invertierende Q-Ausgang des D-Flipflops 38 ist auf einen Eingang des monostabilen Multivibrators 43 und derjenige des D-Flipflops 40 auf einen Eingang des monostabilen Multivibrators 44 geführt. Die beiden Ausgänge des D-Flipflops 42 sind mit je einem dritten Eingang des Nand-Gatters 39 bzw. 41 verbunden, während sein invertierender Ausgang noch zusätzlich auf seinen eigenen D-Eingang geführt ist. Der Ausgang des Nand-Gatters 39 ist mit einem Rückstelleingang CLR des D-Flipflops 38 und derjenige des Nand-Gatters 41 mit einem Rückstelleingang CLR des D-Flipflops 40 verbunden. Die Q-Ausgänge der beiden monostabilen Multivibratoren 43 und 44 bilden die beiden Ausgänge des Synchronisierers 5. Am ersten dieser beiden Ausgänge des Synchronisierers 5 steht das synchronisierte Signal 1a und am zweiten dieser Ausgänge das synchronisierte Signal 2a an.

Die Impulse der Eingangssignale 1 und 2 dürfen nicht sofort den Impulszählern 4 und 22 (siehe Fig. 2 bis Fig. 9 in Kombination mit der Fig. 11 oder der Fig. 12) zugeführt werden. Ist der Inhalt des Impulszählers 22 nämlich z. B. in einer der drei ersten Varianten gleich 14 und erscheint gleichzeitig je ein Impuls der beiden Eingangssignale 1 und 2 an den Signaleingängen der erfindungsgemässen Anordnung, dann müsste der Inhalt des Impulszählers 4 gleich 16 werden, was nicht möglich ist, da der Impulszähler 4 bereits bei einem Inhalt von 15 zurückgestellt wird. Ein Impuls ginge demnach verloren und würde nicht gezählt. Um dies zu vermeiden, müssen die Impulse des Eingangssignals 1 im D-Flipflop 38 und diejenigen des Eingangssignals 2 im D-Flipflop 40 zwischengespeichert werden. Ausserdem muss verhindert werden, dass je ein Impuls der beiden Eingangssignale 1 und 2 gleichzeitig am Takteingang des Impulszählers 22 erscheint, da dieser nur zeitlich aufeinanderfolgende Impulse zählen kann. Um dies zu erreichen, gibt der Synchronisierer 5 den Zählvorgang für die Impulse der beiden Eingangssignale 1 und 2 nur abwechselnd mit Hilfe des D-Flipflops 42 frei. Gleichzeitig mit der Freigabe des Zählvorganges des betreffenden Impulses muss natürlich auch die zugehörige Zwischenspeicherung dieses Impulses gelöscht werden.

Mittels des Signals t2 wird das D-Flipflop 42 periodisch umgeschaltet, so dass es mit Hilfe des dritten Eingangs der beiden Nand-Gatter 39 und 41 periodisch abwechselnd die Rückstellung eines der beiden D-Flipflops 38 oder 40 freigibt.

Normalerweise ist in jedem der beiden D-Flipflops 38 und 40 ein Logikwert Null gespeichert, der jeweils über den zweiten Eingang die Nand-Gatter 39 und 41 und damit auch die Rückstellung der beiden D-Flipflops 38 und 40 sperrt. Die beiden letzten sind somit voll empfangsbereit. Jeder Impuls des Eingangssignals 1 wird daher im D-Flipflop 38 und jeder Impuls des Eingangssignals 2 im D-Flipflop 40 zwischengespeichert. Der dadurch am Ausgang des betreffenden D-Flipflops 38 bzw. 40 erscheinende Logikwert Eins gibt den zweiten Eingang des zugehörigen Nand-Gatters 39 bzw. 41 frei. Da jedoch nur der dritte Eingang eines der beiden Nand-Gatter 39 bzw. 41 durch das D-Flipflop 42 freigegeben ist, kann nur das zu diesem Gatter 39 bzw. 41 gehörende D-Flipflop 38 oder 40 durch den nächsten Impuls des Signals t0 auf Null zurückgestellt werden. Sobald ein Impuls des Signals 1 bzw. 2 am Takteingang des zugehörigen D-Flipflops 38 bzw. 40 erscheint, wird somit ein Logikwert Eins in dieses D-Flipflop 38 bzw. 40 eingelesen, wodurch ein Impuls am Q-Ausgang des zugehörigen D-Flipflops 38 bzw. 40 gestartet wird. Der nächste Impuls des Signals t0 stellt dann anschliessend das Ausgangssignal des durch das D-Flipflop 42 freigegebenen D-Flipflops 38 bzw. 40 wieder auf Null zurück, wodurch der laufende Impuls am Q-Ausgang des betreffenden D-Flipflops 38 bzw. 40 beendet wird. Das rückgestellte D-Flipflop 38 bzw. 40 ist dann wieder erneut für weitere Impulse empfangsbereit, während die steigende Flanke am invertierenden Q-Ausgang des betreffenden D-Flipflops 38 bzw. 40 mit Hilfe des nachgeschalteten monostabilen Multivibrators 43 bzw. 44 einen kurzen Impuls auslöst, der gleichzeitig ein Ausgangsimpuls des Synchronisierers 5 ist. Jeder Impuls der beiden Eingangssignale 1 und 2 wird dabei durch den Synchronisierer 5, auch wenn zwei Impulse eingangsseitig gleichzeitig eintreffen, jeweils zu unterschiedlichen Zeitpunkten an einem seiner beiden Ausgänge weitergegeben. Die Ausgangsimpulse des Synchronisierers 5 werden dann anschliessend mindestens von einem der beiden dem Synchronisierer 5 nachgeschalteten Impulszähler 4 bzw. 22 gezählt (siehe Fig. 2 bis Fig. 9 in Kombination mit der Fig. 11 oder der Fig. 12).

In den vier ersten Varianten der erfindungsgemässen Anordnung kann auch das in der Fig. 18 dargestellte Mittel 10 zur Freigabe der Auswertung verwendet werden. Dieses in der Fig. 18 dargestellte Mittel 10 ist ähnlich aufgebaut wie das in der Fig. 11 dargestellte Mittel 10 mit folgenden Unterschieden:

- Das Oder-Gatter 10c und der Inverter 10f existieren nicht mehr, dafür sind ein Decoder 10g und ein Und-Gatter 10h vorhanden.
- Der Parallelausgang des ausserhalb des Mittels 10 angeordneten Impulszählers 4 (siehe Fig. 2 bis Fig. 5) ist über einen Paralleleingang 10M des Mittels 10 mit einem Paralleleingang des Decoders 10g verbunden, der gleich aufgebaut ist wie das Mittel 10a zur Auslösung des Freigabesignals, welches wie bereits erwähnt auch ein Decoder ist.
- Der Ausgang des Mittels 10a ist auf einen ersten Eingang und der Ausgang des Decoders 10g auf einen zweiten Eingang des Und-Gatters 10h geführt, dessen Ausgang den Freigabeausgang 10A des Mittels 10 bildet.
- Der Eingang 10G des Mittels 10, der, wie bereits erwähnt, vom Eingangssignal 1 gespeist ist, ist unmittelbar mit dem Takteingang des Impulszählers 22 und über den Inverter 10d mit den Freigabeausgängen 10D und 10F des Mittels 10 verbunden.

Bei Verwendung des gemäss Fig. 18 aufgebauten Mittels 10 zählt der Impulszähler 22 binär die Anzahl p Impulse des ersten Eingangssignals 1 der Anordnung, während der Impulszähler 4 wie bisher die Anzahl q Impulse des zweiten Eingangssignals 2 der Anordnung binär zählt. Beide Binärwerte p und q werden getrennt im Mittel 10a bzw. Decoder 10g decodiert. Derjenige von beiden Binärwerten p oder q, der als erster den vorgegebenen Wert R erreicht, erzeugt am invertierenden Ausgang des Mittels 10a bzw. des Decoders 10g einen Logikwert Null, der am Ausgang des Und-Gatters 10h und damit auch am Freigabeausgang 10A des Mittels 10, der normalerweise einen Logikwert Eins aufweist, ebenfalls einen Logikwert Null erzeugt, der seinerseits die Auswertung der Anordnung auf die bereits beschriebene Weise freigibt.

Auch in den vier letzten Varianten der erfindungsgemässen Anordnung kann der Festwertspeicher 18 so programmiert werden, dass er nicht, wie bisher angenommen, den Wert der Summe p+q der Anzahl Impulse der beiden Eingangssignale 1 und 2 der Anordnung decodiert, sondern dass er getrennt die Werte p und q der Anzahl Impulse der beiden Eingangssignale 1 und 2 der Anordnung decodiert und dass derjenige der beiden decodierten Werte p oder q, der als erster den Wert R erreicht, einen Logikwert Null am höchstwertigen (MSB) Datenausgang D7 bzw. D11 des Festwertspeichers 18 erzeugt, um die Auswertung der Anordnung auszulösen.

In allen acht Varianten der erfindungsgemässen Anordnung ist somit ein Mittel 10 bzw. 17;18 vorhanden zur Freigabe mindestens der Auswertung der im Festwertspeicher 6a gespeicherten Zahlenwerte jeweils zu einem Zeitpunkt, an dem

- entweder von der Anzahl q bzw. p gezählter Impulse der beiden Eingangssignale 1 und 2 eine Anzahl als erste den bestimmten vorgegebenen Wert R erreicht
- oder die Summe p+q der Anzahl gezählter Impulse der beiden Eingangssignale 1 und 2 diesen vorgegebenen Wert R erreicht.

## Patentansprüche

1. Anordnung zum Messen einer Scheinleistung
   - mit je einem ein aus Impulsen bestehendes erstes Eingangssignal (1) bzw. zweites Eingangssignal (2) führenden ersten bzw. zweiten Eingang, wobei die Impulsfrequenz (f[P]) des ersten Eingangssignals (1) proportional einem Wert (P) einer zugehörigen Wirkleistung und die Impulsfrequenz (f[Q]) des zweiten Eingangssignals (2) proportional einem Wert (Q) einer zugehörigen Blindleistung ist,
   - mit mindestens einem ersten Impulszähler (4), dessen Takteingang mit einem der beiden Eingangssignale (1,2) verbunden ist zwecks Zählung der Impulse des betreffenden Eingangssignals (1,2), und einem zweiten Impulszähler (22), dessen Takteingang mit mindestens einem der beiden Eingangssignale (1, 2) verbunden ist,
   - mit einer Festwertspeichereinheit (6), die mindestens aus einem Festwertspeicher (6a) besteht, in dem Zahlenwerte gespeichert sind, die abhängig sind von durch den ersten Impulszähler (4) gezählten Werten, und dessen Adresseneingänge (A0 bis A2, A0 bis A3, A0 bis A7) mindestens teilweise mit einem Parallelausgang des ersten Impulszählers (4) verbunden sind, und
   - mit einer Einrichtung (8 bzw. 8; 9) zur Erzeugung von Ausgangsimpulsen mindestens in Abhängigkeit der im Festwertspeicher (6a) gespeicherten Zahlenwerte, wobei die Impulsfrequenz (f[S]) der Ausgangsimpulse proportional einem Wert (S) der Scheinleistung ist,
           dadurch gekennzeichnet, dass
   - ein mit mindestens einem Freigabeausgang (10A bzw. 10D bzw. 17G) versehenes Mittel (10 bzw. 17;18) vorhanden ist zur Freigabe mindestens der Auswertung der im Festwertspeicher (6a) gespeicherten Zahlenwerte jeweils zu einem Zeitpunkt, an dem von der Anzahl p bzw. q gezählter Impulse je eines der beiden Eingangssignale (1, 2) eine Anzahl p bzw. q als erste einen bestimmten vorgegebenen Wert R erreicht oder, an dem die Summe p+q der Anzahl gezählter Impulse der beiden Eingangssignale (1, 2) den Wert R erreicht.

2. Anordnung nach Anspruch 1, dadurch gekennzeichnet,
   - dass eine Einrichtung (7) zum Speichern von Zwischenresultaten vorhanden ist, deren Takteingang mit dem Freigabeausgang (10A bzw. 10D bzw. 17G) des Mittels (10 bzw. 17;18) zur Freigabe der Auswertung verbunden ist,
   - dass in der Einrichtung (8 bzw. 8; 9) zur Erzeugung der Ausgangsimpulse ein Addierer (8) vorhanden ist, dessen Ausgang auf einen Dateneingang der Einrichtung (7) zum Speichern von Zwischenresultaten geführt ist und dessen zwei Buseingänge jeweils mit einem Datenausgang (D0 bis D11, D0 bis D7) des Festwertspeichers (6a) bzw. der Einrichtung (7) zum Speichern von Zwischenresultaten verbunden sind,
   - dass ein Übertragsausgang (CO) des Addierers (8) auf einen Ausgang der Anordnung geführt ist und
   - dass die Ausgangsimpulse der Einrichtung (8 bzw. 8; 9) zur Erzeugung von Ausgangsimpulsen auch

27

in Abhängigkeit der Zwischenresultate erzeugt sind.

3. Anordnung nach Anspruch 1 oder 2, dadurch gekennzeichnet, dass berechnete und auf Multiple von $1/2^K$ abgerundete Werte des Produktes $A.g_s$ im Festwertspeicher (6a) unter Adressen gespeichert sind, die jeweils von einem zugehörigen durch den ersten Impulszähler (4) gezählten Wert q abgeleitet sind, wobei $g_s = [1/R].\sqrt{\{q^2 + [R-q]^2\}}$, K die Anzahl Datenausgangsbits des Festwertspeichers (6a) darstellt, A eine Zahl bezeichnet, die grösser oder gleich einem Zehntel ist, und q alle ganzzahligen Werte von 0 bis R besitzt.

4. Anordnung nach Anspruch 1 oder 2, dadurch gekennzeichnet, dass im Festwertspeicher (6a) Zahlenwerte gespeichert sind, die um $Y/2^K$ niedriger sind als die auf das nächstliegende Multiple von $1/2^K$ abgerundeten Zahlenwerte der berechneten Werte des Produktes $A.g_s$, und zwar unter Adressen, die jeweils von einem zugehörigen, durch den ersten Impulszähler (4) gezählten Wert q abgeleitet sind, wobei $g_s = [1/R].\sqrt{\{q^2 + [R-q]^2\}}$, K die Anzahl Datenausgangsbits des Festwertspeichers (6a) darstellt, A eine Zahl bezeichnet, die grösser oder gleich einem Zehntel ist, q alle ganzzahligen Werte von 0 bis R besitzt und Y eine ganzzahlige Zahl ist.

5. Anordnung nach einem der Ansprüche 1 bis 4, dadurch gekennzeichnet, dass den Adresseneingängen (A0 bis A2) des Festwertspeichers (6a) in der Festwertspeichereinheit (6) Exklusiv-Oder-Gatter (21a, 21b, 21c) vorgeschaltet sind, wobei ein Exklusiv-Oder-Gatter weniger vorhanden ist, als der Parallelausgang des ersten Impulszählers (4) Anzahl Bits aufweist, und wobei die ersten Eingänge aller Exklusiv-Oder-Gatter (21a, 21b, 21c) miteinander verbunden sind und den höchstwertigen Biteingang (MSB) der Adresseneingänge (A0 bis A3) der Festwertspeichereinheit (6) bilden, während die zweiten Eingänge eines jeden Exklusiv-Oder-Gatters (21a, 21b, 21c) die andern Biteingänge der Adresseneingänge (A0 bis A3) der Festwertspeichereinheit (6) bilden.

6. Anordnung nach einem der Ansprüche 1 bis 5, dadurch gekennzeichnet, dass die beiden Eingangssignale (1, 2) über ein Oder-Gatter (10C) auf einen Takteingang des zweiten Impulszählers (22) geführt sind, dessen Parallelausgang über ein als Decoder arbeitendes Mittel (10a) zur Auslösung eines Freigabesignals auf den Freigabeausgang (10A) des Mittels (10) zur Freigabe der Auswertung geführt ist, der seinerseits mit einem Freigabeeingang ($\overline{CE}$) des Festwertspeichers (6a) verbunden ist, und dass der Parallelausgang des ersten Impulszählers (4) auf die Adresseneingänge (A0 bis A3 bzw. A0 bis A2) des Festwertspeichers (6a) geführt ist.

7. Anordnung nach einem der Ansprüche 1 bis 5, dadurch gekennzeichnet, dass der Parallelausgang des ersten Impulszählers (4) mit einem Paralleleingang eines Decoders (10g) verbunden ist, dass eines der beiden Eingangssignale (1, 2) auf einen Takteingang des zweiten Impulszählers (22) geführt ist, dessen Parallelausgang über ein als Decoder arbeitendes Mittel (10a) zur Auslösung eines Freigabesignals mit einem ersten Eingang eines Und-Gatters (10h) verbunden ist, dessen zweiter Eingang auf einen Ausgang des Decoders (10g) und dessen Ausgang auf den Freigabeausgang (10A) des Mittels (10) zur Freigabe der Auswertung geführt ist, der seinerseits mit einem Freigabeeingang ($\overline{CE}$) des Festwertspeichers (6a) verbunden ist, und dass der Parallelausgang des ersten Impulszählers (4) auf die Adresseneingänge (A0 bis A3 bzw. A0 bis A2) des Festwertspeichers (6a) geführt ist.

8. Anordnung nach einem der Ansprüche 1 bis 5, dadurch gekennzeichnet, dass der Parallelausgang des ersten Impulszählers (4) mit einem Dateneingang eines Zwischenregisters (13) verbunden ist, dessen Datenausgang seinerseits auf die Adresseneingänge (A0 bis A3 bzw. A0 bis A2) des Festwertspeichers (6a) geführt ist, dass die beiden Eingangssignale (1, 2) über ein Oder-Gatter (10c) mit einem Takteingang des zweiten Impulszählers (22) verbunden sind, dessen Parallelausgang über ein als Decoder arbeitendes Mittel (10a) zur Auslösung eines Freigabesignals auf einen Freigabeeingang ($\overline{CE}$) des Zwischenregisters (13) geführt ist, und dass der Takteingang des zweiten Impulszählers (22) über einen Inverter (10d) mit dem Freigabeausgang (10D) des Mittels (10) zur Freigabe der Auswertung verbunden ist, der seinerseits auf einen Freigabeeingang ($\overline{CE}$) des Festwertspeichers (6a) geführt ist.

9. Anordnung nach einem der Ansprüche 1 bis 5, dadurch gekennzeichnet, dass der Parallelausgang des ersten Impulszählers (4) mit einem Dateneingang eines Zwischenregisters (13) und mit einem Paralleleingang eines Decoders (10g) verbunden ist, dass der Datenausgang des Zwischenregisters (13) seinerseits auf die Adresseneingänge (A0 bis A3 bzw. A0 bis A2) des Festwertspeichers (6a) geführt ist, dass

28

eines der beiden Eingangssignale (1, 2) mit einem Takteingang des zweiten Impulszählers (22) verbunden ist, dessen Parallelausgang über ein als Decoder arbeitendes Mittel (10a) zur Auslösung eines Freigabesignals auf einen ersten Eingang eines Und-Gatters (10h) geführt ist, dessen zweiter Eingang mit einem Ausgang des Decoders (10g) und dessen Ausgang mit einem Freigabeeingang ($\overline{\text{CE}}$) des Zwischenregisters (13) verbunden ist, und dass der Takteingang des zweiten Impulszählers (22) über einen Inverter (10d) auf den Freigabeausgang (10D) des Mittels (10) zur Freigabe der Auswertung geführt ist, der seinerseits mit einem Freigabeeingang ($\overline{\text{CE}}$) des Festwertspeichers (6a) verbunden ist.

10. Anordnung nach einem der Ansprüche 1 bis 5 mit Adressen des Festwertspeichers (6a), deren niederwertigste Bits in der angegebenen Reihenfolge aus aneinandergereihten Werten von p und q bestehen, wobei p ein zugehöriger durch den zweiten Impulszähler (22) und q ein zugehöriger durch den ersten Impulszählers (4) gezählter Wert ist, dadurch gekennzeichnet, dass der Parallelausgang des ersten Impulszählers (4) mit einem Dateneingang eines Zwischenregisters (13) verbunden ist, dessen Datenausgang seinerseits auf die niederwertigsten Adresseneingänge (A0 bis A3 bzw. A0 bis A2) des Festwertspeichers (6a) geführt ist, dass das Mittel (17;18) zur Freigabe der Auswertung eine Umschalteinrichtung (17) und einen zusätzlichen, als Decoder arbeitenden Festwertspeicher (18) enthält, von dessen Datenausgängen (D11 bis D0) mindestens einer (D11) mit einem Umschalteingang (17M) der Umschalteinrichtung (17) verbunden ist, dass der Freigabeausgang (17G) des Mittels (17;18) zur Freigabe der Auswertung auf einen Freigabeeingang ($\overline{\text{CE}}$) des Festwertspeichers (6a) geführt ist, dass das Mittel (17;18) zur Freigabe der Auswertung noch einen weiteren Freigabeausgang (17F) aufweist, der mit einem Freigabeeingang ($\overline{\text{CE}}$) des Zwischenregisters (13) verbunden ist, und dass der zusätzliche Festwertspeicher (18) gleiche Adressen besitzt wie der Festwertspeicher (6a).

11. Anordnung nach einem der Ansprüche 1 bis 5 mit Adressen des Festwertspeichers (6a), deren niederwertigste Bits in der angegebenen Reihenfolge aus aneinandergereihten Werten von p und q bestehen, wobei p ein zugehöriger durch den zweiten Impulszähler (22) und q ein zugehöriger durch den ersten Impulszähler (4) gezählter Wert ist, dadurch gekennzeichnet, dass das Mittel (17;18) zur Freigabe der Auswertung eine Umschalteinrichtung (17) und einen zusätzlichen, als Decoder arbeitenden Festwertspeicher (18) enthält, von dessen Datenausgängen (D11 bis D0) mindestens einer (D11) mit einem Umschalteingang (17M) der Umschalteinrichtung (17) verbunden ist, dass das Mittel (17;18) zur Freigabe der Auswertung noch einen weiteren Freigabeausgang (17F) aufweist, der auf einen Freigabeeingang ($\overline{\text{CE}}$) des Festwertspeichers (6a) geführt ist, und dass der zusätzliche Festwertspeicher (18) gleiche Adressen besitzt wie der Festwertspeicher (6a).

12. Anordnung nach einem der Ansprüche 8 bis 10, dadurch gekennzeichnet, dass der Parallelausgang des ersten Impulszählers (4) über einen Mikrocomputer (12a) mit dem Dateneingang des Zwischenregisters (13) verbunden ist, wobei der Mikrocomputer (12a) der Ermittlung über eine bestimmte vorgegebene Zeit eines Mittelwertes der am Parallelausgang des ersten Impulszählers (4) anstehenden Werte und der Zuleitung dieses Mittelwertes zum Dateneingang des Zwischenregisters (13) dient.

13. Anordnung nach Anspruch 1 oder 2, dadurch gekennzeichnet, dass berechnete Werte von s aus ganzen Werten und gegebenenfalls abgerundeten Dualbrüchen bestehen, dass letztere mit einem Faktor dermassen multipliziert sind, dass ganzzahlwertige Multiple von $1/2^K$ entstehen, die im Festwertspeicher (6a) jeweils unter Adressen gespeichert sind, die abgeleitet sind von einem zugehörigen durch den ersten Impulszähler (4) gezählten Wert q, dass in einem weiteren Festwertspeicher (14) mindestens das niederwertigste Bit der ganzzahligen Werte von s jeweils unter Adressen gespeichert ist, deren niederwertigste Bits in der angegebenen Reihenfolge aus aneinandergereihten Werten von p+q und q bestehen, und dass mindestens das niederwertigste Bit des Datenausgangs des weiteren Festwertspeichers (14) auch auf den Ausgang der Anordnung geführt ist, wobei s = $\sqrt{\{q^2 + [R - q]^2\}}$, p+q ein zugehöriger durch den zweiten Impulszähler (22) gezählter Wert ist, K die Anzahl Datenausgangsbits der Festwertspeicher (6a, 14) darstellt und q alle ganzzahligen Werte von 0 bis R besitzt.

14. Anordnung nach Anspruch 1 oder 2, dadurch gekennzeichnet, dass um $Y/2^K$ verkleinerte berechnete Werte von s aus ganzen Werten und gegebenenfalls abgerundeten Dualbrüchen bestehen, dass letztere mit einem Faktor dermassen multipliziert sind, dass ganzzahlwertige Multiple von $1/2^K$ entstehen, dass im Festwertspeicher (6a) die Werte der so berechneten ganzzahlwertigen Multiplen von $1/2^K$ der Dualbrüche gespeichert sind, und zwar jeweils unter Adressen, die abgeleitet sind von einem zugehörigen durch den ersten Impulszähler (4) gezählten Wert q, dass in einem weiteren Festwertspeicher (14) mindestens das niederwertigste Bit der ganzzahligen Werte der um Y/2$^K$ verkleinerten berechneten Werte von s jeweils unter Adressen gespeichert ist, deren niederwertigste Bits in der angegebenen Reihenfolge aus aneinandergereihten Werten von p+q und q bestehen, und dass mindestens das niederwertigste Bit des Datenausgangs des weiteren Festwertspeichers (14) auch auf den Ausgang der Anordnung geführt ist, wobei $s = \sqrt{q^2 + [R - q]^2}$, p+q ein zugehöriger durch den zweiten Impulszähler (22) gezählter Wert ist, K die Anzahl Datenausgangsbits der Festwertspeicher (6a, 14) darstellt, q alle ganzzahligen Werte von 0 bis R besitzt und Y eine ganzzahlige Zahl ist.

15. Anordnung nach Anspruch 13 oder 14, dadurch gekennzeichnet, dass die beiden Eingangssignale (1, 2) über ein Oder-Gatter (10c) auf einen Takteingang des zweiten Impulszählers (22) geführt sind, dessen Parallelausgang über ein als Decoder arbeitendes Mittel (10a) zur Auslösung eines Freigabesignals auf den Freigabeausgang (10A) des Mittels (10) zur Freigabe der Auswertung geführt ist, der seinerseits mit einem Freigabeeingang ($\overline{CE}$) des Festwertspeichers (6a) und invertiert mit einem Freigabeeingang ($\overline{CE}$) des weiteren Festwertspeichers (14) verbunden ist.

16. Anordnung nach Anspruch 13 oder 14, dadurch gekennzeichnet, dass der Parallelausgang des ersten Impulszählers (4) mit einem Paralleleingang eines Decoders (10g) verbunden ist, dass eines der beiden Eingangssignale (1, 2) auf einen Takteingang des zweiten Impulszählers (22) geführt ist, dessen Parallelausgang über ein als Decoder arbeitendes Mittel (10a) zur Auslösung eines Freigabesignals mit einem ersten Eingang eines Und-Gatters (10h) verbunden ist, dessen zweiter Eingang auf einen Ausgang des Decoders (10g) und dessen Ausgang auf den Freigabeausgang (10A) des Mittels (10) zur Freigabe der Auswertung geführt ist, der seinerseits mit einem Freigabeeingang ($\overline{CE}$) des Festwertspeichers (6a) und invertiert mit einem Freigabeeingang ($\overline{CE}$) des weiteren Festwertspeichers (14) verbunden ist.

17. Anordnung nach einem der Ansprüche 13 bis 16, dadurch gekennzeichnet, dass den Adresseneingängen (A0 bis A2) des Festwertspeichers (6a) in der Festwertspeichereinheit (6) Exklusiv-Oder-Gatter (21a, 21b, 21c) vorgeschaltet sind, wobei ein Exklusiv-Oder-Gatter weniger vorhanden ist, als der Parallelausgang des ersten Impulszählers (4) Anzahl Bits aufweist, und wobei die ersten Eingänge aller Exklusiv-Oder-Gatter (21a, 21b, 21c) miteinander verbunden sind und den höchstwertigen Biteingang (MSB) der Adresseneingänge (A0 bis A3) der Festwertspeichereinheit (6) bilden, während die zweiten Eingänge eines jeden Exklusiv-Oder-Gatters (21a, 21b, 21c) die andern Biteingänge der Adresseneingänge (A0 bis A3) der Festwertspeichereinheit (6) bilden.

18. Anordnung nach Anspruch 1 oder 2, dadurch gekennzeichnet, dass berechnete Werte von s aus ganzen Werten und gegebenenfalls abgerundeten Dualbrüchen bestehen, dass letztere mit einem Faktor dermassen multipliziert sind, dass ganzzahlwertige Multiple von 1/2$^K$ entstehen, die im Festwertspeicher (6a) gespeichert sind, dass in einem weiteren Festwertspeicher (14) mindestens das niederwertigste Bit der ganzzahligen Werte von s gespeichert ist und dass mindestens das niederwertigste Bit des Datenausgangs des weiteren Festwertspeichers (14) auch auf den Ausgang der Anordnung geführt ist, wobei das Speichern in den beiden Festwertspeichern (6a, 14) jeweils unter Adressen erfolgt, deren niederwertigste Bits in der angegebenen Reihenfolge aus aneinandergereihten Werten von p und q bestehen, wobei $s = \sqrt{q^2 + [R - q]^2}$, p ein zugehöriger durch den zweiten Impulszähler (22) und q ein zugehöriger durch den ersten Impulszähler (4) gezählter Wert ist, K die Anzahl Datenausgangsbits der Festwertspeicher (6a, 14) darstellt und q alle ganzzahligen Werte von 0 bis R besitzt.

19. Anordnung nach Anspruch 1 oder 2, dadurch gekennzeichnet, dass um Y/2$^K$ verkleinerte berechnete Werte von s aus ganzen Werten und gegebenenfalls abgerundeten Dualbrüchen bestehen, dass letztere mit einem Faktor dermassen multipliziert sind, dass ganzzahlwertige Multiple von 1/2$^K$ entstehen, dass im Festwertspeicher (6a) die Werte der so berechneten ganzzahlwertigen Multiplen von 1/2$^K$ der Dualbrüche gespeichert sind, dass in einem weiteren Festwertspeicher (14) mindestens das niederwertigste Bit der ganzzahligen Werte der um Y/2$^K$ verkleinerten berechneten Werte von s jeweils unter Adressen gespeichert ist, und dass mindestens das niederwertigste Bit des Datenausgangs des weiteren Festwertspeichers (14) auch auf den Ausgang der Anordnung geführt ist, wobei das Speichern in den beiden Festwertspeichern (6a, 14) jeweils unter Adressen erfolgt, deren niederwertigste Bits in der angegebenen Reihenfolge aus aneinandergereihten Werten von p und q bestehen, wobei $s = \sqrt{q^2 + [R - q]^2}$, p ein zugehöriger durch den zweiten Impulszähler (22) und q ein zugehöriger durch den ersten Impulszähler (4) gezählter Wert ist, K die Anzahl Datenausgangsbits der Festwertspeicher (6a, 14) darstellt, q alle ganzzahligen Werte von 0 bis R besitzt und Y eine ganzzahlige Zahl ist.

20. Anordnung nach Anspruch 18 oder 19, dadurch gekennzeichnet, dass das Mittel (17;18) zur Freigabe der Auswertung eine Umschalteinrichtung (17) und einen zusätzlichen, als Decoder arbeitenden Festwertspeicher (18) enthält, von dessen Datenausgängen (D7 bis D0) mindestens einer (D7) mit einem Umschalteingang (17M) der Umschalteinrichtung (17) verbunden ist, dass das Mittel (17;18) zur Freigabe der Auswertung noch einen weiteren Freigabeausgang (17F) aufweist, der auf einen Freigabeeingang ($\overline{CE}$) des Festwertspeichers (6a) sowie invertiert auf einen Freigabeeingang ($\overline{CE}$) des weiteren Festwertspeichers (14) geführt ist, und dass der zusätzliche Festwertspeicher (18) gleiche Adressen besitzt wie die beiden andern Festwertspeicher (6a, 14).

21. Anordnung nach Anspruch 1 oder 2, dadurch gekennzeichnet, dass ein weiterer Festwertspeicher (14) vorhanden ist und berechnete und auf Multiple von $1/2^K$ abgerundete Werte von A.cos$\phi$ und A.sin$\phi$ je in einem der beiden Festwertspeicher (6a bzw. 14) unter Adressen gespeichert sind, die jeweils vom zugehörigen, durch den ersten Impulszähler (4) gezählten Wert q abgeleitet sind, wobei cos$\phi$ = [R - q]/$\sqrt{\{q^2 + [R - q]^2\}}$, sin$\phi$ = q/$\sqrt{\{q^2 + [R - q]^2\}}$, K die Anzahl Datenausgangsbits der beiden Festwertspeicher (6a, 14) darstellt, A eine Zahl bezeichnet, die grösser oder gleich einem Zehntel ist, und q alle ganzzahligen Werte von 0 bis R besitzt.

22. Anordnung nach Anspruch 21, dadurch gekennzeichnet,
- dass der Parallelausgang des ersten Impulszählers (4) mit einem Dateneingang eines Zwischenregisters (13) verbunden ist, dessen Datenausgang seinerseits auf Adresseneingänge (A0 bis A3) der beiden Festwertspeicher (6a, 14) geführt ist,
- dass die Datenausgänge (D0 bis D11) der beiden Festwertspeicher (6a, 14) parallelgeschaltet sind und
- dass die beiden Eingangssignale (1, 2) mit einem Freigabeeingang ($\overline{CE}$) je eines der beiden Festwertspeicher (6a bzw. 14) verbunden sind.

23. Anordnung nach Anspruch 22, dadurch gekennzeichnet,
- dass gleichwertige abgerundete Werte von A.cos$\phi$ und A.sin$\phi$ in den beiden Festwertspeichern (6a, 14) unter gleichen Adressen gespeichert sind und
- dass die Adresseneingänge (A0 bis A3 bzw. A0 bis A7) des Festwertspeichers (6a) über je einen Inverter (15) pro Bit auf die Adresseneingänge (A0 bis A3 bzw. A0 bis A7) des weiteren Festwertspeichers (14) geführt sind.

24. Anordnung nach Anspruch 22 oder 23, dadurch gekennzeichnet, dass die beiden Eingangssignale (1, 2) über ein Oder-Gatter (10c) auf einen Takteingang des zweiten Impulszählers (22) geführt sind, dessen Parallelausgang über ein als Decoder arbeitendes Mittel (10a) zur Auslösung eines Freigabesignals mit einem weiteren Freigabeausgang (10A) des Mittels (10) zur Freigabe der Auswertung verbunden ist, der seinerseits auf einen Freigabeeingang ($\overline{CE}$) des Zwischenregisters (13) geführt ist, und dass der Takteingang des zweiten Impulszählers (22) über einen Inverter (10d) den Freigabeausgang (10D) des Mittels (10) zur Freigabe der Auswertung bildet.

25. Anordnung nach Anspruch 22 oder 23, dadurch gekennzeichnet, dass der Parallelausgang des ersten Impulszählers (4) mit einem Paralleleingang eines Decoders (10g) verbunden ist, dass eines der beiden Eingangssignale (1, 2) auf einen Takteingang des zweiten Impulszählers (22) geführt ist, dessen Parallelausgang über ein als Decoder arbeitendes Mittel (10a) zur Auslösung eines Freigabesignals mit einem ersten Eingang eines Und-Gatters (10h) verbunden ist, dessen zweiter Eingang auf einen Ausgang des Decoders (10g) und dessen Ausgang auf einen weiteren Freigabeausgang (10A) des Mittels (10) zur Freigabe der Auswertung geführt ist, der seinerseits mit einem Freigabeeingang ($\overline{CE}$) des Zwischenregisters (13) verbunden ist, und dass der Takteingang des zweiten Impulszählers (22) über einen Inverter (10d) den Freigabeausgang (10D) des Mittels (10) zur Freigabe der Auswertung bildet.

26. Anordnung nach Anspruch 22 oder 23, dadurch gekennzeichnet, dass das Mittel (17;18) zur Freigabe der Auswertung eine Umschalteinrichtung (17) und einen zusätzlichen, als Decoder arbeitenden Festwertspeicher (18) enthält, von dessen Datenausgängen (D11 bis D0) mindestens einer (D11) mit einem Umschalteingang (17M) der Umschalteinrichtung (17) verbunden ist, dass das Mittel (17;18) zur Freigabe der Auswertung noch einen weiteren Freigabeausgang (17F) aufweist, der auf einen Freigabeeingang ($\overline{CE}$)

des Zwischenregisters (13) geführt ist, und dass der zusätzliche Festwertspeicher (18) gleiche Adressen besitzt wie der Festwertspeicher (6a).

27. Anordnung nach einem der Ansprüche 22 bis 26, dadurch gekennzeichnet, dass der Parallelausgang des ersten Impulszählers (4) über einen Mikrocomputer (12a) mit dem Dateneingang des Zwischenregisters (13) verbunden ist, wobei der Mikrocomputer (12a) der Ermittlung über eine bestimmte vorgegebene Zeit eines Mittelwertes der am Parallelausgang des ersten Impulszählers (4) anstehenden Werte und der Zuleitung dieses Mittelwertes zum Dateneingang des Zwischenregisters (13) dient.

28. Anordnung nach einem der Ansprüche 10 bis 27, dadurch gekennzeichnet, dass die vorhandenen Festwertspeicher (6a, 14 bzw. 6a, 18 bzw. 6a, 14, 18) alle oder teilweise zusammen einen einzigen Festwertspeicher (6a;14 bzw. 6a;18 bzw. 6a;14;18) bilden, der mindestens ein Adressenbit mehr aufweist als die einzelnen Festwertspeicher (6a, 14, 18), die ihn bilden.

## Claims

1. An arrangement for measuring an apparent power comprising:
   - first and second inputs carrying a first input signal (1) and a second input signal (2) respectively each comprising pulses, wherein the pulse frequency (f[P]) of the first input signal (1) is proportional to a value (P) of an associated active power and the pulse frequency (f[Q]) of the second input signal (2) is proportional to a value (Q) of an associated reactive power,
   - at least a first pulse counter (4) whose clock input is connected to one of the two input signals (1, 2) for the purposes of counting the pulses of the respective input signal (1, 2), and a second pulse counter (22) having a clock input connected to at least one of the two input signals (1, 2),
   - a read only memory unit (6) which at least comprises a read only memory (6a) in which are stored numerical values which are dependent on values counted by the first pulse counter (4) and whose address inputs (A0 to A2, A0 to A3, A0 to A7) are at least partially connected to a parallel output of the first pulse counter (4), and
   - a means (8 or 8; 9) for producing output pulses at least in dependence on the numerical values which are stored in the read only memory (6a), wherein the pulse frequency (f[S]) of the output pulses is proportional to a value (S) of the apparent power, characterised in that
   - there is a means (10 or 17; 18) provided with at least one enable output (10A or 10D or 17G respectively) for enablement at least of evaluation of the numerical values stored in the read only memory (6a) at a respective moment at which of the number p or q of counted pulses of a respective one of the two input signals (1, 2) a number p or q is the first to reach a given predetermined value R, or, at which the sum p+q of the number of counted pulses of the two input signals (1, 2) reaches the value R.

2. An arrangement according to claim 1 characterised in that:
   - there is a means (7) for the storage of intermediate results, rose clock input is connected to the enable output (10A or 10D or 17G) of the means (10 or 17; 18) for enablement of evaluation,
   - provided in the means (8 or 8; 9) for producing the output pulses is an adder (8) whose output is taken to a data input of the means (7) for storage of intermediate results and rose two bus inputs are respectively connected to a data output (D0 to D11 , D0 to D7) of the read only memory (6a) and the means (7) for storage of the intermediate results respectively,
   - a carry output (CO) of the adder (8) is taken to an output of the arrangement, and
   - the ouptut pulses of the means (8 or 8; 9) for producing output signals are also produced in dependence on the intermediate results.

3. An arrangement according to claim 1 or claim 2 characterised in that calculated values, which are rounded off to multiples of $1/2^K$, of the product A. $g_s$ are stored in the read only memory (16a) at addresses which are respectively derived from an associated value q which is counted by the first pulse counter (4), wherein $g_s = [1/R]. \sqrt{q^2 + [R - q]^2}$ , K represents the number of data output bits of the read only memory (6a), A denotes a number which is greater than or equal to a tenth, and q has all integral values from 0 to R.

4. An arrangement according to claim 1 or claim 2 characterised in that stored in the read only memory (6a) are numerical values which are lower by $Y/2^K$ than the numerical values, which are rounded off to the closest multiple of $1/2^K$, of the calculated values of the product A.$g_s$, more specifically at addresses which are derived from an associated value q which is counted by the first pulse counter (4), wherein $g_s = [1/R]$.
$\sqrt{\{q^2 + [R - q]^2\}}$ , K represents the number of data output bits of the read only memory (6a), A denotes a number which is greater than or equal to a tenth, q has all integral values from 0 to R and Y is an integral number.

5.  An arrangement according to one of claims 1 to 4 characterised in that exclusive-or-gates (21a, 21b, 21c) are disposed upstream of the address inputs (A0 to A2) of the read only memory (6a) in the read only memory unit (6), wherein there is one exclusive-or-gate less than the number of bits of the parallel output of the first pulse counter (4), and wherein the first inputs of all exclusive-or-gates (21a, 21b, 21c) are connected together and form the most significant bit input (MSB) of the address inputs (A0 to A3) of the read only memory unit (6) while the second inputs of each exclusive-or-gate (21a, 21b, 21c) form the other bit inputs of the address inputs (A0 to A3) of the read only memory unit (6).

6.  An arrangement according to one of claims 1 to 5 characterised in that the two input signals (1, 2) are taken by way of an or-gate (10c) to a clock input of the second pulse counter (22) whose parallel output is taken by way of a means (10a) operating as a decoder for triggering an enable signal to the enable output (10A) of the means (10) for enablement of evaluation, which in turn is connected to an enable input ($\overline{\text{CE}}$) of the read only memory (6a), and that the parallel output of the first pulse counter (4) is taken to the address inputs (A0 to A3 and A0 to A2 respectively) of the read only memory (6a).

7.  An arrangement according to one of claims 1 to 5 characterised in that the parallel output of the first pulse counter (4) is connected to a parallel input of a decoder (10g), that one of the two input signals (1, 2) is passed to a clock input of the second pulse counter (22) whose parallel output is connected by way of a means (10a) operating as a decoder for triggering an enable signal to a first input of an and-gate (10h), whose second input is taken to an output of the decoder (10g) and whose output is taken to the enable output (10A) of the means (10) for enablement of evaluation, which in turn is connected to an enable input ($\overline{\text{CE}}$) of the read only memory (6a), and that the parallel output of the first pulse counter (4) is taken to the address inputs (A0 to A3 and A0 to A2 respectively) of the read only memory (6a).

8.  An arrangement according to one of claims 1 to 5 characterised in that the parallel output of the first pulse counter (4) is connected to a data input of an intermediate register (13) whose data output is in turn taken to the address inputs (A0 to A3 and A0 to A2 respectively) of the read only memory (6a), that the two input signals (1, 2) are connected by way of an or-gate (10c) to a clock input of the second pulse counter (22) whose parallel output is taken by way of a means (10a) operating as a decoder for triggering an enable signal to an enable input ($\overline{\text{CE}}$) of the intermediate register (13), and that the clock input of the second pulse counter (22) is connected by way of an inverter (10d) to the enable output (10D) of the means (10) for enablement of evaluation, which in turn is taken to an enable input (CE) of the read only memory (6a).

9.  An arrangement according to one of claims 1 to 5 characterised in that the parallel output of the first pulse counter (4) is connected to a data input of an intermediate register (13) and to a parallel input of a decoder (10g), that the data output of the intermediate register (13) is in turn taken to the address inputs (A0 to A3 and A0 to A2 respectively) of the read only memory (6a), that one of the two input signals (1, 2) is connected to a clock input of the second pulse counter (22) whose parallel output is taken by way of a means (10a) operating as a decoder for triggering an enable signal to a first input of an and-gate (10h) whose second input is connected to an output of the decoder (10g) and whose output is connected to an enable input ($\overline{\text{CE}}$) of the intermediate register (13) and that the clock input of the second pulse counter (22) is taken by way of an inverter (10d) to the enable output (10D) of the means (10) for enablement of evaluation, which in turn is connected to an enable input ($\overline{\text{CE}}$) of the read only memory (6a).

10. An arrangement according to one of claims 1 to 5 with addresses of the read only memory (6a), whose least significant bits in the specified sequence comprise a string of values of p and q, wherein p is an associated value which is counted by the second pulse counter (22) and q is an associated value which is counted by the first pulse counter (4), characterised in that the parallel output of the first pulse counter (4) is connected to a data input of an intermediate register (13) whose data output is in turn taken to the least significant address inputs (A0 to A3 and A0 to A2 respectively) of the read only memory (6a), that the means (17; 18) for enablement of evaluation includes a change-over switching means (17) and an additional read only memory (18) which operates as a decoder and of whose data outputs (D11 to D0) at least one (D11) is connected to a change-over switching input (17M) of the change-over switching means

33

(17), that the enable output (17G) of the memory (17; 18) for enablement of evaluation is taken to an enable input ($\overline{CE}$) of the read only memory (6a), that the means (17; 18) for enablement of evaluation also has a further enable output (17F) which is connected to an enable input ($\overline{CE}$) of the intermediate register (13), and that the additional read only memory (18) has identical addresses to the read only memory (6a).

11. An arrangement according to one of claims 1 to 5 with addresses of the read only memory (6a) whose least significant bits in the specified sequence comprise a string of values of p and q, wherein p is an associated value which is counted by the second pulse counter (22) and q is an associated value which is counted by the first pulse counter (4), characterised in that the means (17; 18) for enablement of evaluation includes a change-over switching means (17) and an additional read only memory (18) which operates as a decoder and of whose data outputs (D11 to D0) at least one (D11) is connected to a change-over switching input (17M) of the change-over switching means (17), that the means (17; 18) for enablement of evaluation also has a further enable output (17F) which is taken to an enable input ($\overline{CE}$) of the read only memory (6a) and that the additional read only memory (18) has identical addresses to the read only memory (6a).

12. An arrangement according to one of claims 8 to 10 characterised in that the parallel output of the first pulse counter (4) is connected by way of a microcomputer (12a) to the data input of the intermediate register, wherein the microcomputer (12a) serves to ascertain over a given predetermined time a mean value of the values at the parallel output of the first pulse counter (4) and to pass said mean value to the data input of the intermediate register (13).

13. An arrangement according to claim 1 or claim 2 characterised in that calculated values of s comprise whole values and possibly rounded-off binary fractions, that the latter are multiplied by a factor such that integral multiples of $1/2^K$ are produced, which are stored in the read only memory (6a) at respective addresses which are derived from an associated value q which is counted by the first pulse counter (4), that stored in a further read only memory (14) is at least the least significant bit of the integral values of s at respective addresses rose least significant bits in the specified sequence comprise a string of values of p+q and q, and that at least the least significant bit of the data output of the further read only memory (14) is also taken to the output of the arrangement, wherein s = $\sqrt{\{q^2 + [R - q]^2\}}$ , p+q is an associated value which is counted by the second pulse counter (22), K represents the number of data output bits of the read only memories (6a, 14) and q has all integral values from 0 to R.

14. An arrangement according to claim 1 or claim 2 characterised in that calculated values of s which are reduced by $Y/2^K$ comprise whole values and possibly rounded-off binary fractions, that the latter are multiplied by a factor such that integral multiples of $1/2^K$ are produced, that stored in the read only memory (6a) are the values of the integral multiples of $1/2^K$ of the binary fractions, which are calculated in that way, more specifically at respective addresses which are derived from an associated value q which is counted by the first pulse counter (4), that at least the least significant bit of the integral values of the calculated values of s which are reduced by $Y/2^K$ is stored in a further read only memory (14) at respective addresses whose least significant bits in the specified sequence comprise a string of values of p+q and q, and that at least the least significant bit of the data output of the further read only memory (14) is also taken to the output of the arrangement, wherein s = $\sqrt{\{q^2 + [R - q]^2\}}$ , p+q is an associated value which is counted by the second pulse counter (22), K represents the number of data output bits of the read only memories (6a, 14), q has all integral values from 0 to R and Y is an integral number.

15. An arrangement according to claim 13 or claim 14 characterised in that the two input signals (1, 2) are taken by way of an or-gate (10c) to a clock input of the second pulse counter (22) whose parallel output is taken by way of a means (10a) operating as a decoder for triggering an enable signal to the enable output (10A) of the means (10) for enablement of evaluation, which in turn is connected to an enable input ($\overline{CE}$) of the read only memory (6a) and inverted to an enable input ($\overline{CE}$) of the further read only memory (14).

16. An arrangement according to claim 13 or claim 14 characterised in that the parallel output of the first pulse counter (4) is connected to a parallel input of a decoder (10g), that one of the two input signals (1, 2) is taken to a clock input of the second pulse counter (22), whose parallel output is connected by way of a means (10a) operating as a decoder for triggering an enable signal to a first input of an and-gate (10h) whose second input is taken to an output of the decoder (10g) and whose output is taken to the enable output (10A) of the means (10) for enablement of evaluation, which in turn is connected to an enable input ($\overline{CE}$) of the read only memory (6a) and inverted to an enable input ($\overline{CE}$) of the further read only memory (14).

17. An arrangement according to one of claims 13 to 16 characterised in that exclusive-or-gates (21a, 21b, 21c) are connected upstream of the address inputs (A0 to A2) of the read only memory (6a) in the read only memory unit (6), wherein there is an exclusive-or-gate less than the number of bits of the parallel output of the first pulse counter (4), and wherein the first inputs of all exclusive-or-gates (21a, 21b, 21c) are connected together and form the most significant bit input (MSB) of the address inputs (A0 to A3) of the read only memory unit (6) while the second inputs of each exclusive or-gate (21a, 21b, 21c) form the other bit inputs of the address inputs (A0 to A3) of the read only memory unit (6).

18. An arrangement according to claim 1 or claim 2 characterised in that calculated values of s comprise integral values and possibly rounded-off binary fractions, that the latter are multiplied by a factor such that integral multiples of $1/2^K$ are produced, which are stored in the read only memory (6a), that at least the least significant bit of the integral values of s is stored in a further read only memory (14) and that at least the least significant bit of the data output of the further read only memory (14) is also taken to the output of the arrangement, wherein storage in the two read only memories (6a, 14) occurs at respective addresses whose least significant bits in the specified sequence comprise a string of values of p and q, wherein $s = \sqrt{\{q^2 + [R - q]^2\}}$ , p is an associated value which is counted by the second pulse counter (22) and q is an associated value which is counted by the first pulse counter (4), K represents the number of data output bits of the read only memories (6a, 14) and q has all integral values from 0 to R.

19. An arrangement according to claim 1 or claim 2 characterised in that calculated values of s, which are reduced by $Y/2^K$, comprise integral values and possibly rounded-off binary fractions, that the latter are multiplied by a factor such that integral multiples of $1/2^K$ are produced, that the values of the integral multiples of $1/2^K$ of the binary fractions, which are calculated in that way, are stored in the read only memory (6a), that at least the least significant bit of the integral values of the calculated values of s, which are reduced by $Y/2^K$, is stored in a further read only memory (14) at respective addresses, and that at least the least significant bit of the data output of the further read only memory (14) is also taken to the output of the arrangement, wherein storage in the two read only memories (6a, 14) is effected at respective addresses whose least significant bits in the specified sequence comprise a string of values of p and q, wherein $s = \sqrt{\{q^2 + [R - q]^2\}}$ , p is an associated value which is counted by the second pulse counter (22) and q is an associated value which is counted by the first pulse counter (4), K represents the number of data output bits of the read only memories (6a, 14), q has all integral values of 0 to R and Y is an integral number.

20. An arrangement according to claim 18 or claim 19 characterised in that the means (17; 18) for enablement of evaluation includes a change-over switching means (17) and an additional read only memory (18) which operates as a decoder and of whose data outputs (D7 to D0) at least one (D7) is connected to a change-over switching input (17M) of the change-over switching means (17), that the means (17; 18) for enablement of evaluation also has a further enable output (17F) which is taken to an enable input ($\overline{CE}$) of the read only memory (6a) and inverted to an enable input ($\overline{CE}$) of the further read only memory (14), and that the additional read only memory (18) has identical addresses to the other two read only memories (6a, 14).

21. An arrangement according to claim 1 or claim 2 characterised in that there is a further read only memory (14) and calculated values, which are rounded off to multiples of $1/2^K$, of A.cos $\phi$ and A. sin $\phi$ are respectively stored in one of the two read only memories (6a and 14 respectively) at addresses which are respectively derived from the associated value q which is counted by the first pulse counter (4), wherein $\cos \phi = [R - q]/\sqrt{\{q^2 + [R - q]^2\}}$, $\sin \phi = q/\sqrt{\{q^2 + [R - q]^2\}}$ , K represents the number of data output bits of the two read only memories (6a, 14), A denotes a number which is greater than or equal to a tenth and q has all integral values from 0 to R.

22. An arrangement according to claim 21 characterised in that:
- the parallel output of the first pulse counter (4) is connected to a data input of an intermediate register (13) whose data output is in turn taken to address inputs (A0 to A3) of the two read only memories (6a, 14),
- the data outputs (D0 to D11) of the two read only memories (6a, 14) are connected in parallel, and
- the two input signals (1, 2) are connected to an enable input ($\overline{CE}$) of a respective one of the two read only memories (6a and 14 respectively).

23. An arrangement according to claim 22 characterised in that:
- equivalent rounded-off values of A.cos $\phi$ and A.sin $\phi$ are stored in the two read only memories (6a, 14) at the same addresses, and
- the address inputs (A0 to A3 and A0 to A7 respectively) of the read only memory (6a) are taken by way of a respective inverter (15) for each bit to the address inputs (A0 to A3 and A0 to A7 respectively) of the further read only memory (14).

24. An arrangement according to claim 22 or claim 23 characterised in that the two input signals (1, 2) are taken by way of an or-gate (10c) to a clock input of the second pulse counter (22) whose parallel output is connected by way of a means (10a) operating as a decoder for triggering an enable signal to a further enable output (10A) of the means (10) for enablement of evaluation, which in turn is taken to an enable input ($\overline{CE}$) of the intermediate register (13), and that the clock input of the second pulse counter (22), by way of an inverter (10d), forms the enable output (10D) of the means (10) for enablement of evaluation.

25. An arrangement according to claim 22 or claim 23 characterised in that the parallel output of the first pulse counter (4) is connected to a parallel input of a decoder (10g), that one of the two input signals (1, 2) is taken to a clock input of the second pulse counter (22) whose parallel output is connected by way of a means (10a) operating as a decoder for triggering an enable signal to a first input of an and-gate (10h) whose second input is taken to an output of the decoder (10g) and whose output is taken to a further enable output (10A) of the means (10) for enablement of evaluation, which in turn is connected to an enable input ($\overline{CE}$) of the intermediate register (13), and that the clock input of the second pulse counter (22), by way of an inverter (10d), forms the enable output (10D) of the means (10) for enablement of evaluation.

26. An arrangement according to claim 22 or claim 23 characterised in that the means (17; 18) for enablement of evaluation includes a change-over switching means (17) and an additional read only memory (18) which operates as a decoder and of whose data outputs (D11 to D0) at least one (D11) is connected to a change-over switching input (17M) of the change-over switching means (17), that the means (17; 18) for enablement of evaluation also has a further enable output (17F) which is taken to an enable input ($\overline{CE}$) of the intermediate register (13) and that the additional read only memory (18) has identical addresses to the read only memory (6a).

27. An arrangement according to one of claims 22 to 26 characterised in that the parallel output of the first pulse counter (4) is connected by way of a microcomputer (12a) to the data input of the intermediate register (13), wherein the microcomputer (12a) serves to ascertain over a given predetermined time a mean value of the values at the parallel output of the first pulse counter (4) and to pass said mean value to the data input of the intermediate register (13).

28. An arrangement according to one of claims 10 to 27 characterised in that the provided read only memories (6a, 14 and 6a, 18 and 6a, 14, 18 respectively) all or in part together form a single read only memory (6a; 14 and 6a; 18 and 6a; 14; 18) which has at least one address bit more than the individual read only memories (6a, 14, 18) which form it.

**Revendications**

1. Montage de mesure d'une puissance apparente, comprenant
- Une première ainsi qu'une seconde entrées par lesquelles passent respectivement un premier signal d'entrée (1) ainsi qu'un second signal d'entrée (2) se composant d'impulsions, la fréquence des impulsions (f[P]) du premier signal d'entrée (1) étant proportionnelle à une valeur (P) d'une puissance réelle correspondante et la fréquence des impulsions (f[Q]) du second signal d'entrée (2) étant proportionnelle à une valeur (Q) d'une puissance réactive correspondante,
- au moins un premier compteur d'impulsions (4) dont l'entrée d'attaque reçoit l'un des deux signaux d'entrée (1, 2) en vue du comptage des impulsions du signal d'entrée concerné (1, 2), ainsi qu'un second compteur d'impulsions (22) dont l'entrée d'attaque reçoit au moins l'un des deux signaux d'entrée

EP 0 382 890 B1

(1, 2),

- un module à mémoires mortes (6) qui se compose d'au moins d'une mémoire morte (6a) dans laquelle sont enregistrées les valeurs numériques qui sont fonction des grandeurs comptées par le premier compteur d'impulsions (4) et dont les entrées d'adressage (A0 à A2, A0 à A3, A0 à A7) sont connectées au moins partiellement à une sortie en parallèle du premier compteur d'impulsions (4) et

- au moins un dispositif (8 ou 8;9) de production d'impulsions de sortie au moins en fonction des valeurs numériques enregistrées dans la mémoire morte (6a), la fréquence (f[S]) des impulsions de sortie étant proportionnelle à une valeur (S) de la puissance apparente,

caractérisé en ce que :

- il comprend au moins un moyen (10 ou 17;18) comportant au moins une sortie de restitution (10A ou 10D ou 17G) et destiné à restituer au moins le compte des valeurs numériques enregistrées dans la mémoire morte (6a), à chaque fois à un instant auquel soit le nombre p, soit le nombre q des impulsions comptées de l'un ou de l'autre des deux signaux d'entrée (1, 2) atteint en premier une valeur déterminée prescrite R, ou à un instant auquel la somme p+q du nombre des impulsions comptées des deux signaux d'entrée (1, 2) atteint la valeur R.

2. Montage selon la revendication 1, caractérisé en ce qu'il comprend un dispositif (7) d'enregistrement de résultats intermédiaires, dont l'entrée d'attaque est connectée à la sortie de restitution (10A ou 10D ou 17G) du moyen (10 ou 17;18) de restitution du compte,

- en ce qu'il existe dans le dispositif (8 ou 8;9) de production des impulsions de sortie un additionneur (8) dont la sortie est dirigée sur une entrée des données du dispositif (7) d'enregistrement de résultats intermédiaires et dont chacune de deux entrées par bus est connectée d'une part à la sortie des données (D0 à D11, D0 à D7) de la mémoire morte (6a) et d'autre part au dispositif (7) d'enregistrement de résultats intermédiaires,

- en ce qu'une sortie de report (CO) de l'additionneur (8) est dirigée sur une sortie du montage et

- en ce que les impulsions de sortie du dispositif (8 ou 8;9) de production d'impulsions de sortie sont aussi produites en fonction des résultats intermédiaires.

3. Montage selon la revendication 1 ou 2, caractérisé en ce que des valeurs du produit $A.g_s$ qui sont calculées et arrondies à un multiple de $1/2^K$ sont enregistrées dans la mémoire morte (6a) à des adresses dont chacune est tirée d'une valeur correspondante q comptée par le premier compteur d'impulsions (4), $g_s = [1/R].\sqrt{\{q^2 + [R - q]^2\}}$, K représentant le nombre des bits de sortie des données de la mémoire morte (6a), A désignant un nombre qui est supérieur ou égal à un dixième et Q ayant toutes les valeurs en nombres entiers allant de 0 à R.

4. Montage selon la revendication 1 ou 2, caractérisé en ce que les valeurs numériques qui sont enregistrées dans la mémoire morte (6a) sont inférieures de $Y/2^K$ aux valeurs numériques, arrondies au multiple entier suivant de $1/2^K$, des valeurs calculées du produit $A.g_s$, et plus particulièrement à des adresses dont chacune est tirée d'une valeur correspondante q comptée par le premier compteur d'impulsions (4), $g_s = [1/R].\sqrt{\{q^2 + [R - q]^2\}}$, K représentant le nombre des bits de sortie des données de la mémoire morte (6a), A désignant un nombre qui est supérieur ou égal à un dixième, q ayant toutes les valeurs en nombres entiers allant de 0 à R et Y étant un nombre entier.

5. Montage selon l'une des revendications 1 à 4, caractérisé en ce que des opérateurs OU exclusif (21a, 21b, 21c) sont montés dans le module à mémoires mortes (6) en amont des sorties d'adressage (A0 à A2) de la mémoire morte (6a), le nombre des opérateurs OU exclusif existants étant inférieur de un à celui des bits que comprend la sortie en parallèle du premier compteur d'impulsions (4), les premières entrées de tous les opérateurs OU exclusif (21a, 21b, 21c) étant connectées les unes aux autres et formant l'entrée des bits de rang le plus élevé (MSB) des entrées d'adressage (A0 à A3) du module de mémoires mortes (6), tandis que les secondes entrées de chaque opérateur OU exclusif (21a, 21b, 21c) forment les autres entrées des bits des entrées d'adressage (A0 à A3) du module de mémoires mortes (6).

6. Montage selon l'une des revendications 1 à 5, caractérisé en ce que les deux signaux d'entrée (1, 2) sont dirigés par l'intermédiaire d'un opérateur OU (10c) sur une entrée d'attaque du second compteur d'impulsions (22) dont la sortie en parallèle est dirigée, par l'intermédiaire d'un moyen (10a) fonctionnant en décodeur et destiné à émettre un signal de restitution, sur la sortie de restitution (10A) du moyen (10) de restitution du compte, cette sortie étant connectée de son côté à une entrée de restitution ($\overline{CE}$) de la mémoire morte (6a) et en ce que la sortie en parallèle du premier compteur d'impulsions (4) est dirigée sur

37

les entrées d'adressage (A0 à A3 ou A0 à A2) de la mémoire morte (6a).

7. Montage selon l'une des revendications 1 à 5, caractérisé en ce que la sortie en parallèle du premier compteur d'impulsions (4) est connectée à une entrée en parallèle d'une décodeur (10g), en ce que l'un des deux signaux d'entrée (1, 2) est dirigé sur une entrée d'attaque du second compteur d'impulsions (22) dont la sortie en parallèle est connectée, par l'intermédiaire d'une moyen (10a) fonctionnant en décodeur et destiné à émettre un signal de restitution, à une première entrée d'un opérateur ET (10h) dont la seconde entrée communique avec une sortie du décodeur (10g) et dont la sortie est dirigée sur la sortie de restitution (10A) du moyen (10) de restitution du compte qui, de son côté, est connectée à une entrée de restitution ($\overline{CE}$) de la mémoire morte (6a) et en ce que la sortie en parallèle du premier compteur d'impulsions (4) est dirigée sur les entrées d'adressage (A0 à A3 ou A0 à A2) de la mémoire morte (6a).

8. Montage selon l'une des revendications 1 à 5, caractérisé en ce que la sortie en parallèle du premier compteur d'impulsions (4) est connectée à une entrée des données d'un registre intermédiaire (13) dont la sortie des données est dirigée de son côté sur les entrées d'adressage (A0 à A3 ou A0 à A2) de la mémoire morte (6a), en ce que les deux signaux d'entrée (1, 2) sont envoyés par un opérateur OU (10c) à une entrée d'attaque du second compteur d'impulsions (22) dont la sortie en parallèle est dirigée, par un moyen (10a) fonctionnant en décodeur et destiné à émettre un signal de restitution, sur une entrée de restitution ($\overline{CE}$) du registre intermédiaire (13) et en ce que l'entrée d'attaque du second compteur d'impulsions (22) est connectée par un inverseur (10d) à la sortie de restitution (10D) du moyen (10) de restitution du compte qui, de son côté, est dirigée sur une entrée de restitution ($\overline{CE}$) de la mémoire morte (6a).

9. Montage selon l'une des revendications 1 à 5, caractérisé en ce que la sortie en parallèle du premier compteur d'impulsions (4) est connectée à une entrée des données d'un registre intermédiaire (13) et à une entrée en parallèle d'un décodeur (10g), en ce que la sortie des données du registre intermédiaire (13) est dirigée de son côté sur les entrées d'adressage (A0 à A3 ou A0 à A2) de la mémoire morte (6a), en ce que l'un des deux signaux d'entrée (1, 2) est envoyé à une entrée d'attaque du second compteur d'impulsions (22) dont la sortie en parallèle est dirigée, par un moyen (10a) fonctionnant en décodeur et destiné à émettre un signal de restitution, sur une première entrée d'un opérateur ET (10h) dont la seconde entrée est connectée à une sortie du décodeur (10g) et dont la sortie est connectée à une entrée de restitution ($\overline{CE}$) du registre intermédiaire et en ce que l'entrée d'attaque du second compteur d'impulsions (22) est connectée par l'intermédiaire d'un inverseur (10d) à la sortie de restitution (10D) du moyen (10) de restitution du compte qui, de son côté, est connectée à une entrée de restitution ($\overline{CE}$) de la mémoire morte (6a).

10. Montage selon l'une des revendications 1 à 5 comprenant des adresses de la mémoire morte (6a) dont les bits de rang le plus bas consistent, dans la séquence indiquée, en valeurs successives de p et q, p étant une valeur correspondante comptée par le second compteur d'impulsions (22) et q étant une valeur correspondante comptée par le premier compteur d'impulsions (4), caractérisé en ce que la sortie en prallèles du premier compteur d'impulsions (4) est connectée à une entrée des données d'un registre intermédiaire (13) dont la sortie des données est dirigée de son côté sur les entrées d'adressage de rang le plus bas (A0 à A3 ou A0 à A2) de la mémoire morte (6a), en ce que le moyen (17;18) de restitution du compte comprend un dispositif de commutation (17) et une mémoire morte supplémentaire (18) fonctionnant en décodeur et dont au moins l'une (D11) des sorties de données (D11 à D0) est connectée à une entrée de commutation (17M) du dispositif de commutation (17), en ce que la sortie de restitution (17G) du moyen (17;18) de restitution du compte est dirigée sur une entrée de restitution ($\overline{CE}$) de la mémoire morte (6a), en ce que le moyen (17;18) de restitution du compte comprend encore une autre sortie de restitution (17F) qui est connectée à une entrée de restitution ($\overline{CE}$) du registre intermédiaire (13) et en ce que la mémoire morte supplémentaire (18) a les mêmes adresses que la mémoire morte (6a).

11. Montage selon l'une des revendications 1 à 5, comprenant des adresses de la mémoire morte (6a) dont les bits de rang le plus bas consistent dans la séquence indiquée en les valeurs successives de p et de q, p étant une valeur correspondante comptée par le second compteur d'impulsions (22) et q étant une valeur correspondante comptée par le premier compteur d'impulsions (4), caractérisé en ce que le moyen (17;18) de restitution du compte contient un dispositif de commutation (17) et une mémoire morte supplémentaire (18) fonctionnant en décodeur et dont au moins l'une (D11) des sorties de données (D11 à D0) est connectée à une entrée de commutation (17M) du dispositif de commutation (17), en ce que le moyen (17;18) de restitution du compte comprend encore une autre sortie de restitution (17F) qui est dirigée sur une entrée de restitution ($\overline{CE}$) de la mémoire morte (6a) et en ce que la mémoire morte supplémentaire (18) a les mêmes adresses que la mémoire morte (6a).

**12.** Montage selon l'une des revendications 8 à 10, caractérisé en ce que la sortie en parallèle du premier compteur d'impulsions (4) est connectée par un micro-ordinateur (12a) à l'entrée des données du registre intermédiaire (13), le micro-ordinateur (12a) étant destiné à déterminer pendant un temps prescrit déterminé une moyenne des valeurs présentes à la sortie en parallèle du premier compteur d'impulsions (4) et à diriger cette moyenne sur l'entrée des données du registre intermédiaire (13).

**13.** Montage selon la revendication 1 ou 2, caractérisé en ce que la valeur calculée de s se compose de grandeurs entières et de fractions binaires éventuellement arrondies, en ce que ces dernières sont multipliées par un facteur de telle manière qu'il en résultent des multiples entiers de $1/2^K$ dont chacun est enregistré dans la mémoire morte (6a) à des adresses qui sont tirées d'une valeur correspondante q comptée par le premier compteur d'impulsions (4), en ce qu'au moins le bit de rang le plus bas des grandeurs entières de s est enregistré dans une autre mémoire morte (14) à des adresses dont les bits de rang le plus bas consistent dans la séquence indiquée en valeurs successives de p+q et de q et en ce qu'au moins le bit de rang le plus bas de la sortie des données de l'autre mémoire morte (14) est aussi dirigé sur la sortie du montage, s = $\sqrt{\{q^2 + [R - q]^2\}}$, p+q étant une valeur correspondante comptée par le second compteur d'impulsions (22), K représentant le nombre des bits de sortie des données des mémoires mortes (6a, 14) et q ayant toutes les valeurs en nombres entiers allant de 0 à R.

**14.** Montage selon la revendication 1 ou 2, caractérisé en ce que des valeurs calculées de s réduites de $Y/2^K$ se composent de grandeurs entières et de fractions binaires éventuellement arrondies, en ce que ces dernières sont multipliées par un facteur tel qu'il en résultent des multiples entiers de $1/2^K$, en ce que les valeurs des multiples entiers ainsi calculés de $1/2^K$ des fractions binaires sont enregistrées dans la mémoire morte (6a) et plus précisémment chacune à des adresses qui sont tirées d'une valeur correspondante q comptée par le premier compteur d'impulsions (4), en ce qu'au moins le bit de rang le plus bas des grandeurs entières des valeurs calculées de s réduites de $Y/2^K$ est enregistré dans une autre mémoire morte (14) à des adresses dont les bits de rang le plus bas consistent dans la séquence indiquée en valeurs successives p+q et de q et en ce qu'au moins le bit de rang le plus bas de la sortie des données de l'autre mémoire morte (14) est aussi dirigé sur la sortie du montage, s = $\sqrt{\{q^2 + [R - q]^2\}}$, p+q étant une valeur correspondante comptée par le second compteur d'impulsions (22), K représentant le nombre des bits de sortie des données des mémoires mortes (6a, 14), q ayant toutes les valeurs en nombres entiers de 0 à R et Y étant un nombre entier.

**15.** Montage selon la revendication 13 ou 14, caractérisé en ce que les deux signaux d'entrée (1, 2) sont dirigés par un opérateur OU (10c) sur l'entrée d'attaque du second compteur d'impulsions (22) dont la sortie en parallèle est dirigée par un moyen (10a), fonctionnant en décodeur, de déclenchement d'un signal de restitution sur la sortie de restitution (10A) du moyen (10) de restitution du compte, cette sortie de restitution étant connectée de son côté à une entrée de restitution ($\overline{CE}$) de la mémoire morte (6a) et étant connectée après inversion à une entrée de restitution ($\overline{CE}$) de l'autre mémoire morte (14).

**16.** Montage selon la revendication 13 ou 14, caractérisé en ce que la sortie en parallèle du premier compteur d'impulsions (4) est connectée à une entrée en parallèle d'un décodeur (10g), en ce que l'un des deux signaux d'entrée (1, 2) est dirigé sur une entrée d'attaque du second compteur d'impulsions (22) dont la sortie en parallèle est connectée par un moyen (10a), fonctionnant en décodeur, de déclenchement d'un signal de restitution à une première entrée d'un opérateur ET (10h) dont la seconde entrée est reliée à une sortie du décodeur (10g) et dont la sortie est dirigée sur la sortie de restitution (10A) du moyen (10) de restitution du compte, cette sortie de restitution étant connectée de son côté à une entrée de restitution ($\overline{CE}$) de la mémoire morte (6a) et, après inversion, à une entrée de restitution ($\overline{CE}$) de l'autre mémoire morte (14).

**17.** Montage selon l'une des revendications 13 à 16, caractérisé en ce que des opérateurs OU exclusif (21a, 21b, 21c) sont montés dans le module à mémoires mortes (6) en amont des entrées d'adressage (A0 à A2) de la mémoire morte (6a), le nombre d'opérateurs OU exclusif étant inférieur de un au nombre de bits que comporte la sortie en parallèle du premier compteur d'impulsions (4), les premières entrées de tous les opérateurs OU exclusif (21a, 21b, 21c) étant connectées les unes aux autres et formant l'entrée du bit de rang le plus élevé (MSB) des entrées d'adressage (A0 à A3) du module à mémoires mortes (6), tandis que les secondes entrées de chacun des opérateurs OU exclusif (21a, 21b, 21c) forment les autres entrées des bits des entrées d'adressage (A0 à A3) du module à mémoires mortes (6).

18. Montage selon la revendication 1 ou 2, caractérisé en ce que les valeurs calculées de s se composent de grandeurs entières et de fractions binaires éventuellement arrondies, en ce que ces dernières sont multipliées par un facteur tel qu'il en résulte des multiples entiers de $1/2^K$ qui sont enregistrés dans la mémoire morte (6a), en ce qu'au moins le bit de rang le plus bas des valeurs entières de s est enregistré dans une autre mémoire morte (14) et en ce qu'au moins le bit de rang le plus bas de la sortie de données de l'autre mémoire morte (14) est aussi dirigé sur la sortie du montage, l'enregistrement dans les deux mémoires mortes (6a, 14) étant effectué dans chaque cas à des adresses dont les bits de rang le plus bas consistent dans la séquence indiquée en valeurs successives de p et de q, $s = \sqrt{\{q^2 + [R - q]^2\}}$, p étant une valeur correspondante comptée par le second compteur d'impulsions (22) et q étant une valeur correspondante comptée par le premier compteur d'impulsions (4), K représentant le nombre des bits de sortie des données des mémoires mortes (6a, 14) et q ayant toutes les valeurs en nombres entiers de 0 à R.

19. Montage selon la revendication 1 ou 2, caractérisé en ce que les valeurs calculées de s qui sont réduites de $Y/2^K$ se composent de grandeurs entières et de fractions binaires éventuellement arrondies, en ce que ces dernières sont multipliées par un facteur tel qu'il en résulte des multiples entiers de $1/2^K$, en ce que les valeurs des multiples entiers ainsi calculés de $1/2^K$ des fractions binaires sont enregistrées dans la mémoire morte (6a), en ce qu'au moins le bit de rang le plus bas des valeurs en nombres entiers des valeurs calculées de s réduites de $Y/2^K$ est mémorisé dans une autre mémoire morte (14) dans chaque cas à des adresses et en ce qu'au moins le bit de rang le plus bas de la sortie des données de l'autre mémoire morte (14) est aussi dirigée sur la sortie du montage, l'enregistrement dans les deux mémoires mortes (6a, 14) s'effectuant dans chaque cas à des adresses dont les bits de rang le plus bas consistent dans la séquence indiquée en valeurs successives de p et de q, $s = \sqrt{\{q^2 + [R - q]^2\}}$, p étant une valeur correspondante comptée par le second compteur d'impulsions (22) et q étant une valeur correspondante comptée par le premier compteur d'impulsions (4), K représentant le nombre des bits de sortie des données des mémoires mortes (6a, 14), q ayant toutes les valeurs en nombres entiers allant de 0 à R et Y étant un nombre entier.

20. Montage selon la revendication 18 ou 19, caractérisé en ce que le moyen (17;18) de restitution du compte comprend un dispositif de commutation (17) et une mémoire morte auxiliaire (18) fonctionnant en décodeur et dont au moins l'une (D7) des sorties de données (D7 à D0) est connectée à une entrée de commutation (17M) du dispositif de commutation (17), en ce que le moyen (17;18) de restitution du compte comprend encore une autre sortie de restitution (17F) qui est dirigée sur une entrée de restitution ($\overline{\mathrm{CE}}$) de la mémoire morte (6a) ainsi que, après inversion, sur une entrée de restitution ($\overline{\mathrm{CE}}$) de l'autre mémoire morte (14) et en ce que la mémoire morte auxiliaire (18) a les mêmes adresses que les deux autres mémoires mortes (6a, 14).

21. Montage selon la revendication 1 ou 2, caractérisé en ce qu'il comprend une autre mémoire morte (14) et en ce que des valeurs calculées de A.cosγ et de A.sinφ arrondies à des multiples de $1/2^K$ sont chacune enregistrées dans l'une des deux mémoires mortes (6a ainsi que 14) à des adresses dont chacune est tirée d'une valeur correspondante q qui est comptée par le premier compteur d'impulsions (4), $\cos\phi = [R - q]/\sqrt{\{q^2 + [R - q]^2\}}$, $\sin\phi = q/\sqrt{\{q^2 + [R - q]^2\}}$, K représentant le nombre des bits de sortie des données des deux mémoires mortes (6a, 14), A désignant un nombre qui est supérieur ou égal à un dixième et q ayant toutes les valeurs en nombres entiers allant de 0 à R.

22. Montage selon la revendication 21, caractérisé en ce que :
- la sortie en parallèle du premier compteur d'impulsions (4) est connectée à une entrée des données d'un registre intermédiaire (13) dont la sortie des données est dirigée de son côté sur les entrées d'adressage (A0 à A3) des deux mémoires mortes (6a, 14),
- les sorties des données (D0 à D11) des deux mémoires mortes (6a, 14) sont montées en parallèle et
- chacun des deux signaux d'entrée (1, 2) parvient à une entrée de restitution ($\overline{\mathrm{CE}}$) de l'une des deux mémoires mortes (6a ainsi que 14).

**23.** Montage selon la revendication 22, caractérisé en ce que
- des grandeurs arrondies de même valeur de A.cos$\phi$ et de A.sin$\phi$ sont enregistrées dans les deux mémoires mortes (6a, 14) à des mêmes adresses et
- chacune des entrées d'adressage (A0 à A3 ou A0 à A7) de la mémoire morte (6a) est dirigée, par l'entremise d'un inverseur (15) pour chaque bit, sur les entrées d'adressage (A0 à A3 ou A0 à A7) de l'autre mémoire morte (14).

**24.** Montage selon la revendication 22 ou 23, caractérisé en ce que les deux signaux d'entrée (1, 2) sont dirigés par un opérateur OU (10c) sur une entrée d'attaque du second compteur d'impulsions (22) dont la sortie en parallèle est connectée par un moyen (10a), fonctionnant en décodeur, de déclenchement d'un signal de restitution à une autre sortie de restitution (10A) du moyen (10) de restitution du compte, cette autre sortie de restitution étant dirigée de son côté sur une entrée de restitution ($\overline{CE}$) du registre intermédiaire (13) et en ce que l'entrée d'attaque du second compteur d'impulsions (22) forme par l'entremise d'un inverseur (10d) la sortie de restitution (10D) du moyen (10) de restitution du compte.

**25.** Montage selon la revendication 22 ou 23, caractérisé en ce que la sortie en parallèle du premier compteur d'impulsions (4) est connectée à une entrée en parallèle d'un décodeur (10g), en ce que l'un des deux signaux d'entrée (1, 2) est dirigé sur une entrée d'attaque du second compteur d'impulsions (22) dont la sortie en parallèle est connectée par un moyen (10a), fonctionnant en décodeur, de déclenchement d'un signal de restitution à une première entrée d'un opérateur ET (10h) dont la seconde entrée est reliée à une sortie du décodeur (10g) et dont la sortie est dirigée sur une autre sortie de restitution (10A) du moyen (10) de restitution du compte, cette autre sortie de restitution étant connectée de son côté à une entrée de restitution ($\overline{CE}$) du registre intermédiaire (13) et en ce que l'entrée d'attaque du second compteur d'impulsions (22) forme par l'entremise d'un inverseur (10d) la sortie de restitution (10D) du moyen (10) de restitution du compte.

**26.** Montage selon la revendication 22 ou 23, caractérisé en ce que le moyen (17;18) de restitution du compte comprend un dispositif de commutation (17) et une mémoire morte auxiliaire (18) fonctionnant en décodeur et dont au moins l'une (D11) des sorties de données (D11 à D0) est connectée à une entrée de commutation (17M) du dispositif de commutation (17), en ce que le moyen (17;18) de restitution du compte comprend encore une autre sortie de restitution (17F) qui est dirigée sur une entrée de restitution ($\overline{CE}$) du registre intermédiaire (13) et en ce que la mémoire morte auxiliaire (18) a les mêmes adresses que la mémoire morte (6a).

**27.** Montage selon l'une des revendications 22 à 26, caractérisé en ce que la sortie en parallèle du premier compteur d'impulsions (4) communique par l'entremise d'un micro-ordinateur (12a) avec l'entrée des données du registre intermédiaire (13), le micro-ordinateur (12a) étant destiné à déterminer pendant un temps déterminé prescrit la moyenne des valeurs présentes à la sortie en parallèle du premier compteur d'impulsions (4) et à diriger cette moyenne sur l'entrée des données du registre intermédiaire (13).

**28.** Montage selon l'une des revendications 10 à 27, caractérisé en ce que les mémoires mortes présentes (6a, 14 ou 6a, 18 ou 6a, 14, 18) forment toutes ou partiellement ensemble une unique mémoire morte (6a;14, ou 6a;18 ou 6a;14;18) qui comprend au moins un bit d'adressage de plus que les mémoires mortes individuelles (6a, 14, 18) qui la forment.

EP 0 382 890 B1

# Fig. 1

# Fig. 2

# Fig. 3

EP 0 382 890 B1

# Fig. 4

# Fig. 5

# Fig. 6

# Fig. 7

EP 0 382 890 B1

Fig. 8

48

# Fig. 9

# Fig. 10

# Fig. 11

Fig. 12

Fig. 13

Fig. 14

EP 0 382 890 B1

Fig. 15

Fig. 16

Fig. 17

52

# Fig. 18